# EUROPEAN PATENT APPLICATION

(11) **EP 4 583 675 A1**
(43) Date of publication of application: **09.07.2025**
(21) Application number: 23934399.9
(22) Date of filing: 24.04.2023
(51) Int. Cl.: H10K 59/12

(54) **DISPLAY SUBSTRATE AND MANUFACTURING METHOD THEREFOR, AND DISPLAY DEVICE**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: LIU, Lang, Beijing 100176 (CN); ZHANG, Tiaomei, Beijing 100176 (CN)
(74) Representative: Durán-Corretjer, S.L.P.
(86) International application number: PCT/CN2023/090410
(87) International publication number: WO 2024/221194

(57) **Abstract**

A display substrate and a manufacturing method therefor, and a display device. The display substrate comprises a plurality of circuit units. Each circuit unit comprises a pixel driving circuit; the pixel driving circuit comprises a first storage capacitor and a second storage capacitor; a second end of the first storage capacitor is connected to a second end of the second storage capacitor; the first storage capacitor comprises at least two first capacitor plates, and the orthographic projections of the two first capacitor plates on the plane of the display substrate at least partially overlap; the second storage capacitor comprises at least two second capacitor plates, and the orthographic projections of the two second capacitor plates on the plane of the display substrate at least partially overlap; in a direction perpendicular to the display substrate, the display substrate comprises a first conductive layer, a second conductive layer, and a third conductive layer which are arranged on a base; the at least two first capacitor plates of the first storage capacitor are respectively arranged in the first conductive layer and the second conductive layer; and the at least two second capacitor plates of the second storage capacitor are respectively arranged in the second conductive layer and the third conductive layer.

## Description

### Technical Field

The present disclosure relates to, but is not limited to, the field of display technologies, and particularly to a display substrate and a preparation method therefor, and a display apparatus.

### Background

An Organic Light Emitting Diode (OLED for short) and a Quantum dot Light Emitting Diode (QLED for short) are active light emitting display devices and have advantages such as self-luminescence, a wide viewing angle, a high contrast ratio, low power consumption, an extremely high response speed, lightness and thinness, flexibility, and a low cost. With constant development of display technologies, a flexible display apparatus (Flexible Display) in which an OLED or a QLED is used as a light emitting device and signal control is performed through a Thin Film Transistor (TFT for short) has become a mainstream product in the field of display at present.

### Summary

The following is a summary of subject matters described herein in detail. The summary is not intended to limit the protection scope of claims.

In one aspect, the present disclosure provides a display substrate including a plurality of circuit units, wherein at least one circuit unit includes a pixel drive circuit, the pixel drive circuit includes at least a first storage capacitor and a second storage capacitor, a second end of the first storage capacitor is connected with a second end of the second storage capacitor; the first storage capacitor includes at least two first capacitor electrode plates, orthographic projections of the two first capacitor electrode plates on a base substrate are at least partially overlapped, and the second storage capacitor includes at least two second capacitor electrode plates, orthographic projections of the two second capacitor electrode plates on the base substrate are at least partially overlapped; on a plane perpendicular to the display substrate, the display substrate includes a semiconductor layer disposed on the base substrate, and a first conductive layer, a second conductive layer, and a third conductive layer sequentially disposed along a direction away from the base substrate, the at least two first capacitor electrode plates in the first storage capacitor are respectively disposed in the first conductive layer and the second conductive layer, and the at least two second capacitor electrode plates in the second storage capacitor are respectively disposed in the second conductive layer and the third conductive layer.

In an exemplary implementation mode, the at least two first capacitor electrode plates include a first electrode plate, a third electrode plate, and a fifth electrode plate, wherein the first electrode plate is disposed in the first conductive layer, the third electrode plate is disposed in the second conductive layer, and the fifth electrode plate is disposed in the third conductive layer; an orthographic projection of the first electrode plate on the base substrate is at least partially overlapped with an orthographic projection of the third electrode plate on the base substrate, and the orthographic projection of the third electrode plate on the base substrate is at least partially overlapped with an orthographic projection of the fifth electrode plate on the base substrate; the first storage capacitor includes a first sub-capacitor and a second sub-capacitor, the first sub-capacitor includes the first electrode plate and the third electrode plate, and the second sub-capacitor includes the third electrode plate and the fifth electrode plate.

In an exemplary implementation mode, the at least two second capacitor electrode plates include a second electrode plate, a fourth electrode plate, and a sixth electrode plate, wherein the second electrode plate is disposed in the first conductive layer, the fourth electrode plate is disposed in the second conductive layer, and the sixth electrode plate is disposed in the third conductive layer; an orthographic projection of the second electrode plate on the base substrate is at least partially overlapped with an orthographic projection of the fourth electrode plate on the base substrate, and the orthographic projection of the fourth electrode plate on the base substrate is at least partially overlapped with an orthographic projection of the sixth electrode plate on the base substrate; the second storage capacitor includes a third sub-capacitor and a fourth sub-capacitor, the third sub-capacitor includes the second electrode plate and the fourth electrode plate, the fourth sub-capacitor includes the fourth electrode plate and the sixth electrode plate.

In an exemplary implementation mode, the at least two first capacitor electrode plates include a first electrode plate, a third electrode plate, and a fifth electrode plate, the at least two second capacitor electrode plates include a second electrode plate, a fourth electrode plate, and a sixth electrode plate, the first electrode plate and the second electrode plate are disposed in the first conductive layer, the third electrode plate and the fourth electrode plate are disposed in the second conductive layer, and the fifth electrode plate and the sixth electrode plate are disposed in the third conductive layer; the fifth electrode plate is connected with the first electrode plate, and the sixth electrode plate is connected with the second electrode plate and the third electrode plate, respectively.

In an exemplary implementation mode, the at least two first capacitor electrode plates include a first electrode plate disposed in the first conductive layer and a third electrode plate disposed in the second conductive layer, an orthographic projection of the first electrode plate on the base substrate is at least partially overlapped with an orthographic projection of the third electrode plate on the base substrate, and the first storage capacitor includes the first electrode plate and the second electrode plate.

In an exemplary implementation mode, the at least two second capacitor electrode plates include a second electrode plate disposed in the second conductive layer and a fourth electrode plate disposed in the third conductive layer, an orthographic projection of the second electrode plate on the base substrate is at least partially overlapped with an orthographic projection of the fourth electrode plate on the base substrate, and the second storage capacitor includes the second electrode plate and the fourth electrode plate.

In an exemplary implementation mode, the third electrode plate of the first storage capacitor and the second electrode plate of the second storage capacitor are of an interconnected integral structure.

In an exemplary implementation mode, the display substrate further includes at least one first power supply connection line extending along a first direction, at least one second power supply connection line extending along the first direction, at least one reference signal connection line extending along the first direction, at least one first power supply line extending along a second direction, at least one second power supply line extending along the second direction, and at least one reference signal line extending along the second direction, the first direction intersecting with the second direction; the first power supply line and the first power supply connection line are disposed in different conductive layers, and the first power supply line and the first power supply connection line are connected through a via to form a mesh structure for transmitting a first power supply signal; the second power supply line and the second power supply connection line are disposed in different conductive layers, and the second power supply line and the second power supply connection line are connected through a via to form a mesh structure for transmitting a second power supply signal; the reference signal line and the reference signal connection line are disposed in different conductive layers, and the reference signal connection line and the reference signal line are connected through a via to form a mesh structure for transmitting a reference signal; potentials of the first power supply line and the second power supply line are different.

In an exemplary implementation mode, the pixel drive circuit includes a first initialization transistor, a compensation transistor, a data writing transistor, a first reference transistor, a first node, and a fifth node, wherein the first node is respectively connected with a second electrode of the first initialization transistor, a first electrode of the compensation transistor, and a first end of the first storage capacitor, and the fifth node is respectively connected with a second electrode of the data writing transistor, a second electrode of the first reference transistor, a second end of the first storage capacitor, and a second end of the second storage capacitor; an orthographic projection of the second power supply connection line on the base substrate is at least partially overlapped with an orthographic projection of the fifth node on the base substrate.

In an exemplary implementation mode, the display substrate further includes at least one data signal line extending along the second direction; a reference signal connection line in one circuit unit is adjacent to a data signal line in another circuit unit adjacent in the first direction; in at least one circuit unit, an orthographic projection of the reference signal connection line on the base substrate is not overlapped with an orthographic projection of the fifth node on the base substrate.

In an exemplary implementation mode, the reference signal line is connected with one first capacitor electrode plate in the first storage capacitor, or the reference signal line is connected with one second capacitor electrode plate in the second storage capacitor.

In an exemplary implementation mode, the display substrate further includes at least one initial signal line extending along a first direction and at least one initial connection line extending along a second direction, the first direction intersecting with the second direction; the initial signal line and the initial connection line are disposed in different conductive layers, and the initial connection line and the initial signal line are connected through a via to form a mesh structure for transmitting an initial signal.

In an exemplary implementation mode, the pixel drive circuit further includes a first initialization transistor, a compensation transistor, a data writing transistor, and a first reference transistor; a first electrode of the first initialization transistor is connected with a first initial signal line, a second electrode of the first initialization transistor is connected with a first electrode of the compensation transistor and a first end of the first storage capacitor respectively, a first electrode of the data writing transistor is connected with a data signal line, a second electrode of the data writing transistor is connected with a second electrode of the first reference transistor, a second end of the first storage capacitor, and a second end of the second storage capacitor respectively, a first electrode of the first reference transistor is connected with a first reference signal line, and a first end of the second storage capacitor is connected with a first power supply line.

In an exemplary implementation mode, the at least one circuit unit further includes a first shielding electrode, an orthographic projection of the first shielding electrode on the base substrate is at least partially overlapped with an orthographic projection of a semiconductor layer between two gate electrodes of the first initialization transistor on the base substrate, and the orthographic projection of the first shielding electrode on the base substrate is at least partially overlapped with an orthographic projection of a semiconductor layer between two gate electrodes of the compensation transistor on the base substrate.

In an exemplary implementation mode, the at least one circuit unit further includes a second shielding electrode disposed between the first electrode of the data writing transistor and the second electrode of the data writing transistor.

In an exemplary implementation mode, the at least one circuit unit further includes a third shielding electrode and a fourth shielding electrode, wherein an orthographic projection of the third shielding electrode on the base substrate is at least partially overlapped with an orthographic projection of a semiconductor layer between two gate electrodes of the data writing transistor on the base substrate, and an orthographic projection of the fourth shielding electrode on the base substrate is at least partially overlapped with an orthographic projection of a semiconductor layer between two gate electrodes of the first reference transistor on the base substrate.

In an exemplary implementation mode, the at least one circuit unit further includes a fifth shielding electrode and a sixth shielding electrode, wherein an orthographic projection of the fifth shielding electrode on the base substrate is at least partially overlapped with an orthographic projection of a semiconductor layer between two gate electrodes of the first initialization transistor on the base substrate, and an orthographic projection of the sixth shielding electrode on the base substrate is at least partially overlapped with an orthographic projection of a semiconductor layer between two gate electrodes of the compensation transistor on the base substrate.

In an exemplary implementation mode, the fifth shielding electrode and the sixth shielding electrode are connected with a first power supply line, or the fifth shielding electrode and the sixth shielding electrode are connected with a second power supply line.

In an exemplary implementation mode, the at least one circuit unit further includes a first connection electrode and a power supply shielding block, wherein the first connection electrode is connected with the second electrode of the first initialization transistor, a second electrode of the compensation transistor, and the first end of the first storage capacitor, respectively, the power supply shielding block is connected with the first power supply line, and an orthographic projection of the power supply shielding block on the base substrate is at least partially overlapped with an orthographic projection of the first connection electrode on the base substrate.

In an exemplary implementation mode, the at least one circuit unit further includes a second connection electrode connected with the second electrode of the data writing transistor, the second electrode of the first reference transistor, the second end of the first storage capacitor, and the second end of the second storage capacitor, respectively, wherein an orthographic projection of the first power supply line on the base substrate is at least partially overlapped with an orthographic projection of the second connection electrode on the base substrate.

In another aspect, the present disclosure also provides a display apparatus, including the display substrate described above.

In yet another aspect, the present disclosure also provides a preparation method of a display substrate, wherein the display substrate includes a plurality of circuit units, at least one circuit unit includes a pixel drive circuit, the pixel drive circuit includes at least a first storage capacitor and a second storage capacitor, a second end of the first storage capacitor is connected with a second end of the second storage capacitor; the first storage capacitor includes at least two first capacitor electrode plates, orthographic projections of the two first capacitor electrode plates on a base substrate are at least partially overlapped, and the second storage capacitor includes at least two second capacitor electrode plates, orthographic projections of the two second capacitor electrode plates on the base substrate are at least partially overlapped; the preparation method includes: forming a first conductive layer, a second conductive layer, and a third conductive layer sequentially on the base substrate, wherein at least one first capacitor electrode plate in the first storage capacitor is disposed in the first conductive layer, at least one first capacitor electrode plate of the first storage capacitor is disposed in the second conductive layer, at least one second capacitor electrode plate in the second storage capacitor is disposed in the second conductive layer, and at least one second capacitor electrode plate in the second storage capacitor is disposed in the third conductive layer.

Other aspects may be comprehended after drawings and detailed description are read and understood.

### Brief Description of Drawings

Accompany drawings are used for providing further understanding of technical solutions of the present disclosure, and constitute a part of the specification. The accompany drawings and embodiments of the present disclosure are adopted to explain the technical solutions of the present disclosure, and do not constitute limitations on the technical solutions of the present disclosure.
FIG. 1 is a schematic diagram of a structure of a display apparatus.
FIG. 2 is a schematic diagram of a planar structure of a display substrate.
FIG. 3 is a schematic diagram of a sectional structure of a display substrate.
FIG. 4 is an equivalent circuit diagram of a pixel drive circuit according to an exemplary embodiment of the present disclosure.
FIG. 5 is a schematic diagram of a planar structure of a display substrate according to an exemplary embodiment of the present disclosure.
FIG. 6 is a schematic diagram of a structure of a first storage capacitor and a second storage capacitor in FIG. 5.
FIG. 7A is a sectional view taken along an A-A direction in FIG. 6.
FIG. 7B is a sectional view taken along a B-B direction in FIG. 6.
FIG. 8 is a schematic diagram of a display substrate after a pattern of a semiconductor layer is formed according to the present disclosure.
FIG. 9A and FIG. 9B are schematic diagrams of a display substrate after a pattern of a first conductive layer is formed according to the present disclosure.
FIG. 10A and FIG. 10B are schematic diagrams of a display substrate after a pattern of a second conductive layer is formed according to the present disclosure.
FIG. 11 is a schematic diagram of a display substrate after a pattern of a fourth insulation layer is formed according to the present disclosure.
FIG. 12A and FIG. 12B are schematic diagrams of a display substrate after a pattern of a third conductive layer is formed according to the present disclosure.
FIG. 13 is a schematic diagram of a display substrate after a pattern of a fifth insulation layer is formed according to the present disclosure.
FIG. 14A and FIG. 14B are schematic diagrams of a display substrate after a pattern of a fourth conductive layer is formed according to the present disclosure.
FIG. 14C and FIG. 14D are schematic diagrams of a display substrate after a pattern of another fourth conductive layer is formed according to the present disclosure.
FIG. 15 is a schematic diagram of a planar structure of another display substrate according to an exemplary embodiment of the present disclosure.
FIG. 16 is a schematic diagram of a structure of a first storage capacitor and a second storage capacitor in FIG. 15.
FIG. 17 is a sectional view taken along a C-C direction in FIG. 16.
FIG. 18 is a schematic diagram of another display substrate after a pattern of a semiconductor layer is formed according to the present disclosure.
FIG. 19A and FIG. 19B are schematic diagrams of another display substrate after a pattern of a first conductive layer is formed according to the present disclosure.
FIG. 20A and FIG. 20B are schematic diagrams of another display substrate after a pattern of a second conductive layer is formed according to the present disclosure.
FIG. 21 is a schematic diagram of another display substrate after a pattern of a fourth insulation layer is formed according to the present disclosure.
FIG. 22A and FIG. 22B are schematic diagrams of another display substrate after a pattern of a third conductive layer is formed according to the present disclosure.
FIG. 23 is a schematic diagram of another display substrate after a pattern of a fifth insulation layer is formed according to the present disclosure.
FIG. 24A and FIG. 24B are schematic diagrams of another display substrate after a pattern of a fifth conductive layer is formed according to the present disclosure.
FIG. 25 is a schematic diagram of a planar structure of yet another display substrate according to an exemplary embodiment of the present disclosure.
FIG. 26 is a schematic diagram of a structure of a first storage capacitor and a second storage capacitor in FIG. 25.
FIG. 27 is a sectional view taken along a D-D direction in FIG. 26.
FIG. 28A and FIG. 28B are schematic diagrams of yet another display substrate after a pattern of a third conductive layer is formed according to the present disclosure.
FIG. 29A and FIG. 29B are schematic diagrams of yet another display substrate after a pattern of a fourth conductive layer is formed according to the present disclosure.
FIG. 30 is a schematic diagram of a planar structure of yet another display substrate according to an exemplary embodiment of the present disclosure.
FIG. 31 is a schematic diagram of a planar structure of yet another display substrate according to an exemplary embodiment of the present disclosure.
FIG. 32 is a schematic diagram of a planar structure of yet another display substrate according to an exemplary embodiment of the present disclosure.
FIG. 33 is a schematic diagram of a planar structure of yet another display substrate according to an exemplary embodiment of the present disclosure.
FIG. 34 is a schematic diagram of a planar structure of yet another display substrate according to an exemplary embodiment of the present disclosure.
FIG. 35 is a schematic diagram of a planar structure of yet another display substrate according to an exemplary embodiment of the present disclosure.
FIGs. 36 and 37 are schematic diagrams of a planar structure of yet another display substrate according to an exemplary embodiment of the present disclosure.
FIGs. 38 and 39 are schematic diagrams of a planar structure of yet another display substrate according to an exemplary embodiment of the present disclosure.
FIG. 40 is a schematic diagram of a connection structure according to an exemplary embodiment of the present disclosure.
FIG. 41 is a schematic diagram of another connection structure according to an exemplary embodiment of the present disclosure.

Reference signs are described as follows.

| | | | | | |
|---|---|---|---|---|---|
| 10 | -first active connection line; | 11 | -first active layer; | 12 | -second active layer; |
| 13 | -third active layer; | 14 | -fourth active layer; | 15 | -fifth active layer; |
| 16 | -sixth active layer; | 17 | -seventh active layer; | 18 | -eighth active layer; |
| 19 | -ninth active layer; | 20 | -second active connection line; | 21 | -first gate electrode; |
| 22 | -second gate electrode; | 24 | -fourth gate electrode; | 25 | -fifth gate electrode; |
| 26 | -sixth gate electrode; | 29 | -ninth gate electrode; | 31 | -first light emitting signal line; |
| 32 | -second light emitting signal line; | 33 | -repair line; | 34 | -first shielding electrode; |
| 35 | -second shielding electrode; | 36 | -third shielding electrode; | 37 | -fourth shielding electrode; |
| 38 | -fifth shielding electrode; | 39 | -sixth shielding electrode; | 40A | -first node electrode; |
| 40B | -second node electrode; | 41 | -first connection electrode; | 42 | -second connection electrode; |
| 43 | -third connection electrode; | 44 | -fourth connection electrode; | 45 | -fifth connection electrode; |
| 46 | -sixth connection electrode; | 47 | -seventh connection electrode; | 48 | -eighth connection electrode; |
| 49 | -ninth connection electrode; | 50 | -tenth connection electrode; | 51 | -first power supply line; |
| 52 | -second power supply line; | 53 | -data signal line; | 54 | -reference signal connection line; |
| 55 | -anode connection electrode; | 56 | -initial connection line; | 61 | -first scan signal line; |
| 62 | -second scan signal line; | 63 | -third scan signal line; | 64 | -fourth scan signal line; |
| 65 | -fifth scan signal line; | 68 | -first power supply connection line; | 69 | -second power supply connection line; |
| 71 | -first electrode plate; | 72 | -second electrode plate; | 73 | -third electrode plate; |
| 74 | -fourth electrode plate; | 75 | -fifth electrode plate; | 76 | -sixth electrode plate; |
| 77 | -first opening; | 78 | -second opening; | 79 | -third opening; |
| 81 | -first initial signal line; | 82 | -second initial signal line; | 91 | -first reference signal line; |
| 92 | -second reference signal line; | 101 | -base substrate; | 102 | -drive circuit layer; |
| 103 | -light emitting structure layer; | 104 | -encapsulation structure layer; | 110 | -first shield electrode; |
| 120 | -second shield electrode. | | | | |

### Detailed Description

To make objectives, the technical solutions, and advantages of the present disclosure clearer, the embodiments of the present disclosure will be described in detail below in combination with the accompany drawings. It is to be noted that implementation modes may be implemented in multiple different forms. Those of ordinary skills in the art may easily understand such a fact that modes and contents may be transformed into various forms without departing from the purpose and scope of the present disclosure. Therefore, the present disclosure should not be explained as being limited to contents recorded in following implementation modes only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one mode of the present disclosure is not limited to shapes, numerical values, or the like shown in the drawings.

Ordinal numerals "first", "second", "third", etc., in the specification are set not to form limits in numbers but only to avoid confusion between constituent elements.

In the specification, for convenience, expressions "central", "above", "below", "front", "back", "vertical", "horizontal", "top", "bottom", "inside", "outside", etc., indicating directional or positional relationships are used to illustrate positional relationships between the constituent elements, not to indicate or imply that a referred apparatus or element must have a specific orientation and be structured and operated with the specific orientation but only to easily and simply describe the present specification, and thus should not be understood as limitations on the present disclosure. The positional relationships between the constituent elements may be changed as appropriate according to a direction according to which each constituent element is described. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be a fixed connection, or a detachable connection, or an integral connection; it may be a mechanical connection or an electrical connection; it may be a direct connection, or an indirect connection through middleware, or internal communication inside two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as a "source terminal" and a "drain terminal", are interchangeable in the specification.

In the specification, an "electrical connection" includes a case that constituent elements are connected together through an element with a certain electrical action. An "element with a certain electrical action" is not particularly limited as long as electrical signals between the connected constituent elements may be sent and received. Examples of the "element with the certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive film" sometimes. Similarly, an "insulation film" may be replaced with an "insulation layer" sometimes.

A triangle, rectangle, trapezoid, pentagon, or hexagon, etc. in the specification is not strictly defined, and it may be an approximate triangle, rectangle, trapezoid, pentagon, or hexagon, etc. There may be some small deformations caused by tolerance, and there may be a chamfer, an arc edge, deformation, etc.

In the present disclosure, "about" refers to that a boundary is not defined so strictly and numerical values within a range of process and measurement errors are allowed.

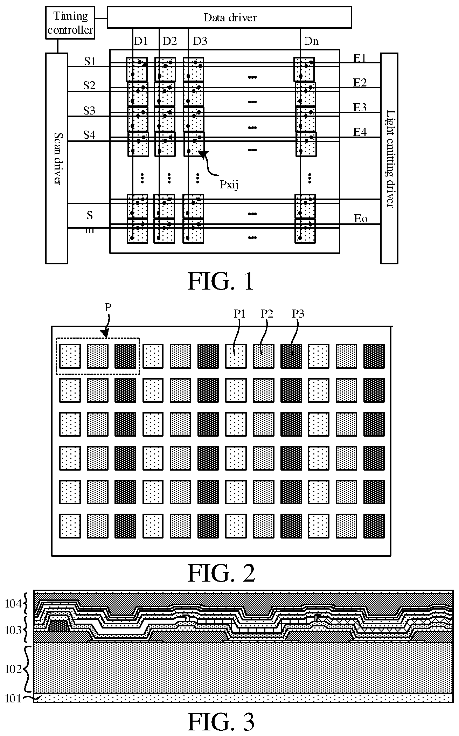

FIG. 1 is a schematic diagram of a structure of a display apparatus. As shown in FIG. 1, the display apparatus may include a timing controller, a data driver, a scan driver, a light emitting driver, and a pixel array. The timing controller is connected with the data driver, the scan driver, and the light emitting driver, respectively, the data driver is connected with a plurality of data signal lines (D1 to Dn) respectively, the scan driver is connected with a plurality of scan signal lines (S1 to Sm) respectively, and the light emitting driver is connected with a plurality of light emitting signal lines (E1 to Eo) respectively. The pixel array may include a plurality of sub-pixels Pxij, i and j may be natural numbers, at least one sub-pixel Pxij may include a circuit unit and a light emitting unit, the circuit unit may include at least a pixel drive circuit connected with a scan signal line, a light emitting signal line, and a data signal line, respectively, and the light emitting unit may include a light emitting device connected with the pixel drive circuit of the circuit unit. In an exemplary implementation mode, the timing controller may provide a grayscale value and a control signal which are suitable for a specification of the data driver to the data driver, provide a clock signal and a scan start signal and the like which are suitable for a specification of the scan driver to the scan driver, and provide a clock signal and an emission stop signal and the like which are suitable for a specification of the light emitting driver to the light emitting driver. The data driver may generate a data voltage to be provided to the data signal lines D1, D2, D3, ..., and Dn using the grayscale value and the control signal that are received from the timing controller. For example, the data driver may sample the grayscale value using the clock signal and apply a data voltage corresponding to the grayscale value to the data signal lines D1 to Dn by taking a pixel row as a unit, wherein n may be a natural number. The scan driver may generate a scan signal to be provided to the scan signal lines S1, S2, S3, ..., and Sm by receiving the clock signal and the scan start signal from the timing controller. For example, the scan driver may sequentially provide a scan signal with an on-level pulse to the scan signal lines S1 to Sm. For example, the scan driver may be constructed in a form of a shift register and may generate a scan signal in a manner in which a scan start signal provided in a form of an on-level pulse is transmitted to a next-stage circuit sequentially under control of the clock signal, wherein m may be a natural number. The light emitting driver may receive a clock signal, an emission stop signal, etc., from the timing controller to generate an emission signal to be provided to the light emitting signal lines E1, E2, E3, ..., and Eo. For example, the light emitting driver may sequentially provide an emission signal with an off-level pulse to the light emitting signal lines E1 to Eo. For example, the light emitting driver may be constructed in a form of a shift register and generate an emission signal in a manner of sequentially transmitting an emission stop signal provided in a form of an off-level pulse to a next-stage circuit under control of the clock signal, wherein o may be a natural number. In an exemplary implementation mode, the pixel array may be disposed on the display substrate.

FIG. 2 is a schematic diagram of a planar structure of a display substrate. In an exemplary embodiment, the display substrate may include a display region and a bezel region located on a periphery of the display region. As shown in FIG. 2, the display region of the display substrate may include a plurality of pixel units P arranged in a matrix. At least one pixel unit P may include a first sub-pixel P1 emitting light of a first color, a second sub-pixel P2 emitting light of a second color, and a third sub-pixel P3 emitting light of a third color. Each sub-pixel may include a circuit unit and a light emitting unit. The circuit unit may at least include a pixel drive circuit, the pixel drive circuit is connected with a scan signal line, a data signal line, and a light emitting signal line respectively, and is configured to receive a data voltage transmitted by the data signal line and output a corresponding current to the light emitting device under control of the scan signal line and the light emitting signal line. The light emitting unit may at least include a light emitting device, the light emitting device is connected with a pixel drive circuit of a sub-pixel where the light emitting device is located respectively, and the light emitting device is configured to emit light with corresponding brightness in response to a current output by the pixel drive circuit of the sub-pixel where the light emitting device is located.

In an exemplary implementation mode, the first sub-pixel P1 may be a red (R) sub-pixel emitting red light, the second sub-pixel P2 may be a blue (B) sub-pixel emitting blue light, and the third sub-pixel P3 may be a green (G) sub-pixel emitting green light. In an exemplary implementation mode, a sub-pixel may be in a shape of a rectangle, a rhombus, a pentagon, or a hexagon. Three sub-pixels may be arranged in a manner to stand side by side horizontally, in a manner to stand side by side vertically, or in a manner like a Chinese character " 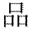 ", etc., which is not limited here in the present disclosure.

In an exemplary implementation mode, a pixel unit may include four sub-pixels, and the four sub-pixels may be arranged in a manner to stand side by side horizontally, in a manner to stand side by side vertically, or in a manner to form a square, which is not limited here in the present disclosure.

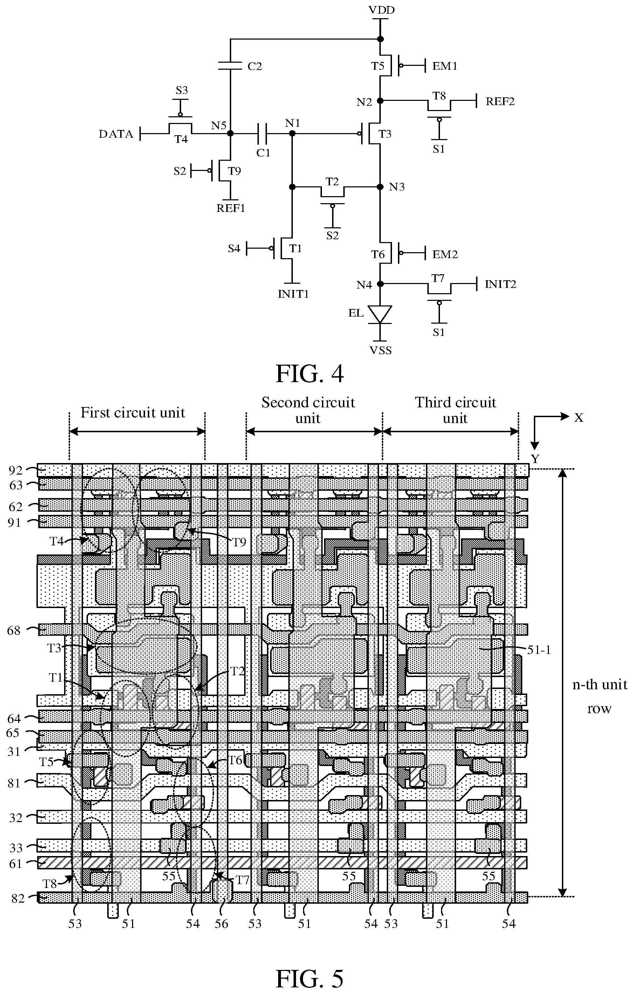

FIG. 3 is a schematic diagram of a sectional structure of a display substrate, and illustrates a structure of three sub-pixels in the display substrate. As shown in FIG. 4, on a plane perpendicular to the display substrate, the display region of the display substrate may include a drive circuit layer 102 disposed on a base substrate 101, a light emitting structure layer 103 disposed at a side of the drive circuit layer 102 away from the base substrate 101, and an encapsulation structure layer 104 disposed at a side of the light emitting structure layer 103 away from the base substrate 101. In some possible implementation modes, the display substrate may include another film layer, such as a touch structure layer, which is not limited here in the present disclosure.

In an exemplary implementation mode, the base substrate 101 may be a flexible base substrate, or may be a rigid base substrate. The drive circuit layer 102 may include multiple circuit units, a circuit unit may at least include a pixel drive circuit, and the pixel drive circuit may include multiple transistors and a storage capacitor. The light emitting structure layer 103 may include multiple light emitting units, a light emitting unit may at least include a light emitting device, and the light emitting device may include an anode, an organic emitting layer, and a cathode. The anode is connected with a pixel drive circuit. The organic emitting layer is connected with the anode. The cathode is connected with the organic emitting layer. The organic emitting layer emits light of a corresponding color under drive of the anode and the cathode. The encapsulation layer 104 may include a first encapsulation layer, a second encapsulation layer, and a third encapsulation layer that are stacked, wherein the first encapsulation layer and the third encapsulation layer may be made of an inorganic material, the second encapsulation layer may be made of an organic material, and the second encapsulation layer is disposed between the first encapsulation layer and the third encapsulation layer to form a laminated structure of an inorganic material/an organic material/an inorganic material, which may ensure that external water vapor cannot enter the light emitting structure layer 103.

In an exemplary implementation mode, the organic emitting layer may include an Emitting Layer (EML), and any one or more of following layers: a Hole Injection Layer (HIL), a Hole Transport Layer (HTL), an Electron Block Layer (EBL), a Hole Block Layer (HBL), an Electron Transport Layer (ETL), and an Electron Injection Layer (EIL).

An exemplary embodiment of the present disclosure provides a display substrate including a plurality of circuit units, at least one circuit unit including a pixel drive circuit, the pixel drive circuit including at least a first storage capacitor and a second storage capacitor, a second end of the first storage capacitor being connected with a second end of the second storage capacitor; the first storage capacitor includes at least two first capacitor electrode plates, orthographic projections of the two first capacitor electrode plates on the base substrate are at least partially overlapped, and the second storage capacitor includes at least two second capacitor electrode plates, orthographic projections of the two second capacitor electrode plates on the base substrate are at least partially overlapped; on a plane perpendicular to the display substrate, the display substrate includes a semiconductor layer disposed on the base substrate, and a first conductive layer, a second conductive layer, and a third conductive layer sequentially disposed along a direction away from the base substrate, the at least two first capacitor electrode plates in the first storage capacitor are respectively disposed in the first conductive layer and the second conductive layer, and the at least two second capacitor electrode plates in the second storage capacitor are respectively disposed in the second conductive layer and the third conductive layer.

In an exemplary implementation mode, the at least two first capacitor electrode plates include a first electrode plate, a third electrode plate, and a fifth electrode plate, wherein the first electrode plate is disposed in the first conductive layer, the third electrode plate is disposed in the second conductive layer, and the fifth electrode plate is disposed in the third conductive layer; an orthographic projection of the first electrode plate on the base substrate is at least partially overlapped with an orthographic projection of the third electrode plate on the base substrate, and the orthographic projection of the third electrode plate on the base substrate is at least partially overlapped with an orthographic projection of the fifth electrode plate on the base substrate; the first storage capacitor includes a first sub-capacitor and a second sub-capacitor, the first sub-capacitor including the first electrode plate and the third electrode plate, and the second sub-capacitor including the third electrode plate and the fifth electrode plate.

In an exemplary implementation mode, the first sub-capacitor and the second sub-capacitor constitute a parallel structure.

In an exemplary implementation mode, the at least two second capacitor electrode plates include a second electrode plate, a fourth electrode plate, and a sixth electrode plate, wherein the second electrode plate is disposed in the first conductive layer, the fourth electrode plate is disposed in the second conductive layer, and the sixth electrode plate is disposed in the third conductive layer; an orthographic projection of the second electrode plate on the base substrate is at least partially overlapped with an orthographic projection of the fourth electrode plate on the base substrate, and the orthographic projection of the fourth electrode plate on the base substrate is at least partially overlapped with an orthographic projection of the sixth electrode plate on the base substrate; the second storage capacitor includes a third sub-capacitor and a fourth sub-capacitor, the third sub-capacitor including the second electrode plate and the fourth electrode plate, the fourth sub-capacitor including the fourth electrode plate and the sixth electrode plate.

In an exemplary implementation mode, the sixth electrode plate is connected with the second electrode plate, and the third sub-capacitor and the fourth sub-capacitor constitute a parallel structure.

In an exemplary implementation mode, the at least two first capacitor electrode plates include a first electrode plate, a third electrode plate, and a fifth electrode plate, the at least two second capacitor electrode plates include a second electrode plate, a fourth electrode plate, and a sixth electrode plate, the first electrode plate and the second electrode plate being disposed in the first conductive layer, the third electrode plate and the fourth electrode plate being disposed in the second conductive layer, and the fifth electrode plate and the sixth electrode plate being disposed in the third conductive layer; the fifth electrode plate is connected with the first electrode plate, and the sixth electrode plate is connected with the second electrode plate and the third electrode plate, respectively.

In an exemplary implementation mode, the fifth electrode plate is connected with the first electrode plate through a via, the sixth electrode plate is connected with the second electrode plate through a via, and the sixth electrode plate is connected with the third electrode plate through a connection electrode.

In an exemplary implementation mode, the at least two first capacitor electrode plates include a first electrode plate disposed in the first conductive layer and a third electrode plate disposed in the second conductive layer, an orthographic projection of the first electrode plate on the base substrate is at least partially overlapped with an orthographic projection of the third electrode plate on the base substrate, and the first storage capacitor includes the first electrode plate and the second electrode plate.

In an exemplary implementation mode, the at least two second capacitor electrode plates include a second electrode plate disposed in the second conductive layer and a fourth electrode plate disposed in the third conductive layer, an orthographic projection of the second electrode plate on the base substrate is at least partially overlapped with an orthographic projection of the fourth electrode plate on the base substrate, and the second storage capacitor includes the second electrode plate and the fourth electrode plate.

In an exemplary implementation mode, the third electrode plate of the first storage capacitor and the second electrode plate of the second storage capacitor are of an interconnected integral structure.

The display substrate of the present disclosure is illustrated with examples below through some exemplary embodiments.

FIG. 4 is an equivalent circuit diagram of a pixel drive circuit according to an exemplary embodiment of the present disclosure. In an exemplary implementation mode, the pixel drive circuit may have a structure of 3T1C, 4T1C, 5T1C, 5T2C, 6T1C, 7T1C, 8T1C, or 9T2C. As shown in FIG. 4, the pixel drive circuit according to an exemplary embodiment of the present disclosure may have a structure of 9T2C, and may include nine transistors (a first transistor T1 to a ninth transistor T9) and two storage capacitors (a first storage capacitor C1 and a second storage capacitor C2), and the pixel drive circuit is connected with twelve signal lines (a first scan signal line S1, a second scan signal line S2, a third scan signal line S3, a fourth scan signal line S4, a first light emitting signal line EM1, a second light emitting signal line EM2, a first initial signal line INIT1, a second initial signal line INIT2, a first reference signal line REF1, a second reference signal line REF2, a data signal line D, and a first power supply line VDD), respectively.

In an exemplary implementation mode, the pixel drive circuit may include a first node N1, a second node N2, a third node N3, a fourth node N4, and a fifth node N5. The first node N1 is respectively connected with a second electrode of the first transistor, a first electrode of the second transistor T2, a gate electrode of the third transistor T3, and a first end of the first storage capacitor C1, the second node N2 is respectively connected with a first electrode of the third transistor T3, a second electrode of the eighth transistor T8, and a second electrode of the fifth transistor T5, the third node N3 is respectively connected with a second electrode of the second transistor T2, a second electrode of the third transistor T3, and a first electrode of the sixth transistor T6, the fourth node N4 is respectively connected with a second electrode of the sixth transistor T6 and a second electrode of the seventh transistor T7, and the fifth node N5 is respectively connected with a second electrode of the fourth transistor T4, a second electrode of the ninth transistor T9, a second end of the first storage capacitor C1, and a second end of the second storage capacitor C2.

In an exemplary implementation mode, a first end of the first storage capacitor C1 is connected with the first node N1, a second end of the first storage capacitor C1 is connected with the fifth node N5, a first end of the second storage capacitor C2 is connected with the first power supply line VDD, and a second end of the second storage capacitor C2 is connected with the fifth node N5.

In an exemplary implementation mode, a gate electrode of the first transistor (referred to as a first initialization transistor) T1 is connected with the fourth scan signal line S4, a first electrode of the first transistor T1 is connected with the first initial signal line INIT1, and a second electrode of the first transistor is connected with the first node N1. When a turned-on signal is applied to the fourth scan signal line S4, the first transistor T1 transmits a first initial voltage to a gate electrode of the third transistor T3 and a first end of the first storage capacitor C1, so that accumulated charge in the first storage capacitor C1 is released, and initialization is achieved.

In an exemplary implementation mode, a gate electrode of the second transistor (referred to as a compensation transistor) T2 is connected with the second scan signal line S2, a first electrode of the second transistor T2 is connected with the first node N1, and a second electrode of the second transistor T2 is connected with the third node N3. When a turned-on signal is applied to the second scan signal line S2, the second transistor T2 enables a gate electrode of the third transistor T3 to be connected with a second electrode of the third transistor T3.

In an exemplary implementation mode, the gate electrode of the third transistor T3 is connected with the first node N1, i.e., the gate electrode of the third transistor T3 is connected with the first end of the first storage capacitor C1, the first electrode of the third transistor T3 is connected with the second node N2, and the second electrode of the third transistor T3 is connected with the third node N3. The third transistor T3 may be referred to as a drive transistor and the third transistor T3 determines a magnitude of a drive current according to a potential difference between the gate electrode and the first electrode of the third transistor T3.

In an exemplary implementation mode, a gate electrode of the fourth transistor (referred to as a data writing transistor) T4 is connected with the third scan signal line S3, a first electrode of the fourth transistor T4 is connected with a data signal line DATA, and a second electrode of the fourth transistor T4 is connected with the fifth node N5. When a turned-on signal is applied to the third scan signal line S3, the fourth transistor T4 enables a data voltage of the data signal line DATA to be input to a second end of the first storage capacitor C1 and a second end of the second storage capacitor C2.

In an exemplary implementation mode, a gate electrode of the fifth transistor T5 is connected with the first light emitting signal line EM1, a first electrode of the fifth transistor T5 is connected with the first power supply line VDD, and a second electrode of the fifth transistor T5 is connected with the second node N2. A gate electrode of the sixth transistor T6 is connected with the second light emitting signal line EM2, a first electrode of the sixth transistor T6 is connected with the third node N3, and a second electrode of the sixth transistor T6 is connected with the fourth node N4. When a turned-on signal is applied to the first light emitting signal line EM1 and the second light emitting signal line EM2, the fifth transistor T5 and the sixth transistor T6 form a drive current path between the first power supply line VDD and the second power supply line VSS to enable a light emitting device EL to emit light.

In an exemplary implementation mode, a gate electrode of the seventh transistor T7 is connected with the first scan signal line S1, a first electrode of the seventh transistor T7 is connected with the second initial signal line INIT2, and a second electrode of the seventh transistor T7 is connected with the fourth node N4. When a turned-on signal is applied to the first scan signal line S1, the seventh transistor T7 transmits a second initial voltage to a first electrode of the light emitting device EL, so that accumulated charge in the first electrode of the light emitting device EL is released, and initialization is achieved.

In an exemplary implementation mode, a gate electrode of the eighth transistor T8 is connected with the first scan signal line S1, a first electrode of the eighth transistor T8 is connected with the second reference signal line REF2, and a second electrode of the eighth transistor T8 is connected with the second node N2. When a turned-on signal is applied to the first scan signal line S1, the eighth transistor T8 transmits a second reference signal to the second node N2.

In an exemplary implementation mode, a gate electrode of the ninth transistor T9 is connected with the second scan signal line S2, a first electrode of the ninth transistor T9 is connected with the first reference signal line REF1, and a second electrode of the ninth transistor T9 is connected with the fifth node N5. When a turned-on signal is applied to the second scan signal line S2, the ninth transistor T9 transmits a first reference signal to the fifth node N5.

In an exemplary implementation mode, the light emitting device EL may be an OLED including a first electrode (anode), an organic emitting layer, and a second electrode (cathode), which are stacked, or may be a QLED including a first electrode (anode), a quantum dot emitting layer, and a second electrode (cathode), which are stacked. The first electrode of the light emitting device EL is connected with the fourth node N4, and a second electrode of the light emitting device EL is connected with the second power supply line VSS, a signal of the second power supply line VSS is a continuously supplied low-level signal, and a signal of the first power supply line VDD is a continuously supplied high-level signal.

In an exemplary implementation mode, the first transistor T1 to the ninth transistor T9 may be P-type transistors, or may be N-type transistors. Use of a same type of transistors in a pixel drive circuit may simplify a process flow, reduce a process difficulty of a display panel, and improve a product yield. In some possible implementation modes, the first transistor T1 to the ninth transistor T9 may include a P-type transistor and an N-type transistor.

In an exemplary implementation mode, for the first transistor T9 to the ninth transistor T1, low temperature poly silicon thin film transistors may be adopted, or oxide thin film transistors may be adopted, or a low temperature poly silicon thin film transistor and an oxide thin film transistor may be adopted. An active layer of a low temperature poly silicon thin film transistor may be made of Low Temperature Poly silicon (LTPS for short), and an active layer of an oxide thin film transistor may be made of an oxide semiconductor (Oxide). The low temperature poly silicon thin film transistor has advantages, such as a high mobility and fast charging, and the oxide thin film transistor has advantages, such a low drain current. The low temperature poly silicon thin film transistor and the oxide thin film transistor are integrated on one display substrate, that is a LTPS + Oxide (LTPO for short) display substrate, so that advantages of the low temperature poly silicon thin film transistor and the oxide thin film transistor may be utilized, low-frequency drive may be achieved, power consumption may be reduced, and display quality may be improved.

In an exemplary implementation mode, a working process of the pixel drive circuit shown in FIG. 4 may include a first stage to a fifth stage.

The first stage may include a plurality of sub-stages that are repeatedly executed, and each sub-stage may include a first sub-stage and a second sub-stage that are executed sequentially.

In the first sub-stage, signals of the fourth scan signal line S4 and the first light emitting signal line EM1 are turned-on signals, and signals of the other signal lines are turned-off signals. A signal of the fourth scan signal line S4 being a turned-on signal may enable the first transistor T1 to be turned on, and a first initial signal of the first initial signal line INIT1 may be provided to the first node N1 to initialize the first node N1. When the third transistor T3 is a P-type transistor, the third transistor T3 is turned on. A turned-on signal of the first light emitting signal line EM1 may enable the fifth transistor T5 to be turned on, and a first power supply signal of the first power supply line VDD may be provided to the second node N2.

In the second sub-stage, signals of the second scan signal line S2 and the first light emitting signal line EM1 are turned-on signals, and signals of the other signal lines are turned-off signals. A signal of the second scan signal line S2 being a turned-on signal may enable the second transistor T2 to be turned on, the first node N1 and the third node N3 are connected, and a threshold voltage of the third transistor T3 is written to the first node N1. The signal of the second scan signal line S2 being a turned-on signal may enable the ninth transistor T9 to be turned on, and a first reference signal of the first reference signal line REF1 is provided to the fifth node N5 to initialize the fifth node N5. A turned-on signal of the first light emitting signal line EM1 may enable the fifth transistor T5 to be turned on, and a first power supply signal of the first power supply line VDD may be provided to the second node N2.

In the second stage, a signal of the third scan signal line S3 is a turned-on signal, and signals of other signal lines are turned-off signals. A signal of the third scan signal line S3 being a turned-on signal may enable the fourth transistor T4 to be turned on, and a data voltage provided by the data signal line DATA is written to the fifth node N5.

In the third stage, a signal of the first scan signal line S1 is a turned-on signal, and signals of other signal lines are turned-off signals. The signal of the first scan signal line S1 being a turned-on signal enables the seventh transistor T7 to be turned on, and a second initial signal of the second initial signal line INIT2 may be written to the fourth node N4 to initialize the fourth node N4 to avoid a residual signal of a previous frame affecting display of a present frame. The signal of the first scan signal line S1 being a turned-on signal enables the eighth transistor T8 to be turned on, and a second reference signal of the second reference signal line REF2 may be written to the second node N2.

In the fourth stage, a signal of the second light emitting signal line EM2 is a turned-on signal, and signals of other signal lines are turned-off signals. The signal of the second light emitting signal line EM2 being a turned-on signal enables the sixth transistor T6 to be turned on, and the third node N3 and the fourth node N4 are connected, so that potentials of the third node N3 and the fourth node N4 are the same.

In the fifth stage, signals of the first light emitting signal line EM1 and the second light emitting signal line EM2 are turned-on signals, and signals of the other signal lines are turned-off signals. The signals of the first light emitting signal line EM1 and the second light emitting signal line EM2 being turned-on signals enable the fifth transistors T5 and the sixth transistors T6 to be turned on, and a first power supply signal of the first power supply line VDD may provide a drive signal to the light emitting device EL through the turned-on fifth transistor T5, the third transistor T3, and the sixth transistor T6 to drive the light emitting device EL to emit light.

In an exemplary implementation mode, when the drive transistor (i.e., the third transistor T3) is in a state for a long time, electrons are trapped in traps, causing hysteresis. Therefore, in the first stage, by performing initialization of the first node N1 and a threshold voltage writing process for multiple times (e.g., three times), not only the hysteresis of the drive transistor may be reduced, but also potential stability of the first node N1 may be ensured. In the third stage S3, the second reference signal is written into the second node N2, which may help to reduce the hysteresis of the drive transistor by changing a potential of the second node N2. In the fourth stage S4, by connecting the third node N3 and the fourth node N4, a potential of the fourth node N4 may be increased, which is conducive to reducing a time length required to subsequently reach an illumination voltage of the light emitting device.

The pixel drive circuit according to the present disclosure may effectively improve the hysteresis of the drive transistor, and is conducive to improving a display effect.

FIG. 5 is a schematic diagram of a planar structure of a display substrate according to an exemplary embodiment of the present disclosure, illustrating a structure of a pixel drive circuit in three circuit units (a first circuit unit, a second circuit unit, and a third circuit unit) in the display substrate. In an exemplary implementation mode, the display substrate may include a drive circuit layer disposed on a base substrate and a light emitting structure layer disposed at a side of the drive circuit layer away from the base substrate, the drive circuit layer may include at least a plurality of circuit units, the light emitting structure layer may include at least a plurality of light emitting units, at least one circuit unit including a pixel drive circuit, and at least one light emitting unit including a light emitting device, the light emitting device may include at least an anode, an organic emitting layer, and a cathode, the anode in the light emitting unit being connected with a pixel drive circuit in a corresponding circuit unit.

**In** an exemplary implementation mode, the circuit units mentioned in the present disclosure refer to regions divided according to pixel drive circuits, and light emitting units mentioned in the present disclosure refer to regions divided according to light emitting devices. **In** an exemplary embodiment, a position of an orthographic projection of a light emitting unit on the base substrate may correspond to a position of an orthographic projection of a circuit unit on the base substrate, or the position of the orthographic projection of the light emitting unit on the base substrate may not correspond to the position of the orthographic projection of the circuit unit on the base substrate.

**In** an exemplary embodiment, a plurality of circuit units sequentially disposed along a first direction X may be referred to as a unit row, and a plurality of circuit units sequentially disposed along a second direction Y may be referred to as a unit column. A plurality of unit rows and a plurality of unit columns form an array of circuit units arranged in an array, and the first direction X intersects with the second direction Y.

As shown in FIG. 5, in an exemplary implementation mode, at least one pixel drive circuit may include a first storage capacitor, a second storage capacitor, and a plurality of transistors, the plurality of transistors may include a first transistor T1 and a seventh transistor T7 as initialization transistors, a second transistor T2 as a compensation transistor, a third transistor T3 as a drive transistor, a fourth transistor T4 as a data writing transistor, a fifth transistor T5 and a sixth transistor T6 as light emitting transistors, and an eighth transistor T8 and a ninth transistor T9 as reference transistors.

**In** an exemplary implementation mode, a gate electrode of the first transistor T1 is connected with a fourth scan signal line 64, a first electrode of the first transistor T1 is connected with a first initial signal line 81, and a second electrode of the first transistor T1 is connected with a first electrode of the second transistor T2 and a first end of the first storage capacitor, respectively. A gate electrode of the second transistor T2 is connected with a fifth scan signal line 65, and a second electrode of the second transistor T2 is connected with a second electrode of the third transistor T3 and a first electrode of the sixth transistor T6, respectively. A gate electrode of the third transistor T3 is connected with the first end of the first storage capacitor, and a first electrode of the third transistor T3 is connected with a second electrode of the fifth transistor T5 and a second electrode of the eighth transistor T8, respectively. A gate electrode of the fourth transistor T4 is connected with a third scan signal line 63, a first electrode of the fourth transistor T4 is connected with a data signal line 53, and a second electrode of the fourth transistor T4 is connected with a second electrode of the ninth transistor T9, a second end of the first storage capacitor, and a second end of the second storage capacitor, respectively. A gate electrode of the fifth transistor T5 is connected with a first light emitting signal line 31, and a first electrode of the fifth transistor T5 is connected with a first power supply line 51. A gate electrode of the sixth transistor T6 is connected with a second light emitting signal line 32, and a second electrode of the sixth transistor T6 is connected with a second electrode of the seventh transistor T7. A gate electrode of the seventh transistor T7 is connected with a first scan signal line 61, and a first electrode of the seventh transistor T7 is connected with a second initial signal line 82. A gate electrode of the eighth transistor T8 is connected with the first scan signal line 61, and a first electrode of the eighth transistor T8 is connected with a second reference signal line 92. A gate electrode of the ninth transistor T9 is connected with a second scan signal line 62, and a first electrode of the ninth transistor T9 is connected with a first reference signal line 91.

In an exemplary implementation mode, the second scan signal line 62 and the fifth scan signal line 65 transmit a same scan signal.

In an exemplary implementation mode, the first scan signal line 61, the second scan signal line 62, the third scan signal line 63, the fourth scan signal line 64, the fifth scan signal line 65, the first light emitting signal line 31, the second light emitting signal line 32, the first initial signal line 81, the second initial signal line 82, the first reference signal line 91, and the second reference signal line 92 may be in a shape of a line with a main body portion extending along the first direction X, and the first power supply line 51 and the data signal line 53 may be in a shape of a line with a main body portion extending along the second direction Y.

In an exemplary implementation mode, the at least one circuit unit may further include an anode connection electrode 55, the anode connection electrode 55 is connected with a second electrode of the sixth transistor T6 and a second electrode of the seventh transistor T7 respectively on one hand, is connected with an anode of a light emitting unit on the other hand.

In an exemplary implementation mode, the drive circuit layer may further include a repair line 33, the repair line 33 may be in a shape of a line with a main body portion extending along the first direction X, an orthographic projection of the repair line 33 on the base substrate is at least partially overlapped with an orthographic projection of the anode connection electrode 55 on the base substrate, and the repair line 33 is configured such that a signal is input to an anode of a sub-pixel that has a defective bright spot through the repair line 33 when the display substrate has the defective bright spot, which is repaired into a dark spot.

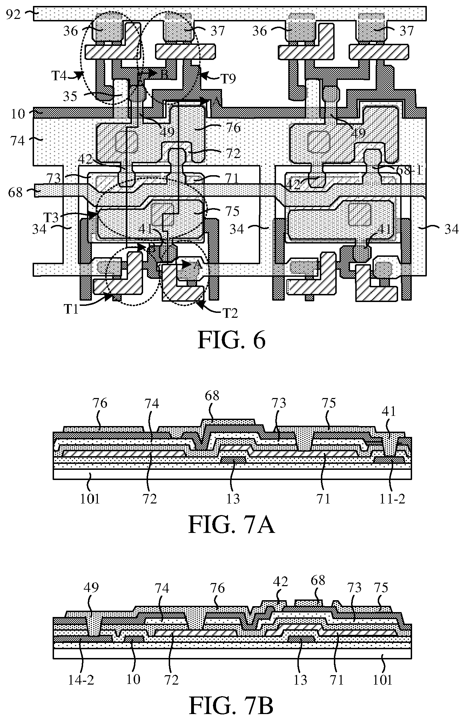

FIG. 6 is a schematic diagram of a structure of a first storage capacitor and a second storage capacitor in FIG. 5, FIG. 7A is a sectional view taken along an A-A direction in FIG. 6, and FIG. 7B is a sectional view taken along a B-B direction in FIG. 6. As shown in FIGs. 5, 6, 7A, and 7B, in an exemplary implementation mode, the first storage capacitor may include at least a first electrode plate 71, a third electrode plate 73, and a fifth electrode plate 75 as a first capacitor electrode plate, an orthographic projection of the third electrode plate 73 on the base substrate is at least partially overlapped with an orthographic projection of the first electrode plate 71 on the base substrate, the first electrode plate 71 and the third electrode plate 73 constitute a first sub-capacitor, an orthographic projection of the fifth electrode plate 75 on the base substrate is at least partially overlapped with the orthographic projection of the third electrode plate 73 on the base substrate, the third electrode plate 73 and the fifth electrode plate 75 constitute a second sub-capacitor, and the first sub-capacitor and the second sub-capacitor constitute the first storage capacitor. The second storage capacitor may include at least a second electrode plate 72, a fourth electrode plate 74, and a sixth electrode plate 76 as a second capacitor electrode plate, an orthographic projection of the fourth electrode plate 74 on the base substrate is at least partially overlapped with an orthographic projection of the second electrode plate 72 on the base substrate, the second electrode plate 72 and the fourth electrode plate 74 constitute a third sub-capacitor, an orthographic projection of the sixth electrode plate 76 on the base substrate is at least partially overlapped with the orthographic projection of the fourth electrode plate 74 on the base substrate, the fourth electrode plate 74 and the sixth electrode plate 76 constitute a fourth sub-capacitor, and the third sub-capacitor and the fourth sub-capacitor constitute the second storage capacitor.

In an exemplary implementation mode, on a plane perpendicular to the display substrate, the drive circuit layer may include a semiconductor layer, a first conductive layer, a second conductive layer, a third conductive layer, and a fourth conductive layer sequentially disposed on the base substrate. The first electrode plate 71 and the second electrode plate 72 may be disposed in the first conductive layer, the third electrode plate 73 and the fourth electrode plate 74 may be disposed in the second conductive layer, and the fifth electrode plate 75 and the sixth electrode plate 76 may be disposed in the third conductive layer.

In an exemplary implementation mode, the fifth electrode plate 75 and the first electrode plate 71 are connected with each other, and the first sub-capacitor and the second sub-capacitor constitute a parallel structure. The sixth electrode plate 76 and the second electrode plate 72 are connected with each other, and the third sub-capacitor and the fourth sub-capacitor constitute a parallel structure.

In an exemplary implementation mode, the fifth electrode plate 75 may be connected with the first electrode plate 71 through a via on one hand, and connected with a second region 11-2 of a first active layer in the first transistor T1 through a first connection electrode 41 on the other hand, and the first electrode plate 71 serves as a gate electrode of the third transistor T3. The sixth electrode plate 76 may be connected with the second electrode plate 72 through a via on one hand, connected with the third electrode plate 73 through a second connection electrode 42 on another hand, and connected with a second region 14-2 of a fourth active layer in the fourth transistor T4 through a ninth connection electrode 49 on yet another hand. The fourth electrode plate 74 may be connected with a first power supply connection line 68 through a via, thus the first electrode plate 71 and the fifth electrode plate 75 may serve as a first end of the first storage capacitor, the third electrode plate 73 may serve as a second end of the first storage capacitor, the fourth electrode plate 74 may serve as a first end of the second storage capacitor, and the second electrode plate 72 and the sixth electrode plate 76 may serve as a second end of the second storage capacitor.

In an exemplary implementation mode, a first end of the first connection electrode 41 is connected with the fifth electrode plate 75, a second end of the first connection electrode 41 is connected with the second region 11-2 of the first active layer in the first transistor T1 (also a first region of a second active layer in the second transistor T2) through a via, and the first connection electrode 41 may serve as a first node of the pixel drive circuit.

In an exemplary implementation mode, the first connection electrode 41 and the fifth electrode plate 75 may be of an interconnected integral structure.

In an exemplary implementation mode, a first end of the second connection electrode 42 is connected with the sixth electrode plate 76, and a second end of the second connection electrode 42 is connected with the third electrode plate 73 through a via. A first end of the ninth connection electrode 49 is connected with the sixth electrode plate 76, a second end of the ninth connection electrode 49 is connected with the second region 14-2 of the fourth active layer in the fourth transistor T4 (also a second region of a ninth active layer in the ninth transistor T9) through a via, and the second connection electrode 42 and the ninth connection electrode 49 may serve as a fifth node N5 in the pixel drive circuit.

In an exemplary implementation mode, the second connection electrode 42, the ninth connection electrode 49, and the sixth electrode plate 76 may be of an interconnected integral structure.

In an exemplary implementation mode, the at least one circuit unit may further include a first shielding electrode 34 connected with the fourth electrode plate 74, an orthographic projection of the first shielding electrode 34 on the base substrate is at least partially overlapped with an orthographic projection of the semiconductor layer between two gate electrodes of the first transistor T1 on the base substrate, and the orthographic projection of the first shielding electrode 34 on the base substrate is at least partially overlapped with an orthographic projection of the semiconductor layer between two gate electrodes of the second transistor T2 on the base substrate. In an exemplary implementation mode, the first shielding electrode 34 is configured to shield an influence of data voltage jump on the first transistor T1 and the second transistor T2, to prevent the data voltage jump from affecting a normal operation of the pixel drive circuit, and to improve a display effect.

In an exemplary implementation mode, the at least one circuit unit may further include a second shielding electrode 35 connected with the fourth electrode plate 74, and the second shielding electrode 35 is located between a first electrode of the fourth transistor T4 and a second electrode of the fourth transistor T4. In an exemplary implementation mode, the second shielding electrode 35 is configured to shield an influence of the first electrode of the fourth transistor T4 on the second electrode of the fourth transistor T4, to prevent data voltage jump from affecting the normal operation of the pixel drive circuit, and to improve the display effect.

In an exemplary implementation mode, the first shielding electrode 34, the second shielding electrode 35, and the fourth electrode plate 74 may be of an interconnected integral structure.

In an exemplary implementation mode, the at least one circuit unit may further include a third shielding electrode 36 connected with the second reference signal line 92, an orthographic projection of the third shielding electrode 36 on the base substrate is at least partially overlapped with an orthographic projection of the semiconductor layer between two gate electrodes of the fourth transistor T4 on the base substrate. In an exemplary implementation mode, the third shielding electrode 36 is configured to shield an influence of data voltage jump on the fourth transistor T4, to prevent the data voltage jump from affecting the normal operation of the pixel drive circuit, and to improve the display effect.

In an exemplary implementation mode, the at least one circuit unit may further include a fourth shielding electrode 37 connected with the second reference signal line 92, an orthographic projection of the fourth shielding electrode 37 on the base substrate is at least partially overlapped with an orthographic projection of the semiconductor layer between two gate electrodes of the ninth transistor T9 on the base substrate. In an exemplary implementation mode, the fourth shielding electrode 37 is configured to shield an influence of data voltage jump on the ninth transistor T9, to prevent the data voltage jump from affecting the normal operation of the pixel drive circuit, and to improve the display effect.

In an exemplary implementation mode, the third shielding electrode 36, the fourth shielding electrode 37, and the second reference signal line 92 may be of an interconnected integral structure.

In an exemplary implementation mode, the drive circuit layer may further include at least one first power supply connection line 68 extending along the first direction X and at least one first power supply line 51 extending along the second direction Y, the first power supply line 51 is connected with pixel drive circuits in a plurality of circuit units, the first power supply line 51 is configured to continuously provide a high-level signal to the pixel drive circuits, and the first power supply line 51 extending along the second direction Y is interconnected with the first power supply connection line 68 extending along the first direction X to form a mesh structure for transmitting a first power supply signal.

In an exemplary implementation mode, the drive circuit layer may further include at least one second initial signal line 82 extending along the first direction X and at least one initial connection line 56 extending along the second direction Y, the second initial signal line 82 is connected with pixel drive circuits in a plurality of circuit units, the second initial signal line 82 is configured to provide a second initial signal to the pixel drive circuits, and the second initial signal line 82 extending along the first direction X is interconnected with the initial connection line 56 extending along the second direction Y to form a mesh structure for transmitting a second initial signal.

In an exemplary implementation mode, the drive circuit layer may further include at least one first reference signal line 91 extending along the first direction X and at least one reference signal connection line 54 extending along the second direction Y, the first reference signal line 91 is connected with pixel drive circuits in a plurality of circuit units, the first reference signal line 91 is configured to provide a first reference signal to the pixel drive circuits, and the first reference signal line 91 extending along the first direction X is interconnected with the reference signal connection line 54 extending along the second direction Y to form a mesh structure for transmitting a first reference signal.

In the present disclosure, A extends along a B direction means that A may include a main portion and a secondary portion connected with the main portion, the main portion is a line, a line segment, or a strip-shaped body, the main portion extends along the B direction, and a length of the main portion extends along the B direction is greater than a length of the secondary portion extends along another direction.

In an exemplary implementation mode, the first power supply line 51 and the first power supply connection line 68 may be disposed in different conductive layers, and the first power supply line 51 and the first power supply connection line 68 may be connected through a via. The second initial signal line 82 and the initial connection line 56 may be disposed in different conductive layers, and the second initial signal line 82 and the initial connection line 56 may be connected through a via. The first reference signal line 91 and the reference signal connection line 54 may be disposed in different conductive layers, and the first reference signal line 91 and the reference signal connection line 54 may be connected through a via.

In an exemplary implementation mode, the first power supply connection line 68, the second initial signal line 82, and the first reference signal line 91 may be disposed in a same layer, i.e., the third conductive layer, and synchronously formed through a same patterning process, and the first power supply line 51, the reference signal connection line 54, and the initial connection line 56 may be disposed in a same layer, i.e., the fourth conductive layer, and synchronously formed through a same patterning process.

In an exemplary implementation mode, the at least one circuit unit may further include a power supply shielding block 51-1 connected with the first power supply line 51, an orthographic projection of the power supply shielding block 51-1 on the base substrate is at least partially overlapped with an orthographic projection of the first connection electrode 41 on the base substrate to shield an influence of another signal in the pixel drive circuit on the first node.

In an exemplary implementation mode, an orthographic projection of the first power supply line 51 on the base substrate is at least partially overlapped with orthographic projections of the second connection electrode 42 and the ninth connection electrode 49 on the base substrate to shield an influence of another signal in the pixel drive circuit on the fifth node.

Exemplary description is made below through a preparation process of a display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in an entire manufacturing process, the "thin film" may also be called a "layer". If the"thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are disposed in a same layer" in the present disclosure means that A and B are formed simultaneously through a same patterning process, and a "thickness" of a film layer is a dimension of the film layer in a direction perpendicular to a display substrate. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B.

In an exemplary implementation mode, taking three circuit units (a first circuit unit, a second circuit unit, and a third circuit unit) in an n-th unit row as an example, a preparation process of the display substrate according to the present embodiment includes following operations.

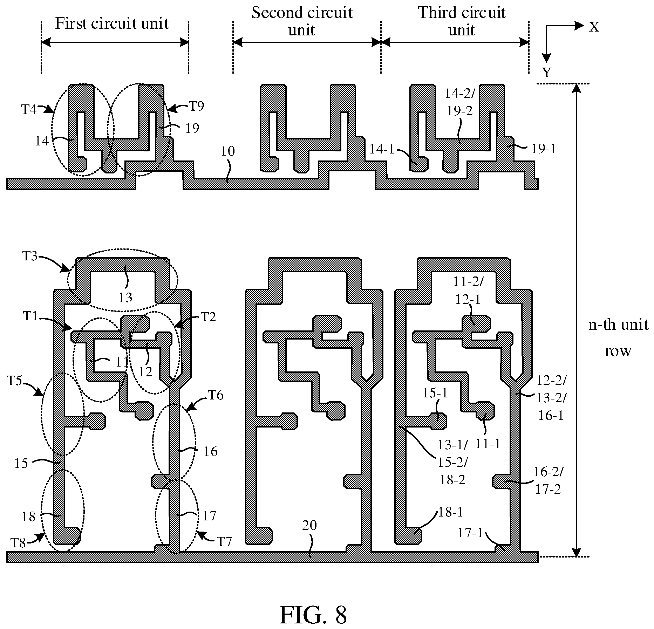

(11) A pattern of a semiconductor layer is formed. In an exemplary implementation mode, forming the pattern of the semiconductor layer may include: a first insulation thin film and a semiconductor thin film are sequentially deposited on a base substrate, and the semiconductor thin film is patterned through a patterning process to form a first insulation layer that covers the base substrate and the semiconductor layer disposed on the first insulation layer, as shown in FIG. 8.

In an exemplary implementation mode, a semiconductor layer of each circuit unit in the display substrate may include at least a first active layer 11 of a first transistor T1, a second active layer 12 of a second transistor T2, a third active layer 13 of a third transistor T3, a fourth active layer 14 of a fourth transistor T4, a fifth active layer 15 of a fifth transistor T5, a sixth active layer 16 of a sixth transistor T6, a seventh active layer 17 of a seventh transistor T7, an eighth active layer 18 of an eighth transistor T8, a ninth active layer 19 of a ninth transistor T9, a first active connection line 10, and a second active connection line 20, and the first active layer 11 to the third active layer 13 and the fifth active layer 15 to the eighth active layer 18 may be of an interconnected integral structure, and the fourth active layers 14 and the ninth active layers 19 may be of an interconnected integral structure.

In an exemplary implementation mode, the fourth active layer 14 and the ninth active layer 19 of the n-th unit row may be located at a side of the third active layer 13 close to an (n-1)-th unit row, that is, the fourth active layer 14 and the ninth active layer 19 may be located at a side of the third active layer 13 of a present circuit unit in an opposite direction of the second direction Y. The first active layer 11, the second active layer 12, and the fifth active layer 15 to the eighth active layer 18 of the n-th unit row may be located at a side of the third active layer 13 close to an (n+1)-th unit row, that is, the first active layer 11, the second active layer 12, and the fifth active layer 15 to the eighth active layer 18 may be located at a side of the third active layer 13 of the present circuit unit in the second direction Y.

In an exemplary implementation mode, the first active layer 11 may be located at a side of the third active layer 13 of the present circuit unit in the second direction Y, the fifth active layer 15 may be located at a side of the first active layer 11 of the present circuit unit in the second direction Y, and the eighth active layer 18 may be located at a side of the fifth active layer 15 of the present circuit unit in the second direction Y. The second active layer 12 may be located at a side of the third active layer 13 of the present circuit unit in the second direction Y, the sixth active layer 16 may be located at a side of the second active layer 12 of the present circuit unit in the second direction Y, and the seventh active layer 17 may be located at a side of the sixth active layer 16 of the present circuit unit in the second direction Y.

In an exemplary implementation mode, the fifth active layer 15 and the eighth active layer 18 may be located at one side of the third active layer 13 of the present circuit unit in the first direction X (e.g., a side in an opposite direction of the first direction X), and the sixth active layer 16 and the seventh active layer 17 may be located at the other side of the third active layer 13 of the present circuit unit in the first direction X (e.g., a side in the first direction X).

In an exemplary implementation mode, the first active layer 11 and the second active layer 12 may be in a shape of an "L", the third active layer 13 may be in a shape of a "C", the fourth active layer 14 and the ninth active layer 19 may be in a shape of an "n", and the fifth active layer 15, the sixth active layer 16, the seventh active layer 17, and the eighth active layer 18 may in a shape of an "I".

In an exemplary implementation mode, an active layer of each transistor may include a first region, a second region, and a channel region located between the first region and the second region. In an exemplary implementation mode, a second region 11-2 of the first active layer and a first region 12-1 of the second active layer may be interconnected, and the second region 11-2 of the first active layer may serve as the first region 12-1 of the second active layer. A first region 13-1 of the third active layer, a second region 15-2 of the fifth active layer, and a second region 18-2 of the eighth active layer may be connected with each other, and the first region 13-1 of the third active layer may simultaneously serve as the second region 15-2 of the fifth active layer and the second region 18-2 of the eighth active layer, constituting a second node N2 of a pixel drive circuit. A second region 12-2 of the second active layer, a second region 13-2 of the third active layer, and a first region 16-1 of the sixth active layer may be connected with each other, and the second region 13-2 of the third active layer may simultaneously serve as the second region 12-2 of the second active layer and the first region 16-1 of the sixth active layer, constituting a third node N3 of the pixel drive circuit. A second region 14-2 of the fourth active layer and a second region 19-2 of the ninth active layer may be interconnected, and the second region 14-2 of the fourth active layer may serve as the second region 19-2 of the ninth active layer. A second region 16-2 of the sixth active layer and a second region 17-2 of the seventh active layer may be interconnected, and the second region 16-2 of the sixth active layer may serve as the second region 17-2 of the seventh active layer, constituting a fourth node N4 of the pixel drive circuit. A first region 11-1 of the first active layer, a first region 14-1 of the fourth active layer, a first region 15-1 of the fifth active layer, a first region 17-1 of the seventh active layer, a first region 18-1 of the eighth active layer, and a first region 19-1 of the ninth active layer may be disposed separately.

In an exemplary implementation mode, the first active connection line 10 may be located at a side of the ninth active layer 19 in the second direction Y and connected with the first region 19-1 of the ninth active layer of each circuit unit. The second active connection line 20 may be located at a side of the seventh active layer 17 in the second direction Y and connected with the first region 17-1 of the seventh active layer of each circuit unit.

In an exemplary implementation mode, the first active connection line 10 may be in a shape of a bending line with a main body portion extending along the first direction X, and the first active connection line 10 and ninth active layers of a plurality of circuit units may be of an interconnected integral structure. Since the first region of the ninth active layer is connected with a first reference signal line formed subsequently, the first active connection line 10 may be multiplexed as a first reference signal line extending along the first direction X, which may not only ensure that first regions of a plurality of ninth active layers in a unit row have a same potential, but also reduce a voltage drop of a first reference signal, which is conducive to improving uniformity of a panel, avoiding poor display of the display substrate, and ensuring a display effect of the display substrate.

In an exemplary implementation mode, the second active connection line 20 may be in a shape of a straight line with a main body portion extending along the first direction X, and the second active connection line 20 and seventh active layers of a plurality of circuit units may be of an interconnected integral structure. Since the first region of the seventh active layer is connected with a second initial signal line formed subsequently, the second active connection line 20 may be multiplexed as a second initial signal line extending along the first direction X, which may not only ensure that first regions of a plurality of seventh active layers in a unit row have a same potential, but also reduce a voltage drop of a second initial signal, which is conducive to improving the uniformity of the panel, avoiding poor display of the display substrate, and ensuring the display effect of the display substrate.

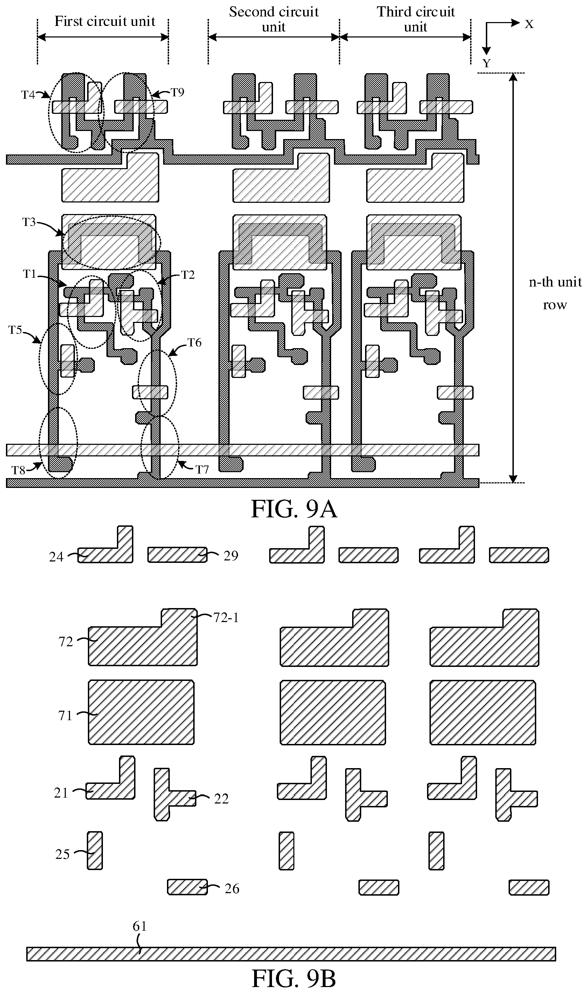

(12) A pattern of a first conductive layer is formed. In an exemplary implementation mode, forming the pattern of the first conductive layer may include: a second insulation thin film and a first conductive thin film are sequentially deposited on the base substrate on which the aforementioned pattern is formed, and the first conductive thin film is patterned through a patterning process to form a second insulation layer that covers the pattern of the semiconductor layer and a pattern of a first conductive layer disposed on the second insulation layer, as shown in FIG. 9A and FIG. 9B, and FIG. 9B is a schematic diagram of the first conductive layer in FIG. 9A. In an exemplary implementation mode, the first conductive layer may be referred to as a first gate metal (GATE1) layer.

In an exemplary implementation mode, the pattern of the first conductive layer of each circuit unit in the display substrate includes at least a first gate electrode 21, a second gate electrode 22, a fourth gate electrode 24, a fifth gate electrode 25, a sixth gate electrode 26, a ninth gate electrode 29, a first scan signal line 61, a first electrode plate 71 of a first storage capacitor, and a second electrode plate 72 of a second storage capacitor.

In an exemplary implementation mode, the first gate electrode 21 may be in a shape of an "L", and may be located at a side of the first electrode plate 71 in the second direction Y, and a region where the first gate electrode 21 is overlapped with the first active layer may serve as a gate electrode of the first transistor T1 with a dual-gate structure.

In an exemplary implementation mode, the second gate electrode 22 may be in a shape of a "T", and may be located at a side of the first electrode plate 71 in the second direction Y, and a region where the second gate electrode 22 is overlapped with the second active layer may serve as a gate electrode of the second transistor T2 with a dual-gate structure.

In an exemplary implementation mode, the fourth gate electrode 24 may be in a shape of an "L", and may be located at a side of the second electrode plate 72 in an opposite direction of the second direction Y, and a region where the fourth gate electrode 24 is overlapped with the fourth active layer may serve as a gate electrode of the fourth transistor T4 with a dual-gate structure.

In an exemplary implementation mode, the fifth gate electrode 25 may be in a shape of a strip extending along the second direction Y, and may be located at a side of the first gate electrode 21 in the second direction Y, and a region where the fifth gate electrode 25 is overlapped with the fifth active layer may serve as a gate electrode of the fifth transistor T5.

In an exemplary implementation mode, the sixth gate electrode 26 may be in a shape of a strip extending along the first direction X, and may be located at a side of the second gate electrode 22 in the second direction Y, and a region where the sixth gate electrode 26 is overlapped with the sixth active layer may serve as a gate electrode of the sixth transistor T6.

In an exemplary implementation mode, the ninth gate electrode 29 may be in a shape of a strip extending along the first direction X, and may be located at a side of the second electrode plate 72 in an opposite direction of the second direction Y, and a region where the ninth gate electrode 29 is overlapped with the ninth active layer may serve as a gate electrode of the ninth transistor T9 with a dual-gate structure.

In an exemplary implementation mode, the first scan signal line 61 may be in a shape of a line with a main body portion extending along the first direction X, and may be located at a side of the fifth gate electrode 25 and the sixth gate electrode 26 in the second direction Y. A region where the first scan signal line 61 is overlapped with the seventh active layer may serve as a gate electrode of the seventh transistor T7, and a region where the first scan signal line 61 is overlapped with the eighth active layer may serve as a gate electrode of the eighth transistor T8.

In an exemplary implementation mode, the first electrode plate 71 of the first storage capacitor may be in a shape of a rectangle, corners of the rectangle may be provided with chamfers, an orthographic projection of the first electrode plate 71 on the base substrate is at least partially overlapped with an orthographic projection of the third active layer of the third transistor T3 on the base substrate, and the first electrode plate 71 may simultaneously serve as a lower electrode plate of the first storage capacitor and a gate electrode of the third transistor T3.

In an exemplary implementation mode, the second electrode plate 72 of the second storage capacitor may be in a shape of a rectangle, corners of the rectangle may be provided with chamfers, and the second electrode plate 72 may be located at a side of the first electrode plate 71 in an opposite direction of the second direction Y, and at a side of the fourth gate electrode 24 and the ninth gate electrode 29 in the second direction Y, that is, in the second direction Y, the second electrode plate 72 is located between the first electrode plate 71 and the fourth gate electrode 24 (the ninth gate electrode 29), and an orthographic projection of the second electrode plate 72 on the base substrate is not overlapped with an orthographic projection of the semiconductor layer on the base substrate. In an exemplary implementation mode, the second electrode plate 72 may serve as a lower electrode plate of the second storage capacitor.

In an exemplary implementation mode, a region where the first active connection line 10 is connected with the first region of the ninth active layer is bent toward a direction of the ninth active layer, so that a recess is formed at a side of the first active connection line 10 away from the ninth active layer. A protrusion 72-1 is provided at a side of the second electrode plate 72 close to the first active connection line 10, the protrusion 72-1 may be in a shape of a block (e.g., a rectangle), a first end of the protrusion 72-1 is connected with the second electrode plate 72, and a second end of the protrusion 72-1 is extended into the recess of the first active connection line 10.

In an exemplary implementation mode, the second electrode plate 72 and the protrusion 72-1 may be of an interconnected integral structure. In the present disclosure, by providing the recess of the first active connection line 10 and the protrusion 72-1 of the second electrode plate 72, an area of the second electrode plate 72 may be effectively increased, and a capacitance amount of the second storage capacitor may be effectively increased.

In an exemplary implementation mode, after the pattern of the first conductive layer is formed, the semiconductor layer may be subjected to a conductive treatment by using the first conductive layer as a shelter. The semiconductor layer in a region, which is sheltered by the first conductive layer, forms channel regions of the first transistor T1 to the ninth transistor T9, and the semiconductor layer in a region, which is not sheltered by the first conductive layer, is made to be conductive, that is, first regions and second regions of the first active layer to the ninth active layer, the first active connection line, and the second active connection line are all made to be conductive.

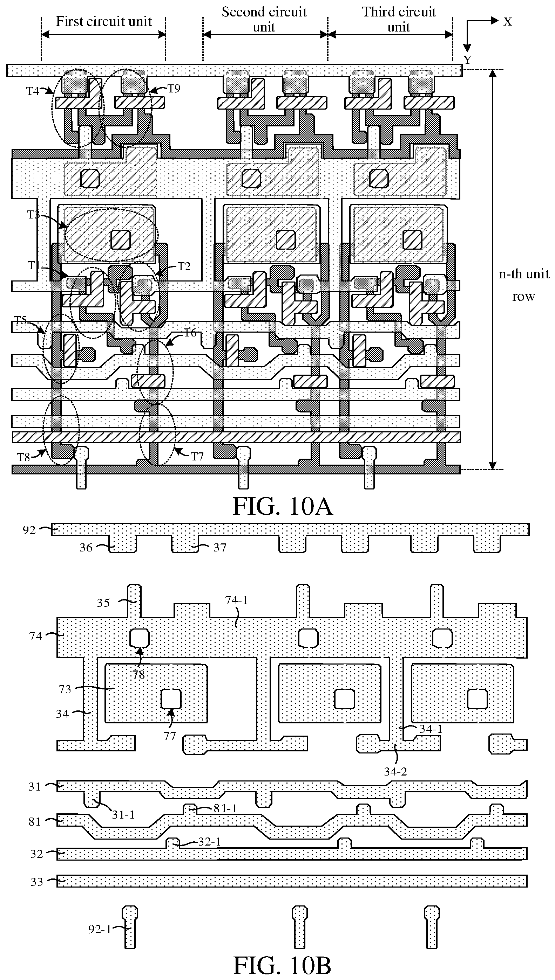

(13) A pattern of a second conductive layer is formed. In an exemplary implementation mode, forming the pattern of the second conductive layer may include: a third insulation thin film and a second conductive thin film are sequentially deposited on the base substrate on which the aforementioned patterns are formed, and the second conductive thin film is patterned through a patterning process to form a third insulation layer that covers the first conductive layer and the pattern of the second conductive layer disposed on the third insulation layer, as shown in FIG. 10A and FIG. 10B, and FIG. 10B is a schematic diagram of the second conductive layer in FIG. 10A. In an exemplary implementation mode, the second conductive layer may be referred to as a second gate metal (GATE2) layer.

In an exemplary implementation mode, the pattern of the second conductive layer of each circuit unit in the display substrate includes at least a first light emitting signal line 31, a second light emitting signal line 32, a repair line 33, a first shielding electrode 34, a second shielding electrode 35, a third shielding electrode 36, a fourth shielding electrode 37, a third electrode plate 73 of the first storage capacitor, a fourth electrode plate 74 of the second storage capacitor, a first initial signal line 81, and a second reference signal line 92.

In an exemplary implementation mode, the first light emitting signal line 31, the second light emitting signal line 32, the repair line 33, the first initial signal line 81, and the second reference signal line 92 may be in a shape of a line with a main body portion extending along the first direction X, the first light emitting signal line 31, the second light emitting signal line 32, the repair line 33, and the first initial signal line 81 may be located between the first gate electrode 21 and the first scan signal line 61, and the second reference signal line 92 may be located at a side of the fourth gate electrode 24 in an opposite direction of the second direction Y.

In an exemplary implementation mode, the first light emitting signal line 31 may be located at a side of the first gate electrode 21 of the present circuit unit in the second direction Y, the first initial signal line 81 may be located at a side of the first light emitting signal line 31 of the present circuit unit in the second direction Y, the second light emitting signal line 32 may be located at a side of the first initial signal line 81 of the present circuit unit in the second direction Y, and the repair line 33 may be located at a side of the second light emitting signal line 32 of the present circuit unit in the second direction Y, that is, the second light emitting signal line 32 and the first initial signal line 81 may be located between the first light emitting signal line 31 and the repair line 33.

In an exemplary implementation mode, a first light emitting connection block 31-1 is provided at a side of the first light emitting signal line 31 close to the first initial signal line 81, the first light emitting connection block 31-1 may be provided in each circuit unit, a first end of the first light emitting connection block 31-1 is connected with the first light emitting signal line 31, a second end of the first light emitting connection block 31-1 extends toward a direction of the first initial signal line 81, and the first light emitting connection block 31-1 is configured to be connected with the fifth gate electrode 25 through a seventh connection electrode formed subsequently. In an exemplary implementation mode, the first light emitting signal line 31 and a plurality of first light emitting connection blocks 31-1 may be of an interconnected integral structure.

In an exemplary implementation mode, a second light emitting connection block 32-1 is provided at a side of the second light emitting signal line 32 close to the first initial signal line 81, the second light emitting connection block 32-1 may be provided in each circuit unit, a first end of the second light emitting connection block 32-1 is connected with the second light emitting signal line 32, a second end of the second light emitting connection block 32-1 extends toward a direction of the first initial signal line 81, and the second light emitting connection block 32-1 is configured to be connected with the sixth gate electrode 26 through an eighth connection electrode formed subsequently. In an exemplary implementation mode, the second light emitting signal line 32 and a plurality of second light emitting connection blocks 32-1 may be of an interconnected integral structure.

In an exemplary implementation mode, a first initial connection block 81-1 is provided at a side of the first initial signal line 81 close to the first light emitting signal line 31, the first initial connection block 81-1 may be provided in each circuit unit, a first end of the first initial connection block 81-1 is connected with the first initial signal line 81, a second end of the first initial connection block 81-1 extends toward a direction of the first light emitting signal line 31, and the first initial connection block 81-1 is configured to be connected with the first region of the first active layer through a subsequently formed tenth connection electrode. In an exemplary implementation mode, the first initial signal line 81 and a plurality of first initial connection blocks 81-1 may be of an interconnected integral structure.

In an exemplary implementation mode, a second reference connection block 92-1 is provided at a side of the second reference signal line 92 of the n-th unit row away from the second electrode plate 72 of the n-th unit row, the second reference connection block 92-1 may be provided in each circuit unit, a first end of the second reference connection block 92-1 is connected with the second reference signal line 92, and a second end of the second reference connection block 92-1 extends toward a direction away from the second electrode plate 72, that is, toward a direction of the (n-1)-th unit row. In an exemplary implementation mode, the second reference connection block 92-1 of the second reference signal line 92 in the (n-1)-th unit row is configured to be connected with the first region of the eighth active layer in the (n-1)-th unit row through a subsequently formed sixth connection electrode, and provide a second reference signal to a first electrode of the eighth transistor T8 in the (n-1)-th unit row. In an exemplary implementation mode, the second reference signal line 92 and a plurality of second reference connection blocks 92-1 may be of an interconnected integral structure.

In an exemplary implementation mode, the third electrode plate 73 of the first storage capacitor has a contour that may be in a shape of a rectangle, corners of the rectangle may be provided with chamfers, may be located between the first light emitting signal line 31 and the second reference signal line 92 of the present circuit unit, an orthographic projection of the third electrode plate 73 on the base substrate is at least partially overlapped with an orthographic projection of the first electrode plate 71 on the base substrate, the third electrode plate 73 may serve as an intermediate electrode plate of the first storage capacitor, and the first electrode plate 71 and the third electrode plate 73 constitute the first sub-capacitor of the first storage capacitor of the pixel drive circuit.

In an exemplary implementation mode, the fourth electrode plate 74 of the second storage capacitor has a contour that may be in a shape similar to the second electrode plate 72, may be located between the second reference signal line 92 and the third electrode plate 73 of the present circuit unit, an orthographic projection of the fourth electrode plate 74 on the base substrate is at least partially overlapped with an orthographic projection of the second electrode plate 72 on the base substrate, the fourth electrode plate 74 may serve as an intermediate electrode plate of the second storage capacitor, and the second electrode plate 72 and the fourth electrode plate 74 constitute the third sub-capacitor of the second storage capacitor C2 of the pixel drive circuit.

In an exemplary implementation mode, an electrode plate connection line 74-1 may be provided at a side of the fourth electrode plate 74 in the first direction X or at a side in an opposite direction of the first direction X, a first end of the electrode plate connection line 74-1 is connected with the fourth electrode plate 74 of the present circuit unit, and a second end of the electrode plate connection line 74-1 extends along the first direction X or an opposite direction of the first direction X, and is connected with a fourth electrode plate 74 of an adjacent circuit unit, so that fourth electrode plates 74 of adjacent circuit units on a unit row are connected with each other. In an exemplary implementation mode, a plurality of fourth electrode plates 74 and a plurality of electrode plate connection lines 74-1 arranged at intervals along the first direction X may be of an interconnected integral structure. Since the fourth electrode plate 74 is connected with a first power supply line formed subsequently, fourth electrode plates 74 of an integral structure of a plurality of circuit units may be multiplexed as a lateral power supply line extending along the first direction X, which may not only ensure that a plurality of fourth electrode plates in one unit row have a same potential, but also reduce a voltage drop of a first power supply signal, and is conducive to improving the uniformity of the panel, avoid poor display of the display substrate, and ensure the display effect of the display substrate.

In an exemplary implementation mode, the fourth electrode plates 74 and the electrode plate connection lines 74-1 arranged at intervals along the first direction X may be of an interconnected integral structure.

In an exemplary implementation mode, the third electrode plate 73 of each circuit unit is provided with a first opening 77, the first opening 77 may be located in a partial region of the third electrode plate 73, the first opening 77 may be rectangular or circular, etc., so that the third electrode plate 73 forms an annular structure. The first opening 77 exposes the third insulation layer covering the first electrode plate 71, and an orthographic projection of the first electrode plate 71 on the base substrate contains an orthographic projection of the first opening 77 on the base substrate. In an exemplary implementation mode, the first opening 77 is configured to accommodate a subsequently formed tenth via, the tenth via is located within the first opening 77 and exposes the first electrode plate 71, so that a subsequently formed fifth electrode plate is connected with the first electrode plate 71.

In an exemplary implementation mode, the fourth electrode plate 74 of each circuit unit is provided with a second opening 78, the second opening 78 may be located in a partial region of the fourth electrode plate 74, the second opening 78 may be rectangular or circular, etc., so that the fourth electrode plate 74 forms an annular structure. The second opening 78 exposes the third insulation layer covering the second electrode plate 72, and an orthographic projection of the second electrode plate 72 on the base substrate contains an orthographic projection of the second opening 78 on the base substrate. In an exemplary implementation mode, the second opening 78 is configured to accommodate a subsequently formed eleventh via, the eleventh via is located within the second opening 78 and exposes the second electrode plate 72, so that a subsequently formed sixth electrode plate is connected with the second electrode plate 72.

In an exemplary implementation mode, the first shielding electrode 34 may be in a shape of a "T", may be located at a side of the fourth electrode plate 74 close to the first light emitting signal line 31, and the first shielding electrode 34 may be provided in each circuit unit. The first shielding electrode 34 in a shape of a "T" may include a first extension section 34-1 and a first shielding section 34-2, a first end of the first extension section 34-1 is connected with the fourth electrode plate 74, and a second end of the first extension section 34-1 is connected with the first shielding section 34-2 after extending toward the first light emitting signal line 31. The first shielding section 34-2 may be in a shape of a strip extending along the first direction X. In the first shielding section 34-2, for a first shielding end located at a side of the first extension section 34-1 in the first direction X and a second shielding end located at a side of the first extension section 34-1 in an opposite direction of the first direction X, an orthographic projection of the first shielding end on the base substrate is at least partially overlapped with an orthographic projection of a first active layer between two gate electrodes of the first transistor T1 in the present circuit unit on the base substrate, and an orthographic projection of the second shielding end on the base substrate is at least partially overlapped with an orthographic projection of a first active layer between two gate electrodes of the second transistor T2 in an adjacent circuit unit on the base substrate. In an exemplary implementation mode, the first shielding electrode 34 is configured to shield an influence of data voltage jump on the first transistor T1 and the second transistor T2, to prevent the data voltage jump from affecting a normal operation of the pixel drive circuit, and to improve the display effect.

In an exemplary implementation mode, the second shielding electrode 35 may be in a shape of an "I", may be provided at a side of the fourth electrode plate 74 close to the second reference signal line 92, and the second shielding electrode 35 may be provided in each circuit unit. In an exemplary implementation mode, a first end of the second shielding electrode 35 is connected with the fourth electrode plate 74, a second end of the second shielding electrode 35 extends toward the second reference signal line 92, and is located between the first region of the fourth active layer and the second region of the fourth active layer, the second shielding electrode 35 is configured to provide shielding between the first region of the fourth active layer (the first electrode of the fourth transistor T4) and the second region of the fourth active layer (the second electrode of the fourth transistor T4), reduce an influence of data voltage jump on a potential of the fifth node N5 of the pixel drive circuit, and improve the display effect.

In an exemplary implementation mode, the first shielding electrode 34, the second shielding electrode 35, and the fourth electrode plate 74 may be of an interconnected integral structure.

In an exemplary implementation mode, the third shielding electrode 36 and the fourth shielding electrode 37 may be in a shape of a block (e.g., a rectangle, etc.), may be located at a side of the second reference signal line 92 close to the fourth electrode plate 74, and the third shielding electrode 36 and the fourth shielding electrode 37 may be provided in each circuit unit. First ends of the third shielding electrode 36 and the fourth shielding electrode 37 are connected with the second reference signal line 92, and second ends of the third shielding electrode 36 and the fourth shielding electrode 37 extend toward a direction of the fourth electrode plate 74. An orthographic projection of the third shielding electrode 36 on the base substrate is at least partially overlapped with an orthographic projection of the fourth active layer between two gate electrodes of the fourth transistor T4 in the present circuit unit on the base substrate, and an orthographic projection of the fourth shielding electrode 37 on the base substrate is at least partially overlapped with an orthographic projection of the ninth active layer between two gate electrodes of the ninth transistor T9 in the present circuit unit on the base substrate. In an exemplary implementation mode, the third shielding electrode 36 is configured to shield an influence of data voltage jump on the fourth transistor T4, and the fourth shielding electrode 37 is configured to shield an influence of data voltage jump on the ninth transistor T9, so as to prevent the data voltage jump from affecting the normal operation of the pixel drive circuit and improve the display effect.

In an exemplary implementation mode, the repair line 33, as a preset repair signal line, is configured such that a signal is input to an anode of a sub-pixel that has a defective bright spot through the repair line 33 when the display substrate has the defective bright spot, which is repaired into a dark spot.

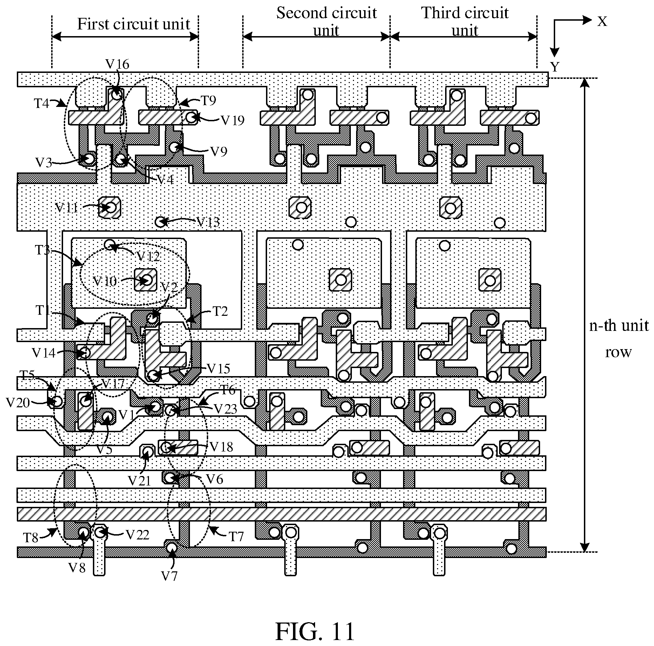

(14) A pattern of a fourth insulation layer is formed. In an exemplary implementation mode, forming the pattern of the fourth insulation layer may include: a fourth insulation thin film is deposited on the base substrate on which the aforementioned patterns are formed, and the fourth insulation thin film is patterned through a patterning process, to form a fourth insulation layer that covers the second conductive layer, wherein a plurality of vias are disposed on each circuit unit, as shown in FIG. 11.

In an exemplary implementation mode, the plurality of vias in each circuit unit in the display substrate include at least a first via V1, a second via V2, a third via V3, a fourth via V4, a fifth via V5, a sixth via V6, a seventh via V7, an eighth via V8, a ninth via V9, a tenth via V10, an eleventh via V11, a twelfth via V12, a thirteenth via V13, a fourteenth via V14, a fifteenth via V15, a sixteenth via V16, a seventeenth via V17, an eighteenth via V18, a nineteenth via V19, a twentieth via V20, a twenty-first via V21, a twenty-second via V22, and a twenty-third via V23.

In an exemplary implementation mode, an orthographic projection of the first via V1 on the base substrate is within a range of an orthographic projection of the first region of the first active layer on the base substrate, the fourth insulation layer, the third insulation layer, and the second insulation layer within the first via V1 are etched off to expose a surface of the first region of the first active layer, and the first via V1 is configured such that a subsequently formed tenth connection electrode is connected with the first region of the first active layer through the via.

In an exemplary implementation mode, an orthographic projection of the second via V2 on the base substrate is within a range of an orthographic projection of the second region of the first active layer (also the first region of the second active layer) on the base substrate, the fourth insulation layer, the third insulation layer, and the second insulation layer within the second via V2 are etched off to expose a surface of the second region of the first active layer (also the first region of the second active layer), and the second via V2 is configured such that a subsequently formed first connection electrode is connected with the second region of the first active layer (also the first region of the second active layer) through the via.

In an exemplary implementation mode, an orthographic projection of the third via V3 on the base substrate is within a range of an orthographic projection of the first region of the fourth active layer on the base substrate, the fourth insulation layer, the third insulation layer, and the second insulation layer within the third via V3 are etched off to expose a surface of the first region of the fourth active layer, and the third via V3 is configured such that a subsequently formed third connection electrode is connected with the first region of the fourth active layer through the via.

In an exemplary implementation mode, an orthographic projection of the fourth via V4 on the base substrate is within a range of an orthographic projection of the second region of the fourth active layer (also the second region of the ninth active layer) on the base substrate, the fourth insulation layer, the third insulation layer, and the second insulation layer within the fourth via V4 are etched off to expose a surface of the second region of the fourth active layer (also the second region of the ninth active layer), and the fourth via V4 is configured such that a subsequently formed ninth connection electrode is connected with the second region of the fourth active layer (also the second region of the ninth active layer) through the via.

In an exemplary implementation mode, an orthographic projection of the fifth via V5 on the base substrate is within a range of an orthographic projection of the first region of the fifth active layer on the base substrate, the fourth insulation layer, the third insulation layer, and the second insulation layer within the fifth via V5 are etched off to expose a surface of the first region of the fifth active layer, and the fifth via V5 is configured such that a subsequently formed fourth connection electrode is connected with the first region of the fifth active layer through the via.

In an exemplary implementation mode, an orthographic projection of the sixth via V6 on the base substrate is within a range of an orthographic projection of the second region of the sixth active layer (also the second region of the seventh active layer) on the base substrate, the fourth insulation layer, the third insulation layer, and the second insulation layer within the sixth via V6 are etched off to expose a surface of the second region of the sixth active layer (also the second region of the seventh active layer), and the sixth via V6 is configured such that a subsequently formed fifth connection electrode is connected with the second region of the sixth active layer (also the second region of the seventh active layer) through the via.

In an exemplary implementation mode, an orthographic projection of the seventh via V7 on the base substrate is within a range of an orthographic projection of the first region of the seventh active layer on the base substrate, the fourth insulation layer, the third insulation layer, and the second insulation layer within the seventh via V7 are etched off to expose a surface of the first region of the seventh active layer, and the seventh via V7 is configured such that a second initial signal line formed subsequently is connected with the first region of the seventh active layer through the via.

In an exemplary implementation mode, an orthographic projection of the eighth via V8 on the base substrate is within a range of an orthographic projection of the first region of the eighth active layer on the base substrate, the fourth insulation layer, the third insulation layer, and the second insulation layer within the eighth via V8 are etched off to expose a surface of the first region of the eighth active layer, and the eighth via V8 is configured such that a subsequently formed sixth connection electrode is connected with the first region of the eighth active layer through the via.

In an exemplary implementation mode, an orthographic projection of the ninth via V9 on the base substrate is within a range of an orthographic projection of the first region of the ninth active layer on the base substrate, the fourth insulation layer, the third insulation layer, and the second insulation layer within the ninth via V9 are etched off to expose a surface of the first region of the ninth active layer, and the ninth via V9 is configured such that a first reference signal line formed subsequently is connected with the first region of the ninth active layer through the via.

In an exemplary implementation mode, an orthographic projection of the tenth via V10 on the base substrate is within a range of an orthographic projection of the first opening 77 of the third electrode plate 73 on the base substrate, the fourth insulation layer and the third insulation layer within the tenth via V10 are etched off to expose a surface of the first electrode plate 71, and the tenth via V10 is configured such that a subsequently formed fifth electrode plate is connected with the first electrode plate 71 through the via.

In an exemplary implementation mode, an orthographic projection of the eleventh via V11 on the base substrate is within a range of an orthographic projection of the second opening 78 of the fourth electrode plate 74 on the base substrate, the fourth insulation layer and the third insulation layer within the eleventh via V11 are etched off to expose a surface of the second electrode plate 72, and the eleventh via V11 is configured such that a subsequently formed sixth electrode plate is connected with the second electrode plate 72 through the via.

In an exemplary implementation mode, an orthographic projection of the twelfth via V12 on the base substrate is within a range of an orthographic projection of the third electrode plate 73 on the base substrate, the fourth insulation layer within the twelfth via V12 is etched off to expose a surface of the third electrode plate 73, and the twelfth via V12 is configured such that a second connection electrode formed subsequently is connected with the third electrode plate 73 through the via.

In an exemplary implementation mode, an orthographic projection of the thirteenth via V13 on the base substrate is within a range of an orthographic projection of the fourth electrode plate 74 on the base substrate, the fourth insulation layer within the thirteenth via V13 is etched off to expose a surface of the fourth electrode plate 74, and the thirteenth via V13 is configured such that a first power supply connection line formed subsequently is connected with the fourth electrode plate 74 through the via.

In an exemplary implementation mode, an orthographic projection of the fourteenth via V14 on the base substrate is within a range of an orthographic projection of the first gate electrode 21 on the base substrate, the fourth insulation layer and the third insulation layer within the fourteenth via V14 are etched off to expose a surface of the first gate electrode 21, and the fourteenth via V14 is configured such that a subsequently formed fourth scan signal line is connected with the first gate electrode 21 through the via.

In an exemplary implementation mode, an orthographic projection of the fifteenth via V15 on the base substrate is within a range of an orthographic projection of the second gate electrode 22 on the base substrate, the fourth insulation layer and the third insulation layer within the fifteenth via V15 are etched off to expose a surface of the second gate electrode 22, and the fifteenth via V15 is configured such that a subsequently formed fifth scan signal line is connected with the second gate electrode 22 through the via.

In an exemplary implementation mode, an orthographic projection of the sixteenth via V16 on the base substrate is within a range of an orthographic projection of the fourth gate electrode 24 on the base substrate, the fourth insulation layer and the third insulation layer within the sixteenth via V16 are etched off to expose a surface of the fourth gate electrode 24, and the sixteenth via V16 is configured such that a subsequently formed third scan signal line is connected with the fourth gate electrode 24 through the via.

In an exemplary implementation mode, an orthographic projection of the seventeenth via V17 on the base substrate is within a range of an orthographic projection of the fifth gate electrode 25 on the base substrate, the fourth insulation layer and the third insulation layer within the seventeenth via V17 are etched off to expose a surface of the fifth gate electrode 25, and the seventeenth via V17 is configured such that a subsequently formed seventh connection electrode is connected with the fifth gate electrode 25 through the via.

In an exemplary implementation mode, an orthographic projection of the eighteenth via V18 on the base substrate is within a range of an orthographic projection of the sixth gate electrode 26 on the base substrate, the fourth insulation layer and the third insulation layer within the eighteenth via V18 are etched off to expose a surface of the sixth gate electrode 26, and the eighteenth via V18 is configured such that a subsequently formed eighth connection electrode is connected with the sixth gate electrode 26 through the via.

In an exemplary implementation mode, an orthographic projection of the nineteenth via V19 on the base substrate is within a range of an orthographic projection of the ninth gate electrode 29 on the base substrate, the fourth insulation layer and the third insulation layer within the nineteenth via V19 are etched off to expose a surface of the ninth gate electrode 29, and the nineteenth via V19 is configured such that a second scan signal line formed subsequently is connected with the ninth gate electrode 29 through the via.

In an exemplary implementation mode, an orthographic projection of the twentieth via V20 on the base substrate is within a range of an orthographic projection of the first light emitting connection block 31-1 of the first light emitting signal line 31 on the base substrate, the fourth insulation layer within the twentieth via V20 is etched off to expose a surface of the first light emitting connection block 31-1, and the twentieth via V20 is configured such that a subsequently formed seventh connection electrode is connected with the first light emitting connection block 31-1 through the via.

In an exemplary implementation mode, an orthographic projection of the twenty-first via V21 on the base substrate is within a range of an orthographic projection of the second light emitting connection block 32-1 of the second light emitting signal line 32 on the base substrate, the fourth insulation layer within the twenty-first via V21 is etched off to expose a surface of the second light emitting connection block 32-1, and the twenty-first via V21 is configured such that a subsequently formed eighth connection electrode is connected with the second light emitting connection block 32-1 through the via.

In an exemplary implementation mode, an orthographic projection of the twenty-second via V22 on the base substrate is within a range of an orthographic projection of the second reference connection block 92-1 of the second reference signal line 92 on the base substrate, the fourth insulation layer within the twenty-second via V22 is etched off to expose a surface of the second reference connection block 92-1, and the twenty-second via V22 is configured such that a subsequently formed sixth connection electrode is connected with the second reference connection block 92-1 through the via.

In an exemplary implementation mode, an orthographic projection of the twenty-third via V23 on the base substrate is within a range of an orthographic projection of the first initial connection block 81-1 of the first initial signal line 81 on the base substrate, the fourth insulation layer within the twenty-third via V23 is etched off to expose a surface of the first initial connection block 81-1, and the twenty-third via V23 is configured such that a subsequently formed tenth connection electrode is connected with the first initial connection block 81-1 through the via.

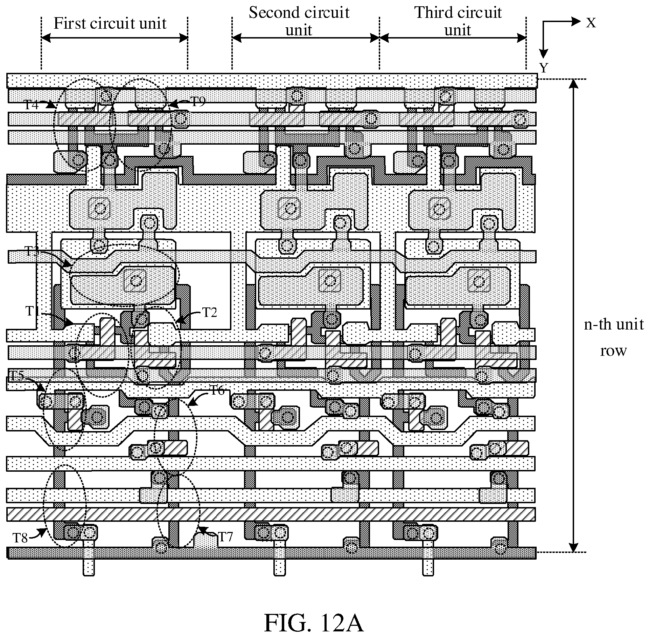

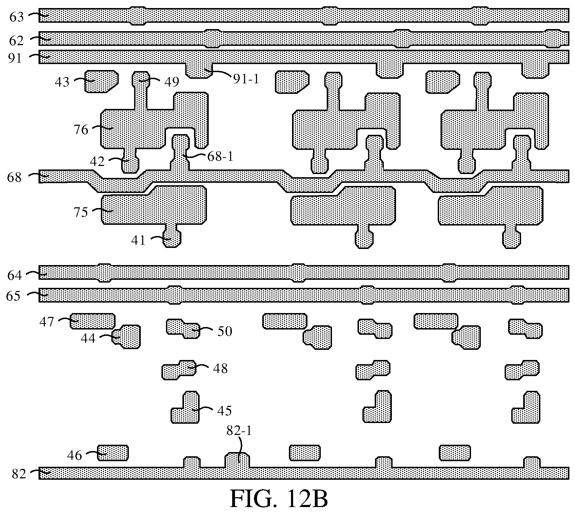

(15) A pattern of a third conductive layer is formed. In an exemplary implementation mode, forming the third conductive layer may include: a third conductive thin film is deposited on the base substrate on which the aforementioned patterns are formed, the third conductive thin film is patterned through a patterning process to form the third conductive layer disposed on the fourth insulation layer, as shown in FIG. 12A and FIG. 12B, and FIG. 12B is a schematic diagram of the third conductive layer in FIG. 12A. In an exemplary implementation mode, the third conductive layer may be referred to as a first source-drain metal (SD1) layer.

In an exemplary implementation mode, patterns of the third conductive layer of the plurality of circuit units in the display substrate may each include a first connection electrode 41, a second connection electrode 42, a third connection electrode 43, a fourth connection electrode 44, a fifth connection electrode 45, a sixth connection electrode 46, a seventh connection electrode 47, an eighth connection electrode 48, a ninth connection electrode 49, a tenth connection electrode 50, a second scan signal line 62, a third scan signal line 63, a fourth scan signal line 64, a fifth scan signal line 65, a first power supply connection line 68, a second initial signal line 82, a first reference signal line 91, a fifth electrode plate 75, and a sixth electrode plate 76.

In an exemplary implementation mode, the second scan signal line 62, the third scan signal line 63, the fourth scan signal line 64, the fifth scan signal line 65, the first power supply connection line 68, the second initial signal line 82, and the first reference signal line 91 may be in a shape of a line with a main body portion extending along the first direction X. The second scan signal line 62, the third scan signal line 63, and the first reference signal line 91 may be located at a side of the sixth electrode plate 76 in an opposite direction of the second direction Y, the fourth scan signal line 64, the fifth scan signal line 65, and the second initial signal line 82 may be located at a side of the fifth electrode plate 75 in the second direction Y, and the first power supply connection line 68 may be located between the fifth electrode plate 75 and the sixth electrode plate 76.

In an exemplary implementation mode, the first reference signal line 91 may be located at a side of the sixth electrode plate 76 in an opposite direction of the second direction Y, the second scan signal line 62 may be located at a side of the first reference signal line 91 in an opposite direction of the second direction Y, and the third scan signal line 63 may be located at a side of the second scan signal line 62 in an opposite direction of the second direction Y.

In an exemplary implementation mode, the fourth scan signal line 64 may be located at a side of the fifth electrode plate 75 in the second direction Y, the fifth scan signal line 65 may be located at a side of the fourth scan signal line 64 in the second direction Y, and the second initial signal line 82 may be located at a side of the fifth scan signal line 65 in the second direction Y.

In an exemplary implementation mode, the first power supply connection line 68 may be in a shape of a bending line with a main body portion extending along the first direction X, an orthographic projection of the first power supply connection line 68 on the base substrate is not overlapped with orthographic projections of the fifth electrode plate 75 and the sixth electrode plate 76 on the base substrate, the first power supply connection line 68 is configured to be connected with a first power supply line formed subsequently, to form a high-voltage power supply grid structure of a net-like communication structure on the display substrate.

In an exemplary implementation mode, the second scan signal line 62 is connected with the ninth gate electrode 29 in each circuit unit through the nineteenth via V19, thereby achieving that the second scan signal line 62 connects the ninth gate electrode 29 of the ninth transistor T9, and the second scan signal line 62 may control turn-on and turn-off of the ninth transistor T9.

In an exemplary implementation mode, the fifth scan signal line 65 is connected with the second gate electrode 22 in each circuit unit through the fifteenth via V15, thereby achieving that the fifth scan signal line 65 connects the second gate electrode 22 of the second transistor T2, and the fifth scan signal line 65 may control turn-on and turn-off of the second transistor T2.

In an exemplary implementation mode, the second scan signal line 62 and the fifth scan signal line 65 may extend to a bezel region and be connected with a same gate drive circuit to achieve output of a same scan signal.

In an exemplary implementation mode, the third scan signal line 63 is connected with the fourth gate electrode 24 in each circuit unit through the sixteenth via V16, thereby achieving that the third scan signal line 63 connects the fourth gate electrode 24 of the fourth transistor T4, and the third scan signal line 63 may control turn-on and turn-off of the fourth transistor T4.

In an exemplary implementation mode, the fourth scan signal line 64 is connected with the first gate electrode 21 in each circuit unit through the fourteenth via V14, thereby achieving that the fourth scan signal line 64 connects the first gate electrode 21 of the first transistor T1, and the fourth scan signal line 64 may control turn-on and turn-off of the first transistor T1.

In an exemplary implementation mode, the second initial signal line 82 is connected with the first region of the seventh active layer in each circuit unit through the seventh via V7, thereby achieving that the second initial signal line 82 connects the first electrode of the seventh transistor T7, and the second initial signal line 82 may write a second initial signal into the first electrode of the seventh transistor T7.

In an exemplary implementation mode, since the second active connection line 20 of the semiconductor layer is directly connected with first regions of seventh active layers of a plurality of circuit units in one unit row, and the second initial signal line 82 of the third conductive layer is connected with first regions of seventh active layers of a plurality of circuit units in one unit row through a via, the second active connection line 20 and the second initial signal line 82 constitute a signal line with a double-layer structure, which may not only ensure that the first regions of the plurality of seventh active layers in one unit row have a same potential, but also reduce a resistance of a signal line, reduce a voltage drop of a second initial signal, facilitate improvement of uniformity of the panel, avoid poor display of the display substrate, and ensure the display effect of the display substrate.

In an exemplary implementation mode, a second initial connection block 82-1 is provided at a side of the second initial signal line 82 close to the fifth scan signal line 65, a first end of the second initial connection block 82-1 is connected with the second initial signal line 82, and a second end of the second initial connection block 82-1 extends toward a direction of the fifth scan signal line 65. In an exemplary implementation mode, the second initial connection block 82-1 is configured to be connected with an initial connection line subsequently formed.

In an exemplary implementation mode, the first reference signal line 91 is connected with the first region of the ninth active layer in each circuit unit through the ninth via V9, thereby achieving that the first reference signal line 91 connects the first electrode of the ninth transistor T9, and the first reference signal line 91 may write a first reference signal into the first electrode of the ninth transistor T9.

In an exemplary implementation mode, since the first active connection line 10 of the semiconductor layer is directly connected with first regions of ninth active layers of a plurality of circuit units in one unit row, and the first reference signal line 91 of the third conductive layer is connected with first regions of ninth active layers of a plurality of circuit units in one unit row through a via, the first active connection line 10 and the first reference signal line 91 constitute a signal line with a double-layer structure, which may not only ensure that first regions of plurality of ninth active layers in a unit row have a same potential, but also reduce a resistance of a signal line, reduce a voltage drop of a first reference signal, facilitate improvement of the uniformity of the panel, avoid poor display of the display substrate, and ensure the display effect of the display substrate.

In an exemplary implementation mode, a reference connection block 91-1 is provided at a side of the first reference signal line 91 close to the first power supply connection line 68, a first end of the reference connection block 91-1 is connected with the first reference signal line 91 and a second end of the reference connection block 91-1 extends toward a direction of the first power supply connection line 68, and the reference connection block 91-1 is configured to be connected with the first region of the ninth active layer through the ninth via V9 on one hand, and is configured to be connected with a reference signal connection line formed subsequently on the other hand.

In an exemplary implementation mode, the first power supply connection line 68 is connected with the fourth electrode plate 74 in each circuit unit through the thirteenth via V13, thereby achieving that the first power supply connection line 68 connects the fourth electrode plate 74. Since the first power supply connection line 68 is connected with a first power supply line formed subsequently, the first power supply connection line 68 may write a first power supply signal into the intermediate electrode plate of the second storage capacitor.

In an exemplary implementation mode, a first power supply connection block 68-1 is provided at a side of the first power supply connection line 68 close to the sixth electrode plate 76, a first end of the first power supply connection block 68-1 is connected with the first power supply connection line 68, and a second end of the first power supply connection block 68-1 extends toward a direction of the sixth electrode plate 76. In an exemplary implementation mode, the first power supply connection block 68-1 is, on one hand, configured to be connected with the fourth electrode plate 74 through the thirteenth via V13, and, on the other hand, configured to be connected with a first power supply line subsequently formed.

In an exemplary implementation mode, the fifth electrode plate 75 of the first storage capacitor may be in a shape of a rectangle, corners of the rectangle may be provided with chamfers, and may be located between the fourth scan signal line 64 and the first power supply connection line 68 of the present circuit unit. An orthographic projection of the fifth electrode plate 75 on the base substrate is at least partially overlapped with an orthographic projection of the third electrode plate 73 on the base substrate, and the fifth electrode plate 75 is connected with the first electrode plate 71 through the tenth via V10. The fifth electrode plate 75 may serve as an upper electrode plate of the first storage capacitor, and the fifth electrode plate 75 and the third electrode plate 73 constitute the second sub-capacitor of the first storage capacitor of the pixel drive circuit.

In an exemplary implementation mode, the sixth electrode plate 76 of the second storage capacitor may have a shape similar to that of the fourth electrode plate 74, may be located between the first reference signal line 91 and the first power supply connection line 68 of the present circuit unit, an orthographic projection of the sixth electrode plate 76 on the base substrate is at least partially overlapped with an orthographic projection of the fourth electrode plate 74 on the base substrate, and the sixth electrode plate 76 is connected with the second electrode plate 72 through the eleventh via V11. The sixth electrode plate 76 may serve as an upper electrode plate of the second storage capacitor, and the sixth electrode plate 76 and the fourth electrode plate 74 constitute the fourth sub-capacitor of the second storage capacitor of the pixel drive circuit.

In an exemplary implementation mode, the first connection electrode 41 may be in a shape of a strip with a main body portion extending along the second direction Y, and may be provided at a side of the fifth electrode plate 75 close to the fourth scan signal line 64. A first end of the first connection electrode 41 is connected with the fifth electrode plate 75, and a second end of the first connection electrode 41, after extending toward a direction of the fourth scan signal line 64, is connected with the second region of the first active layer (also the first region of the second active layer) through the second via V2.

In an exemplary implementation mode, the fifth electrode plate 75 and the first connection electrode 41 may be of an interconnected integral structure.

In an exemplary implementation mode, the second connection electrode 42 may be in a shape of a strip with a main body portion extending along the second direction Y, and may be provided at a side of the sixth electrode plate 76 close to the first power supply connection line 68. A first end of the second connection electrode 42 is connected with the sixth electrode plate 76, and a second end of the second connection electrode 42, after extending toward a direction of the first power supply connection line 68, is connected with the third electrode plate 73 through the twelfth via V12.

In an exemplary implementation mode, the sixth electrode plate 76 and the second connection electrode 42 may be of an interconnected integral structure.

In an exemplary implementation mode, the third connection electrode 43 may be in a shape of a block (e.g., a rectangle), may be located between the first reference signal line 91 and the first power supply connection line 68, and the third connection electrode 43 is connected with the first region of the fourth active layer through the third via V3. In an exemplary implementation mode, the third connection electrode 43 may serve as the first electrode of the fourth transistor T4, and is configured to be connected with a data signal line formed subsequently.

In an exemplary implementation mode, the fourth connection electrode 44 may be in a shape of a block (e.g., a rectangle), may be located between the fifth scan signal line 65 and the second initial signal line 82, and the fourth connection electrode 44 is connected with the first region of the fifth active layer through the fifth via V5. In an exemplary implementation mode, the fourth connection electrode 44 may serve as the first electrode of the fifth transistor T5 and is configured to be connected with a first power supply line formed subsequently.

In an exemplary implementation mode, the fifth connection electrode 45 may be in a shape of an "L", may be located between the fifth scan signal line 65 and the second initial signal line 82, and the fifth connection electrode 45 is connected with the second region of the sixth active layer (also the second region of the seventh active layer) through the sixth via V6. In an exemplary implementation mode, the fifth connection electrode 45 may serve as the second electrode of the sixth transistor T6 and the second electrode of the seventh transistor T7, and be configured to be connected with an anode connection electrode formed subsequently.

In an exemplary implementation mode, the sixth connection electrode 46 may be in a shape of a strip with a main body portion extending along the first direction X, may be located between the fifth scan signal line 65 and the second initial signal line 82, a first end of the sixth connection electrode 46 is connected with the first region of the eighth active layer through the eighth via V8, and a second end of the sixth connection electrode 46 is connected with the second reference connection block 92-1 through the twenty-second via V22. In an exemplary implementation mode, the sixth connection electrode 46 may serve as the first electrode of the eighth transistor T8, and since the second reference connection block 92-1 is connected with the second reference signal line 92, it is achieved that the second reference signal line 92 connects the first electrode of the eighth transistor T8, and the second reference signal line 92 in the (n-1)-th unit row may write a second reference signal into the first electrode of the eighth transistor T8 in the (n-1)-th unit row.

In an exemplary implementation mode, the seventh connection electrode 47 may be in a shape of a strip with a main body portion extending along the first direction X, may be located between the fifth scan signal line 65 and the second initial signal line 82, a first end of the seventh connection electrode 47 is connected with the fifth gate electrode 25 through the seventeenth via V17, and a second end of the seventh connection electrode 47 is connected with the first light emitting connection block 31-1 through the twentieth via V20. Since the first light emitting connection block 31-1 is connected with the first light emitting signal line 31, it is achieved that the first light emitting signal line 31 connects the fifth gate electrode 25 of the fifth transistor T5, and the first light emitting signal line 31 may control turn-on and turn-off of the fifth transistor T5.

In an exemplary implementation mode, the eighth connection electrode 48 may be in a shape of a strip with a main body portion extending along the first direction X, may be located between the fifth scan signal line 65 and the second initial signal line 82, a first end of the eighth connection electrode 48 is connected with the sixth gate electrode 26 through the eighteenth via V18, and a second end of the eighth connection electrode 48 is connected with the second light emitting connection block 32-1 through the twenty-first via V21. Since the second light emitting connection block 32-1 is connected with the second light emitting signal line 32, it is achieved that the second light emitting signal line 32 connects the sixth gate electrode 26 of the sixth transistor T6, and the second light emitting signal line 32 may control turn-on and turn-off of the sixth transistor T6.

In an exemplary implementation mode, the ninth connection electrode 49 may be in a shape of a strip with a main body portion extending along the second direction Y, and may be provided at a side of the sixth electrode plate 76 close to the first reference signal line 91. A first end of the ninth connection electrode 49 is connected with the sixth electrode plate 76, and a second end of the ninth connection electrode 49, after extending toward a direction of the first reference signal line 91, is connected with the second region of the fourth active layer (also the second region of the ninth active layer) through the fourth via V4.

In an exemplary implementation mode, the sixth electrode plate 76 and the ninth connection electrode 49 may be of an interconnected integral structure, and the sixth electrode plate 76, the second connection electrode 42, and the ninth connection electrode 49 may be of an interconnected integral structure.

In an exemplary implementation mode, the tenth connection electrode 50 may be in a shape of a strip with a main body portion extending along the first direction X, and may be located between the fifth scan signal line 65 and the second initial signal line 82. A first end of the tenth connection electrode 50 is connected with the first region of the first active layer through the first via V1, and a second end of the tenth connection electrode 50 is connected with the first initial connection block 81-1 through the twenty-third via V23. Since the first initial connection block 81-1 is connected with the first initial signal line 81, it is achieved that the first initial signal line 81 connects the first electrode of the first transistor T1, and the first initial signal line 816 may write a first initial signal into the first electrode of the first transistor T1.

In an exemplary implementation mode, since the first connection electrode 41 is connected with the fifth electrode plate 75, the fifth electrode plate 75 is connected with the first electrode plate 71, and the first electrode plate 71 serves as the gate electrode of the third transistor T3, the first connection electrode 41 enables the second electrode of the first transistor T1, the first electrode of the second transistor T2, the gate electrode of the third transistor T3, and the first end of the first storage capacitor (including the first electrode plate 71 and the fifth electrode plate 75 of the first storage capacitor) to have a same potential, the first connection electrode 41 may serve as the first node N1 in the pixel drive circuit.

In an exemplary implementation mode, since the second connection electrode 42 and the ninth connection electrode 49 are connected with the sixth electrode plate 76, the sixth electrode plate 76 is connected with the second electrode plate 72, and the second connection electrode 42 is connected with the third electrode plate 73 of the first storage capacitor, the second connection electrode 42 and the ninth connection electrode 49 enable the second electrode of the fourth transistor T4, the second electrode of the ninth transistor T9, the second end of the first storage capacitor (i.e., the third electrode plate 73 of the first storage capacitor), and the second end of the second storage capacitor (including the second electrode plate 72 and the sixth electrode plate 76 of the second storage capacitor) to have a same potential, the second connection electrode 42 and the ninth connection electrode 49 may serve as the fifth node N5 in the pixel drive circuit.

In an exemplary implementation mode, since the fifth electrode plate 75 is connected with the second region of the first active layer (which is also the first region of the second active layer) through the first connection electrode 41, and the fifth electrode plate 75 is connected with the first electrode plate 71 through a via, both the first electrode plate 71 and the fifth electrode plate 75 have a potential of the first node N1. Since the third electrode plate 73 is connected with the sixth electrode plate 76 through the second connection electrode 42, and the sixth electrode plate 76 is connected with the second region of the fourth active layer (which is also the second region of the ninth active layer) through the ninth connection electrode 49, the third electrode plate 73 has a potential of the fifth node N5. In this way, the first electrode plate 71 having the potential of the first node N1 and the third electrode plate 73 having the potential of the fifth node N5 form the first sub-capacitor of the first storage capacitor of the pixel drive circuit, and the fifth electrode plate 75 having the potential of the first node N1 and the third electrode plate 73 having the potential of the fifth node N5 form the second sub-capacitor of the first storage capacitor of the pixel drive circuit, and the first sub-capacitor and the second sub-capacitor are in parallel. The present disclosure utilizes the first conductive layer, the second conductive layer, and the third conductive layer to form the first sub-capacitor and the second sub-capacitor of a parallel structure, and the first sub-capacitor and the second sub-capacitor of the parallel structure form a complete first storage capacitor, which, on one hand, may effectively increase a capacitance value of the first storage capacitor, and on the other hand, may reduce an area of an electrode plate under a condition of guaranteeing the capacitance value of the first storage capacitor, and effectively reduce an occupied area.

In an exemplary implementation mode, since the sixth electrode plate 76 is connected with the second region of the fourth active layer (which is also the second region of the ninth active layer) through the ninth connection electrode 49, and the sixth electrode plate 76 is connected with the second electrode plate 72 through a via, both the second electrode plate 72 and the sixth electrode plate 76 have the potential of the fifth node N5. Since the fourth electrode plate 74 is connected with the first power supply connection line 68, and the first power supply connection line 68 is connected with a first power supply line formed subsequently, the fourth electrode plate 74 has a potential of the first power supply line. In this way, the second electrode plate 72 having the potential of the fifth node N5 and the fourth electrode plate 74 having the potential of the first power supply line form the third sub-capacitor of the second storage capacitor of the pixel drive circuit, and the sixth electrode plate 76 having the potential of the fifth node N5 and the fourth electrode plate 74 having the potential of the first power supply line form the fourth sub-capacitor of the second storage capacitor of the pixel drive circuit, and the third sub-capacitor and the fourth sub-capacitor are in parallel. The present disclosure utilizes the first conductive layer, the second conductive layer, and the third conductive layer to form the third sub-capacitor and the fourth sub-capacitor of a parallel structure, and the third sub-capacitor and the fourth sub-capacitor of the parallel structure form a complete second storage capacitor, which, on one hand, may effectively increase a capacitance value of the second storage capacitor, and on the other hand, may reduce an area of an electrode plate under a condition of guaranteeing the capacitance value of the second storage capacitor, and effectively reduce an occupied area.

In an exemplary implementation mode, a capacitance value of a first storage capacitor in the first circuit unit, a capacitance value of a first storage capacitor in the second circuit unit, and a capacitance value of a first storage capacitor in the third circuit unit may be individually designed such that first storage capacitors of different circuit units have different capacitance values.

In an exemplary implementation mode, a capacitance value of a first storage capacitor of a circuit unit in a green sub-pixel may be smaller than a capacitance value of a first storage capacitor of a circuit unit in a red sub-pixel and a capacitance value of a first storage capacitor of a circuit unit in a blue sub-pixel.

In an exemplary implementation mode, an orthographic projection of the first electrode plate 71 on the base substrate, an orthographic projection of the third electrode plate 73 on the base substrate, and an orthographic projection of the fifth electrode plate 75 on the base substrate have a first overlapping region, and the capacitance value of the first storage capacitor is proportional to an area of the first overlapping region, so that the capacitance value of the first storage capacitor may be adjusted by adjusting the area of the first overlapping region.

In an exemplary implementation mode, a capacitance value of a second storage capacitor in the first circuit unit, a capacitance value of a second storage capacitor in the second circuit unit, and a capacitance value of a second storage capacitor in the third circuit unit may be individually designed such that second storage capacitors of different circuit units have different capacitance values.

In an exemplary implementation mode, a capacitance value of a second storage capacitor of a circuit unit in the green sub-pixel may be smaller than a capacitance value of a second storage capacitor of a circuit unit in the red sub-pixel and a capacitance value of a second storage capacitor of a circuit unit in the blue sub-pixel.

In an exemplary implementation mode, an orthographic projection of the second electrode plate 72 on the base substrate, an orthographic projection of the fourth electrode plate 74 on the base substrate, and an orthographic projection of the sixth electrode plate 76 on the base substrate have a second overlapping region, and the capacitance value of the second storage capacitor is proportional to an area of the second overlapping region, so that the capacitance value of the second storage capacitor may be adjusted by adjusting the area of the second overlapping region.

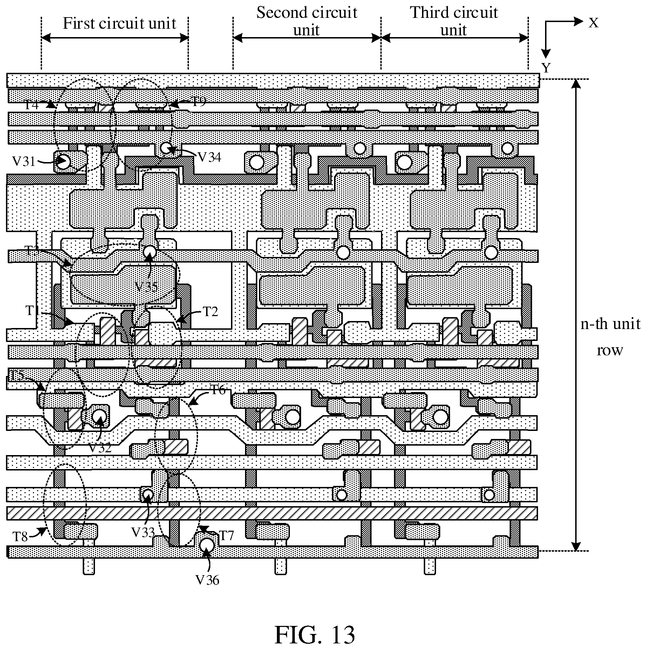

(16) A pattern of a fifth insulation layer is formed. In an exemplary implementation mode, forming the pattern of the fifth insulation layer may include: a fifth insulation thin film is deposited on the base substrate on which the aforementioned patterns are formed, the fifth insulation thin film is patterned through a patterning process to form a fifth insulation layer that covers the third conductive layer, wherein a plurality of vias are disposed in each circuit unit, as shown in FIG. 13.

In an exemplary implementation mode, the plurality of vias in each circuit unit in the display substrate include at least a thirty-first via V31, a thirty-second via V32, a thirty-third via V33, a thirty-fourth via V34, and a thirty-fifth via V35.

In an exemplary implementation mode, an orthographic projection of the thirty-first via V31 on the base substrate is within a range of an orthographic projection of the third connection electrode 43 on the base substrate, the fifth insulation layer within the thirty-first via V31 is removed to expose a surface of the third connection electrode 43, and the thirty-first via V31 is configured such that a data signal line formed subsequently is connected with the third connection electrode 43 through the via.

In an exemplary implementation mode, an orthographic projection of the thirty-second via V32 on the base substrate is within a range of an orthographic projection of the fourth connection electrode 44 on the base substrate, the fifth insulation layer within the thirty-second via V32 is removed to expose a surface of the fourth connection electrode 44, and the thirty-second via V32 is configured such that a first power supply line formed subsequently is connected with the fourth connection electrode 44 through the via.

In an exemplary implementation mode, an orthographic projection of the thirty-third via V33 on the base substrate is within a range of an orthographic projection of the fifth connection electrode 45 on the base substrate, the fifth insulation layer within the thirty-third via V33 is removed to expose a surface of the fifth connection electrode 45, and the thirty-third via V33 is configured such that an anode connection electrode formed subsequently is connected with the fifth connection electrode 45 through the via.

In an exemplary implementation mode, an orthographic projection of the thirty-fourth via V34 on the base substrate is within a range of an orthographic projection of the reference connection block 91-1 of the first reference signal line 91 on the base substrate, the fifth insulation layer within the thirty-fourth via V34 is removed to expose a surface of the reference connection block 91-1, and the thirty-fourth via V34 is configured such that a subsequently formed reference signal connection line is connected with the reference connection block 91-1 through the via.

In an exemplary implementation mode, an orthographic projection of the thirty-fifth via V35 on the base substrate is within a range of an orthographic projection of the first power supply connection block 68-1 of the first power supply connection line 68 on the base substrate, the fifth insulation layer within the thirty-fifth via V35 is removed to expose a surface of the first power supply connection block 68-1, and the thirty-fifth via V35 is configured such that a first power supply line formed subsequently is connected with the first power supply connection block 68-1 through the via.

In an exemplary implementation mode, in at least one circuit unit, a thirty-sixth via V36 may also be included. An orthographic projection of the thirty-sixth via V36 on the base substrate is within a range of an orthographic projection of the second initial connection block 82-1 of the second initial signal line 82 on the base substrate, the fifth insulation layer within the thirty-sixth via V36 is removed to expose a surface of the second initial connection block 82-1, and the thirty-sixth via V36 is configured such that a subsequently formed initial connection line is connected with the second initial connection block 82-1 through the via. In an exemplary implementation mode, the thirty-sixth via V36 may be located between the first circuit unit and the second circuit unit.

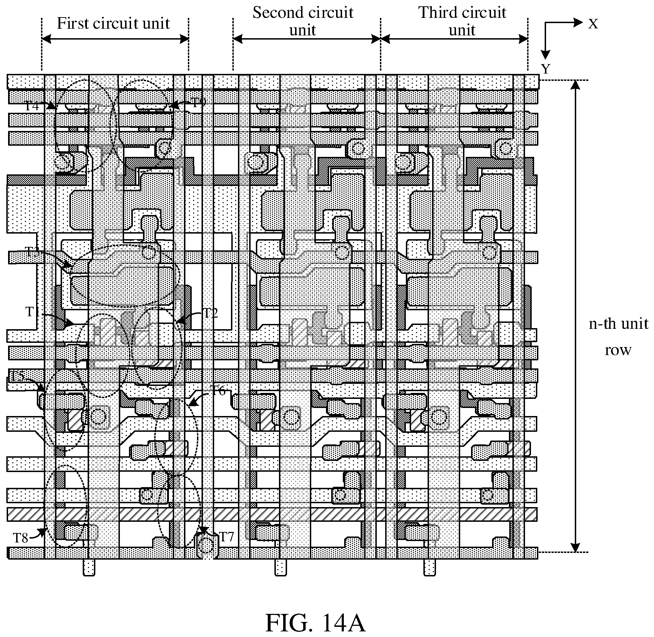

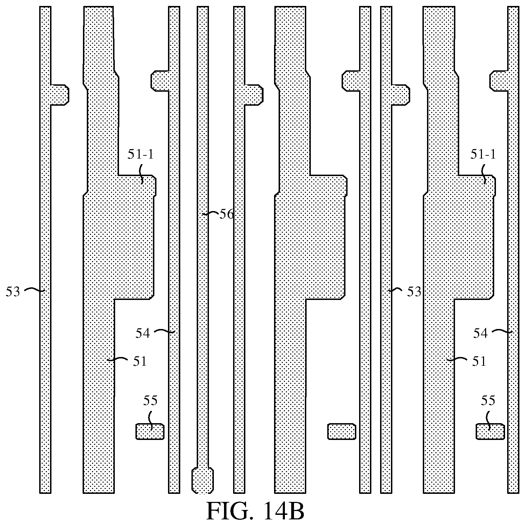

(17) A pattern of a fourth conductive layer is formed. In an exemplary implementation mode, forming the pattern of the fourth conductive layer may include: a fourth conductive thin film is deposited on the base substrate on which the aforementioned patterns are formed, the fourth conductive thin film is patterned through a patterning process to form the fourth conductive layer disposed on the fifth insulation layer, as shown in FIG. 14A and FIG. 14B, and FIG. 14B is a schematic diagram of the fourth conductive layer in FIG. 14A. In an exemplary implementation mode, the fourth conductive layer may be referred to as a second source-drain metal (SD2) layer.

In an exemplary implementation mode, patterns of the fourth conductive layer of the plurality of circuit units in the display substrate may each include a first power supply line 51, a data signal line 53, a reference signal connection line 54, and an anode connection electrode 55.

In an exemplary implementation mode, the first power supply line 51, the data signal line 53, and the reference signal connection line 54 may be in a shape of a strip with a main body portion extending along the second direction Y, the first power supply line 51 may be located at a side of the data signal line 53 in the first direction X, and the reference signal connection line 54 may be located at a side of the first power supply line 51 in the first direction X, that is, the first power supply line 51 may be located between the data signal line 53 and the reference signal connection line 54.

In an exemplary implementation mode, the first power supply line 51 may be in a shape of a bending line with a main body portion extending along the second direction Y, and the first power supply line 51 is connected with the fourth connection electrode 44 through the thirty-second via V32 on one hand, and connected with the first power supply connection block 68-1 through the thirty-fifth via V35 on the other hand. Since the fourth connection electrode 44 is connected with the first region of the fifth active layer through a via, it is achieved that the first power supply line 51 writes a first power supply signal into the first electrode of the fifth transistor T5. Since the first power supply connection block 68-1 is connected with the first power supply connection line 68, an interconnection of the first power supply connection line 68 with a main body portion extending along the first direction X and the first power supply line 51 with a main body portion extending along the second direction Y is thus achieved, so that the first power supply line 51 and the first power supply connection line 68 form a mesh-like mesh structure for transmitting the first power supply signal on the display substrate, which not only may effectively reduce a resistance of the first power supply line 51, reduce a voltage drop of the first power supply signal, but also may effectively improve uniformity of the first power supply signal in the display substrate, effectively improve uniformity of display, and improve display attribute and display quality.

In an exemplary implementation mode, a power supply shielding block 51-1 is provided at a side of the first power supply line 51 close to the reference signal connection line 54, a first end of the power supply shielding block 51-1 is connected with the first power supply line 51, and a second end of the power supply shielding block 51-1 extends toward a direction of the reference signal connection line 54. The power supply shielding block 51-1 may be in a shape of a block (e.g., a rectangle), and an orthographic projection of the power supply shielding block 51-1 on the base substrate is at least partially overlapped with an orthographic projection of the first connection electrode 41 on the base substrate. Since the first connection electrode 41 serves as the first node N1 in the pixel drive circuit, the power supply shielding block 51-1 with a constant voltage may effectively shield an influence of another signal in the pixel drive circuit on the first node N1, prevent the another signal (such as data voltage jump) from affecting a potential of the first node N1 of the pixel drive circuit, and improve the display effect.

In an exemplary implementation mode, the first power supply line 51 and the power supply shielding block 51-1 may be of an interconnected integral structure.

In an exemplary implementation mode, an orthographic projection of the power supply shielding block 51-1 on the base substrate may contain an orthographic projection of the first connection electrode 41 on the base substrate.

In an exemplary implementation mode, an orthographic projection of the first power supply line 51 on the base substrate is at least partially overlapped with orthographic projections of the second connection electrode 42 and the ninth connection electrode 49 on the base substrate. Since the second connection electrode 42 and the ninth connection electrode 49 serves as the fifth node N5 in the pixel drive circuit, the first power supply line 51 with a constant voltage may effectively shield an influence of another signal in the pixel drive circuit on the fifth node N5, prevent the another signal from affecting a potential of the fifth node N5 of the pixel drive circuit, and improve the display effect.

In an exemplary implementation mode, the first power supply line 51 may be designed with unequal widths, and the first power supply line 51 designed with the unequal widths may not only facilitate a layout of a pixel structure, but also reduce a parasitic capacitance between the first power supply line and a data signal line.

In an exemplary implementation mode, the data signal line 53 may be in a shape of a straight line with a main body portion extending along the second direction Y, and the data signal line 53 is connected with the third connection electrode 43 through the thirty-first via V31. Since the third connection electrode 43 is connected with the first region of the fourth active layer through a via, it is achieved that the data signal line 53 writes a data signal into the first electrode of the fourth transistor T4.

In an exemplary implementation mode, the reference signal connection line 54 may be in a shape of a straight line with a main body portion extending along the second direction Y, and the reference signal connection line 54 is connected with the reference connection block 91-1 through the thirty-fourth via V34. Since the reference connection block 91-1 is connected with the first reference signal line 91, an interconnection of the first reference signal line 91 with a main body portion extending along the first direction X and the reference signal connection line 54 with a main body portion extending along the second direction Y is thus achieved, so that the first reference signal line 91 and the reference signal connection line 54 form a mesh-like mesh structure for transmitting a first reference signal on the display substrate, which not only may effectively reduce a resistance of the first reference signal line and reduce a voltage drop of the first reference signal, but also may effectively improve uniformity of the first reference signal in the display substrate, effectively improve uniformity of display, and improve display attribute and display quality.

In an exemplary implementation mode, the anode connection electrode 55 may be in a shape of a block (e.g., a rectangle), and the anode connection electrode 55 is connected with the fifth connection electrode 45 through the thirty-third via V33. Since the fifth connection electrode 45 is connected with the second region of the sixth active layer (also the second region of the seventh active layer) through a via, it is achieved that the anode connection electrode 55 is connected with the second electrode of the sixth transistor T6 and the second electrode of the seventh transistor T7. In an exemplary implementation mode, the anode connection electrode 55 is configured to be connected with an anode formed subsequently, thereby it may be achieved that the pixel drive circuit drives a light emitting device.

In an exemplary implementation mode, an initial connection line 56 may also be included in the at least one circuit unit. The initial connection line 56 may be in a shape of a straight line with a main body portion extending along the second direction Y, and the initial connection line 56 is connected with the second initial connection block 82-1 through the thirty-sixth via V36. Since the second initial connection block 82-1 is connected with the second initial signal line 82, an interconnection of the second initial signal line 82 with a main body portion extending along the first direction X and the initial connection line 56 with a main body portion extending along the second direction Y is thus achieved, so that the second initial signal line 82 and the initial connection line 56 form a mesh-like mesh structure for transmitting a second initial signal on the display substrate, which not only may effectively reduce a resistance of the second initial signal line and reduce a voltage drop of the second initial signal, but also may effectively improve uniformity of the second initial signal in the display substrate, effectively improve uniformity of display, and improve display attribute and display quality. In an exemplary implementation mode, the initial connection line 56 may be located between the reference signal connection line 54 of the first circuit unit and the data signal line 53 of the second circuit unit.

In an exemplary implementation mode, the first power supply connection line 68 of the third conductive layer may be provided in each unit row, the first power supply line 51 of the fourth conductive layer may be provided in each unit column, and a plurality of first power supply connection lines 51 are respectively connected with a plurality of first power supply connection lines 68 to form a mesh structure for transmitting a first power supply signal.

In an exemplary implementation mode, the first reference signal line 91 of the third conductive layer may be provided in each unit row, the reference signal connection line 54 of the fourth conductive layer may be provided in each unit column, and a plurality of first reference signal lines 91 are connected with a plurality of reference signal connection lines 54 respectively to form a mesh structure for transmitting a first reference signal.

In an exemplary implementation mode, the second initial signal line 82 of the third conductive layer may be provided in each unit row, the initial connection line 56 of the fourth conductive layer may be provided every two unit columns, and a plurality of initial connection lines 56 are connected with a plurality of second initial signal lines 82 respectively to form a mesh structure for transmitting a second initial signal.

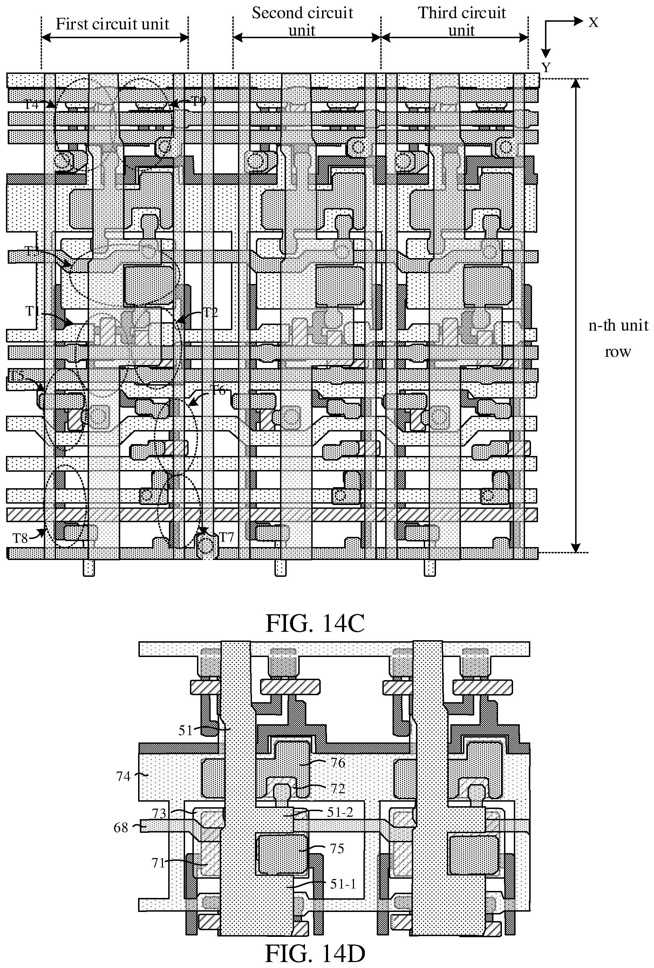

FIG. 14C is a schematic diagram of a display substrate after a pattern of another fourth conductive layer is formed according to the present disclosure, and FIG. 14D is a schematic diagram of a structure of a first storage capacitor and a second storage capacitor in FIG. 14C. As shown in FIGs. 14C and 14D, in forming the pattern of the third conductive layer, a size of the fifth electrode plate 75 in the first direction X is relatively small, and the fifth electrode plate 75 is located at a side close to the reference signal connection line 54 of the present circuit unit. In forming the pattern of the fourth conductive layer, the first power supply line 51 of the at least one circuit unit is further connected with the power supply shielding block 51-1 and a third power supply connection block 51-2, an orthographic projection of the power supply shielding block 51-1 on the base substrate is at least partially overlapped with an orthographic projection of the first connection electrode 41 on the base substrate, and the third power supply connection block 51-2 is connected with the first power supply connection block 68-1 through the thirty-fifth via, so that an orthographic projection of the fifth electrode plate 75 on the base substrate is not overlapped with an orthographic projection of the first power supply line 51 on the base substrate.

In an exemplary implementation mode, an orthographic projection of the fifth electrode plate 75 on the base substrate is not overlapped with an orthographic projection of the first reference signal line 91 on the base substrate, the orthographic projection of the fifth electrode plate 75 on the base substrate is not overlapped with an orthographic projection of the reference signal connection line 54 on the base substrate, and the orthographic projection of the fifth electrode plate 75 on the base substrate is not overlapped with an orthographic projection of the first power supply line 51 on the base substrate. Since the fifth electrode plate 75 has a potential of the first node N1, setting the first reference signal line 91 not overlapped with the fifth electrode plate 75, the reference signal connection line 54 not overlapped with the fifth electrode plate 75, and the first power supply line 51 not overlapped with the fifth electrode plate 75 may reduce a parasitic capacitance of the first node N1, which may effectively avoid signal crosstalk, and ensure stability of the potential of the first node N1.

In an exemplary implementation mode, an orthographic projection of the sixth electrode plate 76 on the base substrate is not overlapped with an orthographic projection of the first reference signal line 91 on the base substrate, and the orthographic projection of the sixth electrode plate 76 on the base substrate is not overlapped with an orthographic projection of the reference signal connection line 54 on the base substrate. Since the reference signal connection line 54 of one circuit unit is adjacent to the data signal line 53 of another circuit unit adjacent in the first direction X, a signal jump on the data signal line 53 will affect a potential of the reference signal connection line 54. Since the sixth electrode plate 76 has a potential of the fifth node N5, setting the first reference signal line 91 not overlapped with the sixth electrode plate 76 and the reference signal connection line 54 not overlapped with the sixth electrode plate 76 may reduce a parasitic capacitance of the fifth node N5, , which may effectively avoid signal crosstalk, and ensure stability of the potential of the first node N5.

A subsequent preparation process may include forming a pattern of a first planarization layer, the first planarization layer is provided with a plurality of anode vias, an orthographic projection of an anode via on the base substrate is within a range of an orthographic projection of an anode connection electrode on the base substrate, the first planarization layer within the anode via is removed to a surface of the anode connection electrode, the anode via is configured such that a subsequently formed anode is connected with the anode connection electrode through the via.

So far, a drive circuit layer has been prepared on the base substrate. In an exemplary implementation mode, after preparation of the drive circuit layer is completed, a light emitting structure layer and an encapsulation structure layer may be sequentially prepared on the drive circuit layer, which will not be repeated herein.

In an exemplary implementation mode, in a plane parallel to the display substrate, the drive circuit layer may include a plurality of circuit units, each circuit unit may include a pixel drive circuit, and a first scan signal line, a second scan signal line, a third scan signal line, a fourth scan signal line, a fifth scan signal line, a first light emitting signal line, a second light emitting signal line, a first initial signal line, a second initial signal line, a first reference signal line, a second reference signal line, a first power supply line, and a data signal line connected with the pixel drive circuit. In a plane perpendicular to the display substrate, the drive circuit layer may include at least a first insulation layer, a semiconductor layer, a second insulation layer, a first conductive layer, a third insulation layer, a second conductive layer, a fourth insulation layer, a third conductive layer, a fifth insulation layer, and a fourth conductive layer that are sequentially stacked on the base substrate.

In the present embodiment, the first active connection line 10, the second active connection line 20, and the first active layer 11 to the ninth active layer 19 may be disposed in the semiconductor layer, the first gate electrode 21, the second gate electrode 22, the fourth gate electrode 24, the fifth gate electrode 25, the sixth gate electrode 26, the ninth gate electrode 29, the first scan signal line 61, the first electrode plate 71, and the second electrode plate 72 may be disposed in the first conductive layer, the first light emitting signal line 31, the second light emitting signal line 32, the repair line 33, the first shielding electrode 34, the second shielding electrode 35, the third shielding electrode 36, the fourth shielding electrode 37, the third electrode plate 73, the fourth electrode plate 74, the first initial signal line 81, and the second reference signal line 92 may be disposed in the second conductive layer, the first connection electrode 41 to the tenth connection electrode 50, the second scan signal line 62, the third scan signal line 63, the fourth scan signal line 64, the fifth scan signal line 65, the first power supply connection line 68, the second initial signal line 82, the first reference signal line 91, the fifth electrode plate 75, and the sixth electrode plate 76 may be disposed in the third conductive layer, and the first power supply line 51, the data signal line 53, the reference signal connection line 54, the anode connection electrode 55, and the initial connection line 56 may be provided in the fourth conductive layer.

As may be seen from the structure and the preparation process of the display substrate of the present embodiment described above, by using the first conductive layer, the second conductive layer, and the third conductive layer to form a sandwich structure with a three-layer metal layout, using the first sub-capacitor and the second sub-capacitor of a parallel structure to form the first storage capacitor, and using the third sub-capacitor and the fourth sub-capacitor of a parallel structure to form the second storage capacitor, the embodiment of the present disclosure, on one hand, may effectively increase a capacitance value of a storage capacitor, and on the other hand, may reduce an area of an electrode plate under a condition of guaranteeing the capacitance value of the storage capacitor, and effectively reduce an occupied area.

In an embodiment of the present disclosure, a first power supply connection line with a main body portion extending along the first direction X and a first power supply line with a main body portion extending along the second direction Y are provided, and the first power supply line and the first power supply connection line are connected with each other, so that the first power supply line and the first power supply connection line form a mesh-like mesh structure for transmitting a first power supply signal on the display substrate, which may not only effectively reduce a resistance of the first power supply line, reduce a voltage drop of the first power supply signal, but also effectively improve uniformity of the first power supply signal in the display substrate, effectively improve uniformity of display, and improve display attribute and display quality.

In an embodiment of the present disclosure, a first reference signal line with a main body portion extending along the first direction X and a reference signal connection line with a main body portion extending along the second direction Y are provided, and the first reference signal line and the reference signal connection line are connected with each other, so that the first reference signal line and the reference signal connection line form a mesh-like mesh structure for transmitting a first reference signal on the display substrate, which may not only effectively reduce a resistance of the first reference signal line, reduce a voltage drop of the first reference signal, but also effectively improve uniformity of the first reference signal in the display substrate, effectively improve uniformity of display, and improve display attribute and display quality.

In an embodiment of the present disclosure, a second initial signal line with a main body portion extending along the first direction X and an initial connection line with a main body portion extending along the second direction Y are provided, and the second initial signal line and the initial connection line are connected with each other, so that the second initial signal line and the initial connection line form a mesh-like mesh structure for transmitting a second initial signal on the display substrate, which may not only effectively reduce a resistance of the second initial signal line, reduce a voltage drop of the second initial signal, but also effectively improve uniformity of the second initial signal in the display substrate, effectively improve uniformity of display, and improve display attribute and display quality.

In an embodiment of the present disclosure, a first active connection line of the semiconductor layer and a first reference signal line of the third conductive layer are provided to constitute a signal line with a double-layer structure, and a second active connection line of the semiconductor layer and a second initial signal line of the third conductive layer are provided to constitute a signal line with a double-layer structure, which may effectively reduce voltage drops of a reference signal and an initial signal, be conducive to improving uniformity of a panel, avoid poor display of the display substrate, and ensure a display effect of the display substrate.

By providing the first shielding electrode, the second shielding electrode, the third shielding electrode, and the fourth shielding electrode, the embodiment of the present disclosure may shield an influence of a data voltage jump on the first transistor T1, the second transistor T2, the fourth transistor T4, the ninth transistor T9, and a key node, prevent the data voltage jump from affecting a normal operation of the pixel drive circuit, and improve a display effect.

By providing the first power supply line and the power supply shielding block to shield the first node N1 and the fifth node N5 of the pixel drive circuit, the embodiment of the present disclosure effectively avoids another signal from affecting potentials of the first node N1 and the fifth node N5 of the pixel drive circuit, and improves a display effect.

The preparation process in the present disclosure may be compatible well with an existing preparation process, is simple in process implementation, is easy to implement, and has a high production efficiency, a low production cost, and a high yield.

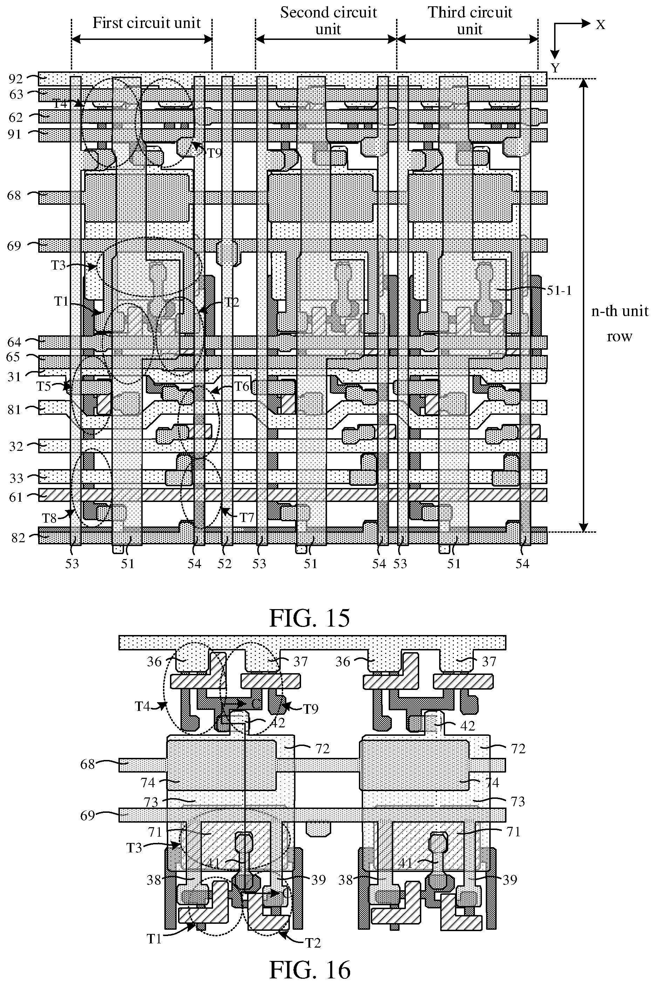

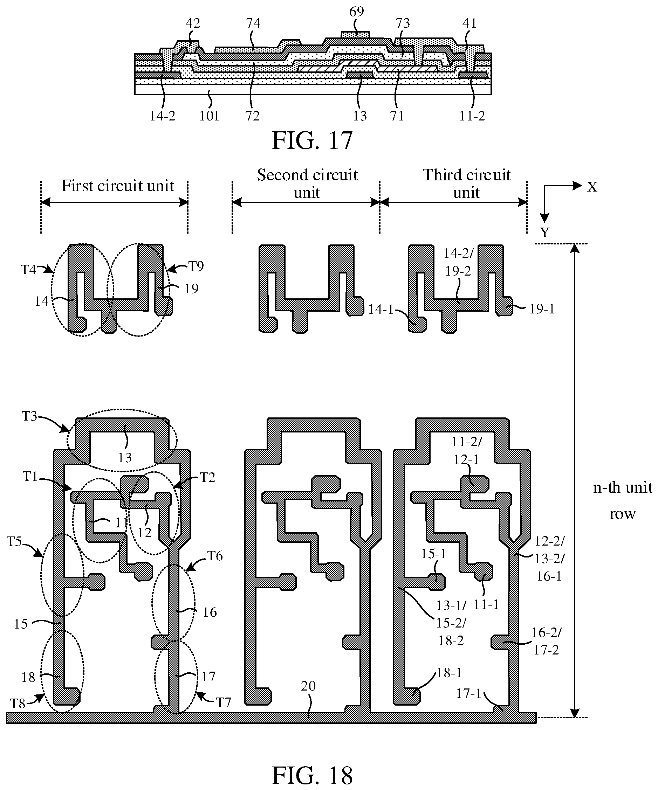

FIG. 15 is a schematic diagram of a planar structure of another display substrate according to an exemplary embodiment of the present disclosure, illustrating a structure of a pixel drive circuit in three circuit units (a first circuit unit, a second circuit unit, and a third circuit unit) in the display substrate, FIG. 16 is a schematic diagram of a structure of a first storage capacitor and a second storage capacitor in FIG. 15, and FIG. 17 is a sectional view taken along a C-C direction in FIG. 16. As shown in FIGs. 15, 16, and 17, a main body structure of the pixel drive circuit according to the present exemplary embodiment is substantially the same as that of the foregoing embodiment, except that the first storage capacitor and the second storage capacitor of the present embodiment are of a stacked structure, and the second storage capacitor is provided at a side of the first storage capacitor away from the base substrate.

In an exemplary implementation mode, the first storage capacitor may include a first electrode plate 71 and a third electrode plate 73 as a first capacitor electrode plate, an orthographic projection of the third electrode plate 73 on the base substrate is at least partially overlapped with an orthographic projection of the first electrode plate 71 on the base substrate, and the first electrode plate 71 and the third electrode plate 73 forms the first storage capacitor. The second storage capacitor may include a second electrode plate 72 and a fourth electrode plate 74 as a second capacitor electrode plate, an orthographic projection of the fourth electrode plate 74 on the base substrate is at least partially overlapped with an orthographic projection of the second electrode plate 72 on the base substrate, and the second electrode plate 72 and the fourth electrode plate 74 forms the second storage capacitor.

In an exemplary implementation mode, on a plane perpendicular to the display substrate, the drive circuit layer may include a semiconductor layer, a first conductive layer, a second conductive layer, a third conductive layer, and a fourth conductive layer sequentially disposed on the base substrate. The first electrode plate 71 may be provided in the first conductive layer, the second electrode plate 72 and the third electrode plate 73 may be provided in the second conductive layer, the fourth electrode plate 74 may be provided in the third conductive layer, and the second electrode plate 72 and the third electrode plate 73 may be of an interconnected integral structure.

In an exemplary implementation mode, the first electrode plate 71 serves as a gate electrode of the third transistor T3 and is connected with the second region 11-2 of the first active layer in the first transistor T1 through a first connection electrode 41. The second electrode plate 72 is connected with the third electrode plate 73 on one hand, and connected with the second region 14-2 of the fourth active layer in the fourth transistor T4 through a second connection electrode 42 on the other hand. The fourth electrode plate 74 is connected with a first power supply connection line 68, so that the first electrode plate 71 may serve as a first end of the first storage capacitor, the third electrode plate 73 may serve as a second end of the first storage capacitor, the fourth electrode plate 74 may serve as a first end of the second storage capacitor, and the second electrode plate 72 may serve as a second end of the second storage capacitor.

In an exemplary implementation mode, a first end of the first connection electrode 41 is connected with the first electrode plate 71 through a via, and a second end of the first connection electrode 41 is connected with the second region 11-2 of the first active layer in the first transistor T1 (also the first region of the second active layer in the second transistor T2) through a via, and the first connection electrode 41 may serve as a first node of the pixel drive circuit.

In an exemplary implementation mode, a first end of the second connection electrode 42 is connected with the second electrode plate 72, a second end of the second connection electrode 42 is connected with the second region 14-2 of the fourth active layer in the fourth transistor T4 (also the second region of the ninth active layer in the ninth transistor T9) through a via, and the second connection electrode 42 may serve as a fifth node N5 in the pixel drive circuit.

In an exemplary implementation mode, the at least one circuit unit may further include a third shielding electrode 36 and a fourth shielding electrode 37, positions, structures, and connection relationships of the third shielding electrode 36 and the fourth shielding electrode 37 are substantially the same as those of the foregoing embodiment.

In an exemplary implementation mode, the at least one circuit unit may further include a fifth shielding electrode 38 connected with a second power supply connection line 69, an orthographic projection of the fifth shielding electrode 38 on the base substrate is at least partially overlapped with an orthographic projection of the semiconductor layer between two gate electrodes of the first transistor T1 on the base substrate. In an exemplary implementation mode, the fifth shielding electrode 38 is configured to shield an influence of a data voltage jump on the first transistor T1, prevent the data voltage jump from affecting a normal operation of the pixel drive circuit, and improve a display effect.

In an exemplary implementation mode, the at least one circuit unit may further include a sixth shielding electrode 39 connected with the second power supply connection line 69, an orthographic projection of the sixth shielding electrode 39 on the base substrate is at least partially overlapped with an orthographic projection of the semiconductor layer between two gate electrodes of the second transistor T2 on the base substrate. In an exemplary implementation mode, the sixth shielding electrode 39 is configured to shield an influence of a data voltage jump on the second transistor T2, prevent the data voltage jump from affecting the normal operation of the pixel drive circuit, and improve the display effect.

In an exemplary implementation mode, the fifth shielding electrode 38, the sixth shielding electrode 39, and the second power supply connection line 69 may be of an interconnected integral structure.

In an exemplary implementation mode, the drive circuit layer may further include at least one first power supply connection line 68 extending along the first direction X and at least one first power supply line 51 extending along the second direction Y, the first power supply line 51 and the first power supply connection line 68 are interconnected to form a mesh structure for transmitting a first power supply signal.

In an exemplary implementation mode, the drive circuit layer may further include at least one second power supply connection line 69 extending along the first direction X and at least one second power supply line 52 extending along the second direction Y, the second power supply line 52 is connected with cathodes in a plurality of light emitting units, the second power supply line 52 is configured to continuously provide a low-level signal to the cathodes, and the second power supply connection line 69 extending along the first direction X is interconnected with the second power supply line 52 extending along the second direction Y to form a mesh structure for transmitting a second power supply signal.

In an exemplary implementation mode, the drive circuit layer may further include at least one first reference signal line 91 extending along the first direction X and at least one reference signal connection line 54 extending along the second direction Y, the first reference signal line 91 and the reference signal connection line 54 are connected with each other to form a mesh structure for transmitting a first reference signal.

The first power supply line 51 and the first power supply connection line 68 may be provided in different conductive layers, and the first power supply line 51 and the first power supply connection line 68 may be connected through a via. The second power supply line 52 and the second power supply connection line 69 may be provided in different conductive layers, and the second power supply line 52 and the second power supply connection line 69 may be connected through a via. The first reference signal line 91 and the reference signal connection line 54 may be disposed in different conductive layers, and the first reference signal line 91 and the reference signal connection line 54 may be connected through a via.

In an exemplary implementation mode, the first power supply connection line 68, the second power supply connection line 69, and the first reference signal line 91 may be provided in a same layer, i.e., the third conductive layer, and synchronously formed through a same patterning process, and the first power supply line 51, the second power supply line 52, and the reference signal connection line 54 may be provided in a same layer, i.e., the fourth conductive layer, and synchronously formed through a same patterning process.

In an exemplary implementation mode, the at least one circuit unit may further include a power supply shielding block 51-1 connected with the first power supply line 51, and an orthographic projection of the power supply shielding block 51-1 on the base substrate is at least partially overlapped with an orthographic projection of the first connection electrode 41 on the base substrate to shield an influence of another signal in the pixel drive circuit on the first node.

In an exemplary implementation mode, an orthographic projection of the first power supply line 51 on the base substrate is at least partially overlapped with an orthographic projection of the second connection electrode 42 on the base substrate to shield an influence of another signal in the pixel drive circuit on the fifth node.

In an exemplary implementation mode, taking three circuit units (a first circuit unit, a second circuit unit, and a third circuit unit) in an n-th unit row as an example, a preparation process of the display substrate according to the present embodiment may include following operations.

(21) A pattern of a semiconductor layer is formed. In an exemplary implementation mode, forming the pattern of the semiconductor layer may include: a first insulation thin film and a semiconductor thin film are deposited sequentially on a base substrate, and the semiconductor thin film is patterned through a patterning process to form a first insulation layer that covers the base substrate and the semiconductor layer disposed on the first insulation layer, as shown in FIG. 18.

In an exemplary implementation mode, the semiconductor layer of each circuit unit in the display substrate may include at least a second active connection line 20 and a first active layer 11 of the first transistor T1 to a ninth active layer 19 of the ninth transistor T9, and positions, structures, and connection relationships of the first active layer 11 to the ninth active layer 19, the second active connection line 20, and the first active layer 11 to the ninth transistor T9 are substantially the same as those of the foregoing embodiment.

In an exemplary implementation mode, the semiconductor layer of the present embodiment is not formed with a first active connection line, that is, first regions of ninth active layers of circuit units adjacent in the first direction X are not connected with each other.

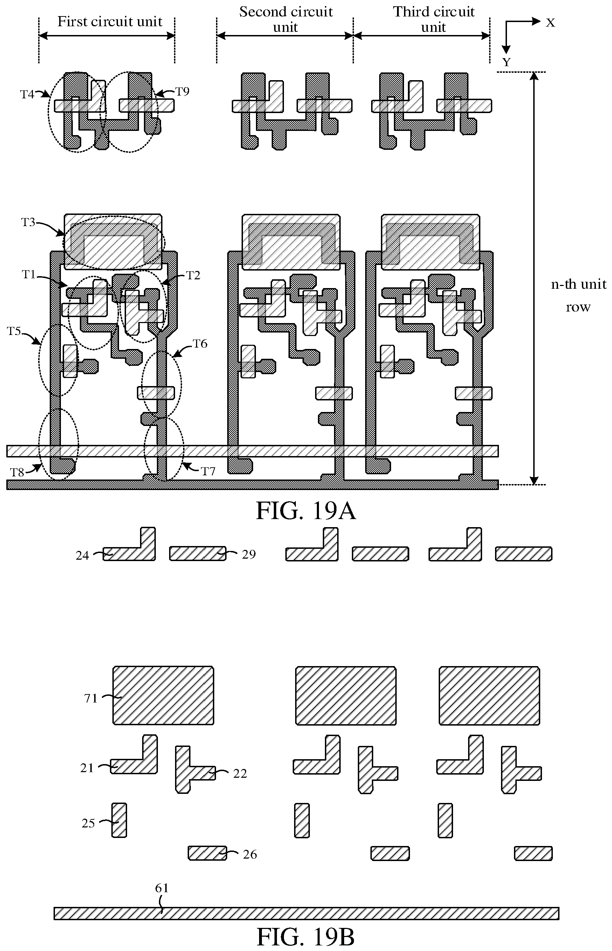

(22) A pattern of a first conductive layer is formed. In an exemplary implementation mode, forming the pattern of the first conductive layer may include: a second insulation thin film and a first conductive thin film are sequentially deposited on the base substrate on which the aforementioned pattern is formed, and the first conductive thin film is patterned through a patterning process to form a second insulation layer that covers the pattern of the semiconductor layer and a pattern of a first conductive layer disposed on the second insulation layer, as shown in FIG. 19A and FIG. 19B, and FIG. 19B is a schematic diagram of the first conductive layer in FIG. 19A.

In an exemplary implementation mode, the pattern of the first conductive layer of each circuit unit in the display substrate includes at least a first gate electrode 21, a second gate electrode 22, a fourth gate electrode 24, a fifth gate electrode 25, a sixth gate electrode 26, a ninth gate electrode 29, a first scan signal line 61, and a first electrode plate 71 of the first storage capacitor.

In an exemplary implementation mode, positions, structures, and connection relationships of the first gate electrode 21, the second gate electrode 22, the fourth gate electrode 24, the fifth gate electrode 25, the sixth gate electrode 26, the ninth gate electrode 29, the first scan signal line 61, and the first electrode plate 71 are substantially the same as those of the foregoing embodiment.

In an exemplary implementation mode, the first conductive layer of the present embodiment is not formed with a second electrode plate of the second storage capacitor.

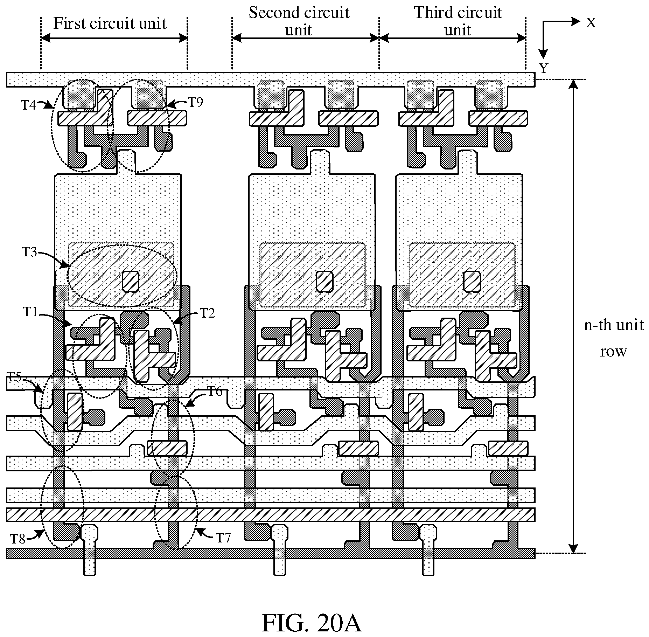

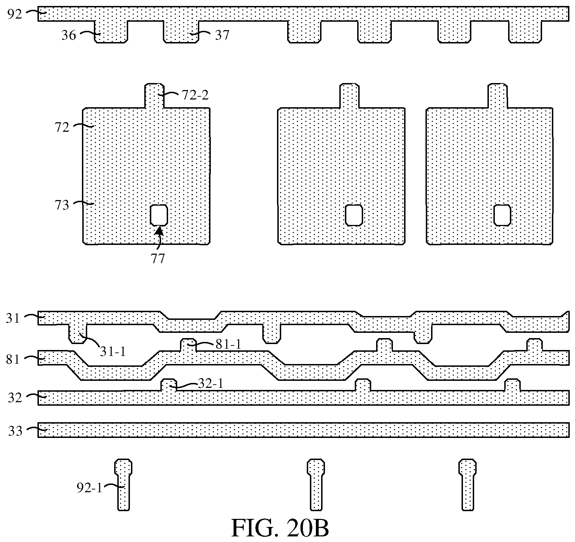

(23) A pattern of a second conductive layer is formed. In an exemplary implementation mode, forming the pattern of the second conductive layer may include: a third insulation thin film and a second conductive thin film are sequentially deposited on the base substrate on which the aforementioned patterns are formed, and the second conductive thin film is patterned through a patterning process to form a third insulation layer that covers the first conductive layer and the pattern of the second conductive layer disposed on the third insulation layer, as shown in FIG. 20A and FIG. 20B, and FIG. 20B is a schematic diagram of the second conductive layer in FIG. 20A.

In an exemplary implementation mode, the pattern of the second conductive layer of each circuit unit in the display substrate includes at least a first light emitting signal line 31, a second light emitting signal line 32, a repair line 33, a third shielding electrode 36, a fourth shielding electrode 37, a third electrode plate 73 of the first storage capacitor, a second electrode plate 72 of the second storage capacitor, a first initial signal line 81, and a second reference signal line 92.

In an exemplary implementation mode, positions, structures, and connection relationships of the first light emitting signal line 31, the second light emitting signal line 32, the repair line 33, the third shielding electrode 36, the fourth shielding electrode 37, the first initial signal line 81, and the second reference signal line 92 are substantially the same as those of the foregoing embodiment.

In an exemplary implementation mode, the third electrode plate 73 of the first storage capacitor has a contour which may be in a shape of a rectangle, corners of the rectangle may be provided with chamfers, and the third electrode plate 73 may be located between the first light emitting signal line 31 and the second reference signal line 92 of the present circuit unit, an orthographic projection of the third electrode plate 73 on the base substrate is at least partially overlapped with an orthographic projection of the first electrode plate 71 on the base substrate, the third electrode plate 73 may serve as an upper electrode plate of the first storage capacitor, and the first electrode plate 71 and the third electrode plate 73 form the first storage capacitor of the pixel drive circuit.

In an exemplary implementation mode, the third electrode plate 73 of each circuit unit is provided with a first opening 77, the first opening 77 may be located in a partial region of the third electrode plate 73, the first opening 77 may be rectangular or circular, etc., so that the third electrode plate 73 forms an annular structure. The first opening 77 exposes the third insulation layer covering the first electrode plate 71, and an orthographic projection of the first electrode plate 71 on the base substrate contains an orthographic projection of the first opening 77 on the base substrate. In an exemplary implementation mode, the first opening 77 is configured to accommodate a subsequently formed tenth via, the tenth via is located within the first opening 77 and exposes the first electrode plate 71, so that a subsequently formed first connection electrode is connected with the first electrode plate 71.

In an exemplary implementation mode, the second electrode plate 72 of the second storage capacitor may be in a shape of a rectangle, corners of the rectangle may be provided with chamfers, and the second electrode plate 72 may be located between the third electrode plate 73 of the present circuit unit and the second reference signal line 92, and the second electrode plate 72 may serve as a lower electrode plate of the second storage capacitor.

In an exemplary implementation mode, an electrode plate connection block 72-2 is provided at a side of the second electrode plate 72 close to the second reference signal line 92, the electrode plate connection block 72-2 may be in a shape of an "I", and the electrode plate connection block 72-2 may be provided in each circuit unit. In an exemplary implementation mode, a first end of the electrode plate connection block 72-2 is connected with the second electrode plate 72, a second end of the electrode plate connection block 72-2 extends toward the second reference signal line 92, and the electrode plate connection block 72-2 is configured to be connected with the second region of the fourth active layer (also the second region of the ninth active layer) through a second connection electrode subsequently formed.

In an exemplary implementation mode, the second electrode plate 72 and the electrode plate connection block 72-2 may be of an interconnected integral structure.

In an exemplary implementation mode, the second electrode plate 72 and the third electrode plate 73 may be of an interconnected integral structure, i.e., the third electrode plate 73 of the first storage capacitor and the second electrode plate 72 of the second storage capacitor share a same electrode plate.

In an exemplary implementation mode, the second conductive layer of the present embodiment is not formed with a first shielding electrode and a second shielding electrode, and an area of the third electrode plate 73 of the present embodiment is increased compared with the foregoing embodiment.

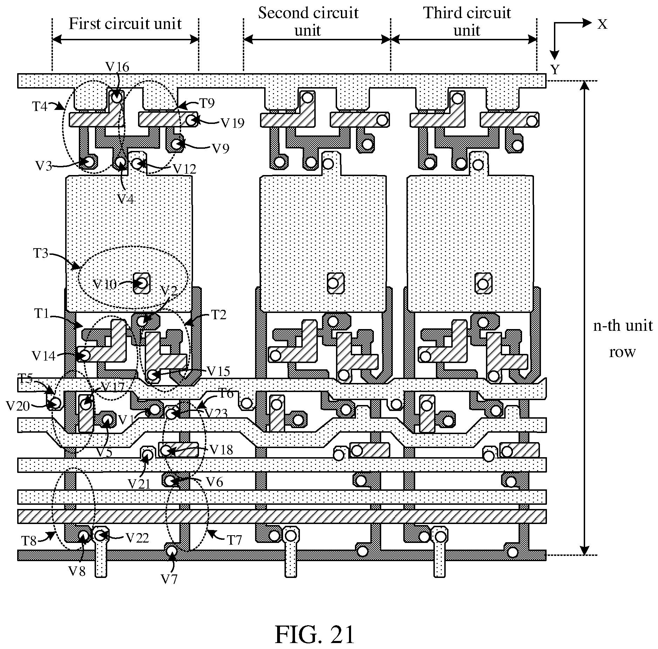

(24) A pattern of a fourth insulation layer is formed. In an exemplary implementation mode, forming the pattern of the fourth insulation layer may include: a fourth insulation thin film is deposited on the base substrate on which the aforementioned patterns are formed, and the fourth insulation thin film is patterned through a patterning process, to form a fourth insulation layer that covers the second conductive layer, wherein a plurality of vias are disposed on each circuit unit, as shown in FIG. 21.

In an exemplary implementation mode, the plurality of vias in each circuit unit in the display substrate include at least a first via V1, a second via V2, a third via V3, a fourth via V4, a fifth via V5, a sixth via V6, a seventh via V7, an eighth via V8, a ninth via V9, a tenth via V10, a twelfth via V12, a fourteenth via V14, a fifteenth via V15, a sixteenth via V16, a seventeenth via V17, an eighteenth via V18, a nineteenth via V19, a twentieth via V20, a twenty-first via V21, a twenty-second via V22, and a twenty-third via V23.

In an exemplary implementation mode, positions, structures, and connection relationships of the first via V1 to the tenth via V10 and the fourteenth via V14 to the twenty-third via V23 are substantially the same as those of the foregoing embodiment.

In an exemplary implementation mode, an orthographic projection of the twelfth via V12 on the base substrate is within a range of an orthographic projection of the electrode plate connection block 72-2 of the second electrode plate 72 on the base substrate, the fourth insulation layer within the twelfth via V12 is etched off to expose a surface of the electrode plate connection block 72-2, and the twelfth via V12 is configured such that a subsequently formed second connection electrode is connected with the electrode plate connection block 72-2 through the via.

In an exemplary implementation mode, the fourth insulation layer of the present embodiment is not formed with an eleventh via V11 and a thirteenth via V13.

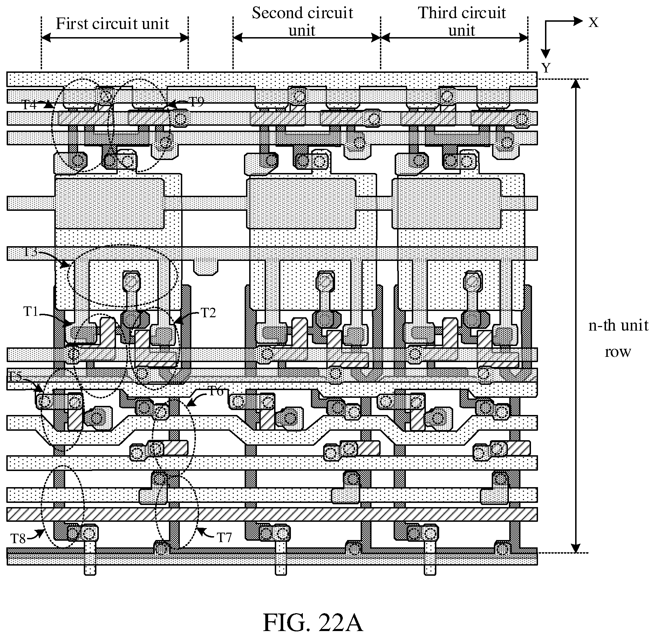

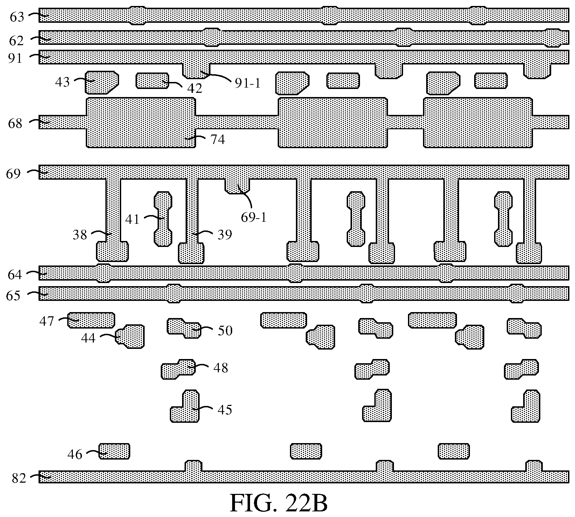

(25) A pattern of a third conductive layer is formed. In an exemplary implementation mode, forming the third conductive layer may include: a third conductive thin film is deposited on the base substrate on which the aforementioned patterns are formed, the third conductive thin film is patterned through a patterning process to form the third conductive layer disposed on the fourth insulation layer, as shown in FIG. 22A and FIG. 22B, and FIG. 22B is a schematic diagram of the third conductive layer in FIG. 22A.

In an exemplary implementation mode, patterns of the third conductive layer of a plurality of circuit units in the display substrate may each include a fifth shielding electrode 38, a sixth shielding electrode 39, a first connection electrode 41, a second connection electrode 42, a third connection electrode 43, a fourth connection electrode 44, a fifth connection electrode 45, a sixth connection electrode 46, a seventh connection electrode 47, an eighth connection electrode 48, a tenth connection electrode 50, a second scan signal line 62, a third scan signal line 63, a fourth scan signal line 64, a fifth scan signal line 65, a first power supply connection line 68, a second power supply connection line 69, a second initial signal line 82, a first reference signal line 91, and a fourth electrode plate 74.

In an exemplary implementation mode, positions, structures, and connection relationships of the second scan signal line 62, the third scan signal line 63, the fourth scan signal line 64, the fifth scan signal line 65, the second initial signal line 82, and the first reference signal line 91 are substantially the same as those of the foregoing embodiment.

In an exemplary implementation mode, the first power supply connection line 68 may be in a shape of a straight line with a main body portion extending along the first direction X, and may be located at a side of the first reference signal line 91 in the second direction Y. The first power supply connection line 68 is configured to be connected with a first power supply line formed subsequently, to form a high-voltage power supply grid structure of a net-like communication structure on the display substrate.

In an exemplary implementation mode, the second power supply connection line 69 may be in a shape of a straight line with a main body portion extending along the first direction X, and may be located at a side of the first power supply connection line 68 in the second direction Y, that is, the first power supply connection line 68 is located between the second power supply connection line 69 and the first reference signal line 91. The second power supply connection line 69 is configured to be connected with a second power supply line formed subsequently, to form a low-voltage power supply grid structure of a net-like communication structure on the display substrate.

In an exemplary implementation mode, in at least one circuit unit, a second power supply connection block 69-1 is provided at a side of the second power supply connection line 69 away from the first power supply connection line 68, a first end of the second power supply connection block 69-1 is connected with the second power supply connection line 69, a second end of the second power supply connection block 69-1 extends toward a direction away from the first power supply connection line 68, and the second power supply connection block 69-1 is configured to be connected with a second power supply line formed subsequently. In an exemplary implementation mode, the second power supply connection block 69-1 may be provided between the first circuit unit and the second circuit unit.

In an exemplary implementation mode, the fourth electrode plate 74 of the second storage capacitor may be in a shape of a rectangle, corners of the rectangle may be provided with chamfers, and the fourth electrode plate 74 may be located between the second power supply connection line 69 and the first reference signal line 91. An orthographic projection of the fourth electrode plate 74 on the base substrate is at least partially overlapped with an orthographic projection of the second electrode plate 72 on the base substrate. The fourth electrode plate 74 may serve as an upper electrode plate of the second storage capacitor, and the fourth electrode plate 74 and the second electrode plate 72 form the second storage capacitor of the pixel drive circuit.

In an exemplary implementation mode, an orthographic projection of the fourth electrode plate 74 on the base substrate is at least partially overlapped with an orthographic projection of the first power supply connection line 68 on the base substrate, and the first power supply connection line 68 is connected with the fourth electrode plate 74 of each circuit unit, so that the first power supply connection line 68 may ensure that a plurality of fourth electrode plates in one unit row have a same potential, which is conducive to improving uniformity of a panel, avoiding poor display of the display substrate, and ensuring a display effect of the display substrate. Since the first power supply connection line 68 is connected with a first power supply line formed subsequently, the first power supply connection line 68 may write a first power supply signal into an upper electrode plate of the second storage capacitor, and fourth electrode plates 74 in a plurality of circuit units have a potential of the first power supply line.

In an exemplary implementation mode, the first power supply connection line 68 and the fourth electrode plate 74 may be of an interconnected integral structure.

In an exemplary implementation mode, positions, structures, and connection relationships of the third connection electrode 43 to the eighth connection electrode 48 and the tenth connection electrode 50 are substantially the same as those of the foregoing embodiment.

In an exemplary implementation mode, the first connection electrode 41 may be in a shape of a strip with a main body portion extending along the second direction Y, and may be located between the fourth scan signal line 64 and the second power supply connection line 69. A first end of the first connection electrode 41 is connected with the second region of the first active layer (also the first region of the second active layer) through the second via V2, and a second end of the first connection electrode 41 is connected with the first electrode plate 71 through the tenth via V10. In an exemplary implementation mode, since the first connection electrode 41 is connected with the first electrode plate 71 and the first electrode plate 71 acts as a gate electrode of the third transistor T3, the first connection electrode 41 enables a second electrode of the first transistor T1, a first electrode of the second transistor T2, and the first electrode plate 71 of the first storage capacitor (i.e., the gate electrode of the third transistor T3) to have a same potential, the first connection electrode 41 may act as the first node N1 of the pixel drive circuit.

In an exemplary implementation mode, the second connection electrode 42 may be in a shape of a strip with a main body portion extending along the first direction X, and may be located between the first reference signal line 91 and the fourth electrode plate 74. A first end of the second connection electrode 42 is connected with the second region of the fourth active layer (also the second region of the ninth active layer) through the fourth via V4, and a second end of the second connection electrode 42 is connected with the electrode plate connection block 72-2 through the twelfth via V12. In an exemplary implementation mode, since the second connection electrode 42 is connected with the electrode plate connection block 72-2, and the electrode plate connection block 72-2 is connected with the second electrode plate 72, the second connection electrode 42 enables a second electrode of the fourth transistor T4, a second electrode of the ninth transistor T9, and the second electrode plate 74 of the second storage capacitor to have a same potential, and the second connection electrode 42 may serve as the fifth node N5 of the pixel drive circuit.

In an exemplary implementation mode, the fifth shielding electrode 38 may be in a shape of a strip with a main body portion extending along the second direction Y, and may be located at a side of the second power supply connection line 69 close to the fourth scan signal line 64. A first end of the fifth shielding electrode 38 is connected with the second power supply connection line 69, a second end of the fifth shielding electrode 38 extends toward a direction of the fourth scan signal line 64, an orthographic projection of the fifth shielding electrode 38 on the base substrate is at least partially overlapped with an orthographic projection of the first active layer between two gate electrodes of the first transistor T1 in the present circuit unit on the base substrate, the fifth shielding electrode 38 is configured to shield an influence of a data voltage jump on the first transistor T1, to prevent the data voltage jump from affecting a normal operation of the pixel drive circuit, and to improve a display effect.

In an exemplary implementation mode, the sixth shielding electrode 39 may have a shape of a strip with a main body portion extending along the second direction Y, and may be located at a side of the second power supply connection line 69 close to the fourth scan signal line 64. A first end of the sixth shielding electrode 39 is connected with the second power supply connection line 69, a second end of the sixth shielding electrode 39 extends toward a direction of the fourth scan signal line 64, an orthographic projection of the sixth shielding electrode 39 on the base substrate is at least partially overlapped with an orthographic projection of the second active layer between two gate electrodes of the second transistor T2 in the present circuit unit on the base substrate, the sixth shielding electrode 39 is configured to shield an influence of a data voltage jump on the second transistor T2, prevent the data voltage jump from affecting the normal operation of the pixel drive circuit, and improve the display effect.

In an exemplary implementation mode, the fifth shielding electrode 38, the sixth shielding electrode 39, and the second power supply connection line 69 may be of an interconnected integral structure.

In an exemplary implementation mode, since the first electrode plate 71 is connected with the second region of the first active layer (which is also the first region of the second active layer) through the first connection electrode 41, and the first electrode plate 71 serves as the gate electrode of the third transistor T3, the first electrode plate 71 has a potential of the first node N1. Since the third electrode plate 73 is connected with the second electrode plate 72, and the second electrode plate 72 is connected with the second region of the fourth active layer (also the second region of the ninth active layer) through the second connection electrode 42, both the second electrode plate 72 and the third electrode plate 73 have a potential of the fifth node N5. Since the fourth electrode plate 74 is connected with the first power supply connection line 68, and the first power supply connection line 68 is connected with a first power supply line formed subsequently, the fourth electrode plate 74 has a potential of the first power supply line. In this way, the first electrode plate 71 having the potential of the first node N1 and the third electrode plate 73 having the potential of the fifth node N5 form the first storage capacitor of the pixel drive circuit, the first electrode plate 71 is a first end of the first storage capacitor, and the third electrode plate 73 is a second end of the first storage capacitor. The second electrode plate 72 having the potential of the fifth node N5 and the fourth electrode plate 74 having the potential of the first power supply line form the second storage capacitor of the pixel drive circuit, the fourth electrode plate 74 is a first end of the second storage capacitor, and the second electrode plate 72 is a second end of the second storage capacitor.

In an exemplary implementation mode, the first electrode plate 71 (a lower electrode plate of the first storage capacitor) is provided in the first conductive layer, the second electrode plate 72 (a lower electrode plate of the second storage capacitor) and the third electrode plate 73 (an upper electrode plate of the first storage capacitor) are provided in the second conductive layer, and the fourth electrode plate 74 (an upper electrode plate of the second storage capacitor) is provided in the third conductive layer, forming the first storage capacitor and the second storage capacitor which are stacked, and the second storage capacitor is provided at a side of the first storage capacitor away from the base substrate. In an embodiment of the present disclosure, the upper electrode plate of the first storage capacitor and the lower electrode plate of the second storage capacitor are disposed in the second conductive layer and have a common structure, the lower electrode plate of the first storage capacitor remains unchanged, and the upper electrode plate of the second storage capacitor in the third conductive layer is increased, so that the first power supply connection line 68 and the fourth electrode plate 74 of an integral structure achieve a through design of the upper electrode plate of the second storage capacitor in the first direction X, and a layout is more optimized, on one hand, an occupied area of the first storage capacitor and the second storage capacitor may be reduced, which is conducive to improving a resolution (Pixel Per Inch (PPI)) of the display substrate, on the other hand, on a premise of guaranteeing the resolution of the display substrate, space optimized by the layout of the storage capacitors may be used for laying out other signal lines such as laying out the second power supply line and the like. Since fourth electrode plates 74 in one unit row are connected with each other by means of the first power supply connection line 68, and an orthographic projection of the first power supply connection line 68 on the base substrate is overlapped with an orthographic projection of a data signal line formed subsequently on the base substrate, which is equivalent to performing a narrowing design at an overlapping position of the first power supply line and the data signal line, reducing an overlapping area of the first power supply line and the data signal line, reducing a parasitic capacitance between the first power supply line and the data signal line, signal crosstalk may be avoided effectively. In the present disclosure, by providing the fifth shielding electrode 38 and the sixth shielding electrode 39 in the third conductive layer, and by utilizing the second power supply connection line 69 to provide a constant voltage for the fifth shielding electrode 38 and the sixth shielding electrode 39, a structure is more reasonable, which is conducive to improving the resolution of the display substrate.

In an exemplary implementation mode, orthographic projections of the second electrode plate 72 and the third electrode plate 73 on the base substrate are not overlapped with an orthographic projection of the first reference signal line 91 on the base substrate, and the orthographic projections of the second electrode plate 72 and the third electrode plate 73 on the base substrate are not overlapped with an orthographic projection of the reference signal connection line 54 on the base substrate. Since the second electrode plate 72 and the third electrode plate 73 have the potential of the fifth node N5, the first reference signal line 91 and the reference signal connection line 54 are provided to be not overlapped with the second electrode plate 72 and the third electrode plate 73 of an integral structure, so that a parasitic capacitance of the fifth node N5 may be reduced, signal crosstalk may be effectively avoided, and the potential of the fifth node N5 may be guaranteed to be stable.

In an exemplary implementation mode, in at least one circuit unit, a capacitance value of the first storage capacitor may be greater than a capacitance value of the second storage capacitor.

In some exemplary implementation modes, the capacitance value of the first storage capacitor may be greater than 1.5 times the capacitance value of the second storage capacitor.

In an exemplary implementation mode, an orthographic projection of the first electrode plate 71 on the base substrate and an orthographic projection of the third electrode plate 73 on the base substrate have a first overlapping region, and an orthographic projection of the second electrode plate 72 on the base substrate and an orthographic projection of the fourth electrode plate 74 on the base substrate have a second overlapping region. In at least one circuit unit, the first overlapping region may be larger than the second overlapping region. In some exemplary implementation modes, the first overlapping region may be greater than 1.5 times the second overlapping region.

In an exemplary implementation mode, the fifth shielding electrode 38 and the sixth shielding electrode 39 of the present embodiment are connected with the second power supply connection line 69 providing a low-voltage power supply signal, the second power supply connection line 69 is provided with the second power supply connection block 69-1, and the second initial signal line 82 is not provided with a second initial connection block.

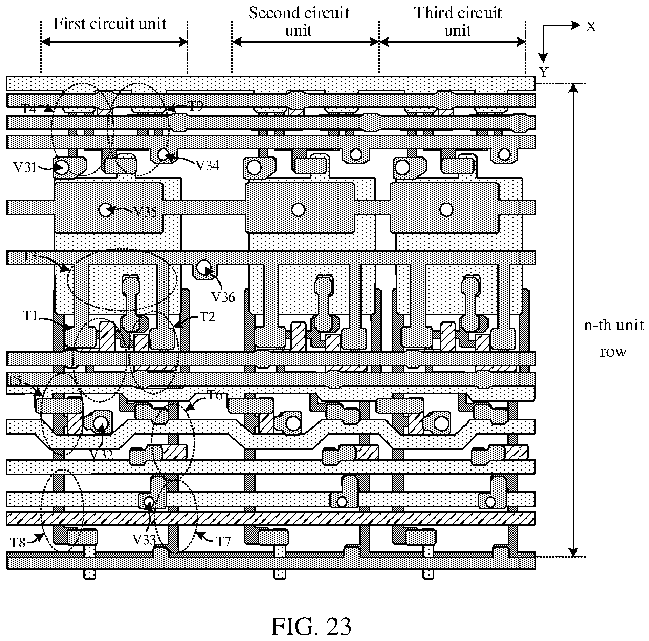

(26) A pattern of a fifth insulation layer is formed. In an exemplary implementation mode, forming the pattern of the fifth insulation layer may include: a fifth insulation thin film is deposited on the base substrate on which the aforementioned patterns are formed, the fifth insulation thin film is patterned through a patterning process to form a fifth insulation layer that covers the third conductive layer, wherein a plurality of vias are disposed in each circuit unit, as shown in FIG. 23.

In an exemplary implementation mode, the plurality of vias of each circuit unit in the display substrate include at least a thirty-first via V31, a thirty-second via V32, a thirty-third via V33, a thirty-fourth via V34, and a thirty-fifth via V35.

In an exemplary implementation mode, positions, structures, and connection relationships of the thirty-first via V31 to the thirty-fourth via V34 are substantially the same as those of the foregoing embodiment.

In an exemplary implementation mode, an orthographic projection of the thirty-fifth via V35 on the base substrate is within a range of an orthographic projection of the first power supply connection line 68 (also the fourth electrode plate 74) on the base substrate, the fifth insulation layer within the thirty-fifth via V35 is removed to expose a surface of the first power supply connection line 68, and the thirty-fifth via V35 is configured such that a subsequently formed first power supply line is connected with the first power supply connection line 68 (also the fourth electrode plate 74) through the via.

In an exemplary implementation mode, at least one circuit unit may further include a thirty-sixth via V36. An orthographic projection of the thirty-sixth via V36 on the base substrate is within a range of an orthographic projection of the second power supply connection block 69-1 of the second power supply connection line 69 on the base substrate, the fifth insulation layer within the thirty-sixth via V36 is removed to expose a surface of the second power supply connection block 69-1, and the thirty-sixth via V36 is configured such that a second power supply line formed subsequently is connected with the second power supply connection block 69-1 through the via. In an exemplary implementation mode, the thirty-sixth via V36 may be located between the first circuit unit and the second circuit unit.

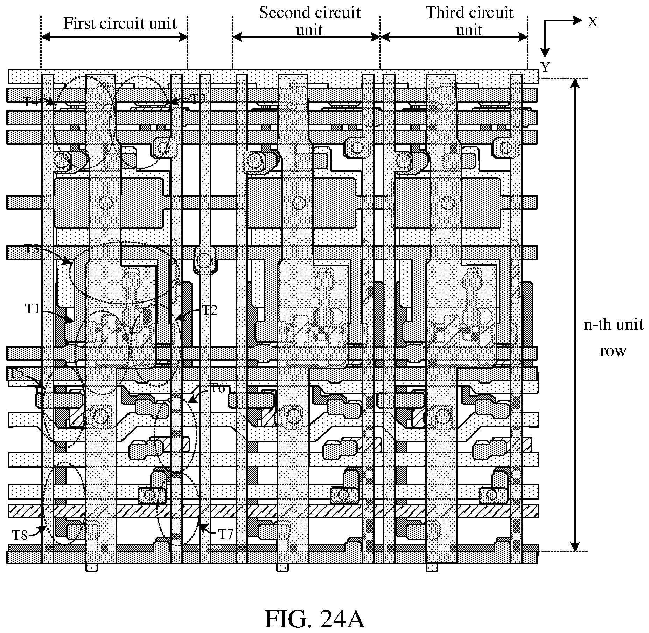

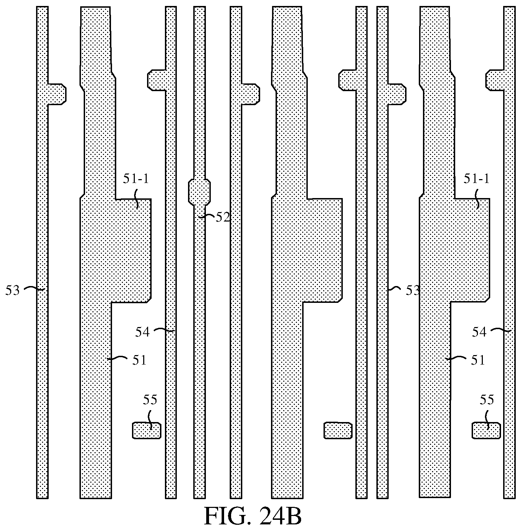

(27) A pattern of a fourth conductive layer is formed. In an exemplary implementation mode, forming a pattern of a fourth conductive layer may include depositing a fourth conductive thin film on the base substrate on which the above-mentioned patterns are formed, patterning the fourth conductive thin film using a patterning process to form a fourth conductive layer disposed on the fifth insulation layer, as shown in FIGs. 24A and 24B, FIG. 24B is a schematic diagram of the fourth conductive layer in FIG. 24A.

In an exemplary implementation mode, patterns of the fourth conductive layer of a plurality of circuit units in the display substrate may each include a first power supply line 51, a data signal line 53, a reference signal connection line 54, and an anode connection electrode 55.

In an exemplary implementation mode, positions, structures, and connection relationships of the first power supply line 51 (including a power supply shielding block 51-1), the data signal line 53, the reference signal connection line 54, and the anode connection electrode 55 are substantially the same as those of the foregoing embodiment. The first power supply connection line 68 with a main body portion extending along the first direction X and the first power supply line 51 with a main body portion extending along the second direction Y are interconnected so that the first power supply line 51 and the first power supply connection line 68 form a mesh-like mesh structure for transmitting a first power supply signal on the display substrate. The first reference signal line 91 with a main body portion extending along the first direction X and the reference signal connection line 54 with a main body portion extending along the second direction Y are interconnected so that the first reference signal line 91 and the reference signal connection line 54 form a mesh-like mesh structure for transmitting a first reference signal on the display substrate.

In an exemplary implementation mode, a second power supply line 52 may also be included in at least one circuit unit. The second power supply line 52 may be in a shape of a straight line with a main body portion extending along the second direction Y, and the second power supply line 52 is connected with the second power supply connection block 69-1 through the thirty-sixth via V36. Since the second power supply connection block 69-1 is connected with the second power supply connection line 69, an interconnection of the second power supply connection line 69 with a main body portion extending along the first direction X and the second power supply line 52 with a main body portion extending along the second direction Y is thus achieved, so that the second power supply line 52 and the second power supply connection line 69 form a mesh-like mesh structure for transmitting a second power supply signal on the display substrate, which not only may effectively reduce a resistance of the second power supply line 52, reduce a voltage drop of the second power supply signal, but also may effectively improve uniformity of the second power supply signal in the display substrate, effectively improve uniformity of display, and improve display attribute and display quality. In an exemplary implementation mode, the second power supply line 52 may be located between the reference signal connection line 54 of the first circuit unit and the data signal line 53 of the second circuit unit.

In an exemplary implementation mode, the second power supply connection line 69 of the third conductive layer may be provided in each unit row, the second power supply line 52 of the fourth conductive layer may be provided every two unit columns, and a plurality of second power supply lines 52 are connected with a plurality of second power supply connection lines 69, respectively, to form a mesh structure for transmitting a second power supply signal.

In present embodiment, the second active connection line 20, the first active layer 11 to the ninth active layer 19 may be disposed in the semiconductor layer, the first gate electrode 21, the second gate electrode 22, the fourth gate electrode 24, the fifth gate electrode 25, the sixth gate electrode 26, the ninth gate electrode 29, the first scan signal line 61, and the first electrode plate 71 may be disposed in the first conductive layer, the first light emitting signal line 31, the second light emitting signal line 32, the repair line 33, the third shielding electrode 36, the fourth shielding electrode 37, the second electrode plate 72, the third electrode plate 73, the first initial signal line 81, and the second reference signal line 92 may be disposed in the second conductive layer, the fifth shielding electrode 38, the sixth shielding electrode 39, the first connection electrode 41 to the eighth connection electrode 48, the tenth connection electrode 50, the second scan signal line 62, the third scan signal line 63, the fourth scan signal line 64, the fifth scan signal line 65, the first power supply connection line 68, the second power supply connection line 69, the second initial signal line 82, the first reference signal line 91, and the fourth electrode plate 74 may be disposed in the third conductive layer, the first power supply line 51, the second power supply line 52, the data signal line 53, the reference signal connection line 54, and the anode connection electrode 55 may be disposed in the fourth conductive layer.

As may be seen from the structure and the preparation process of the display substrate of the present embodiment described above, In an embodiment of the present disclosure, the first conductive layer, the second conductive layer, and the third conductive layer are used for forming the first storage capacitor and the second storage capacitor that are stacked, a lower electrode plate of the first storage capacitor is disposed in the first conductive layer, an upper electrode plate of the first storage capacitor and a lower electrode plate of the second storage capacitor are disposed in the second conductive layer and have a common structure, and an upper electrode plate of the second storage capacitor is disposed in the third conductive layer. Therefore, the second storage capacitor is disposed at a side of the first storage capacitor away from the base substrate, and a layout is more optimized. On one hand, an occupied area of the first storage capacitor and the second storage capacitor may be reduced, which is conducive to improving a resolution of the display substrate. On the other hand, on a premise of guaranteeing the resolution of the display substrate, space optimized by the layout of the storage capacitors may be used for laying out other signal lines.

In an embodiment of the present disclosure, a narrowing design is performed at an overlapping position of the first power supply line and the data signal line, which reduces an overlapping area of the first power supply line and the data signal line, reduces a parasitic capacitance between the first power supply line and the data signal line, and may effectively avoid signal crosstalk.

In an embodiment of the present disclosure, a second power supply connection line with a main body portion extending along the first direction X and a second power supply line with a main body portion extending along the second direction Y are provided, and the second power supply line and the second power supply connection line are connected with each other, so that the second power supply line and the second power supply connection line form a mesh-like mesh structure for transmitting a second power supply signal on the display substrate, which may not only effectively reduce a resistance of the second power supply signal line, reduce a voltage drop of the second power supply signal, but also may effectively improve uniformity of the second power supply signal in the display substrate, effectively improve uniformity of display, and improve display attribute and display quality.

In an embodiment of the present disclosure, the third shielding electrode, the fourth shielding electrode, the fifth shielding electrode, and the sixth shielding electrode are provided, which may shield an influence of a data voltage jump on the first transistor T1, the second transistor T2, the fourth transistor T4, and the ninth transistor T9, prevent the data voltage jump from affecting a normal operation of the pixel drive circuit, and improve a display effect. By using the second power supply line to provide a constant voltage for the fifth shielding electrode and the sixth shielding electrode, a structure is more reasonable, and it is beneficial to improve a resolution of the display substrate. The preparation process in the present disclosure may be compatible well with an existing preparation process, is simple in process implementation, is easy to implement, and has a high production efficiency, a low production cost, and a high yield.

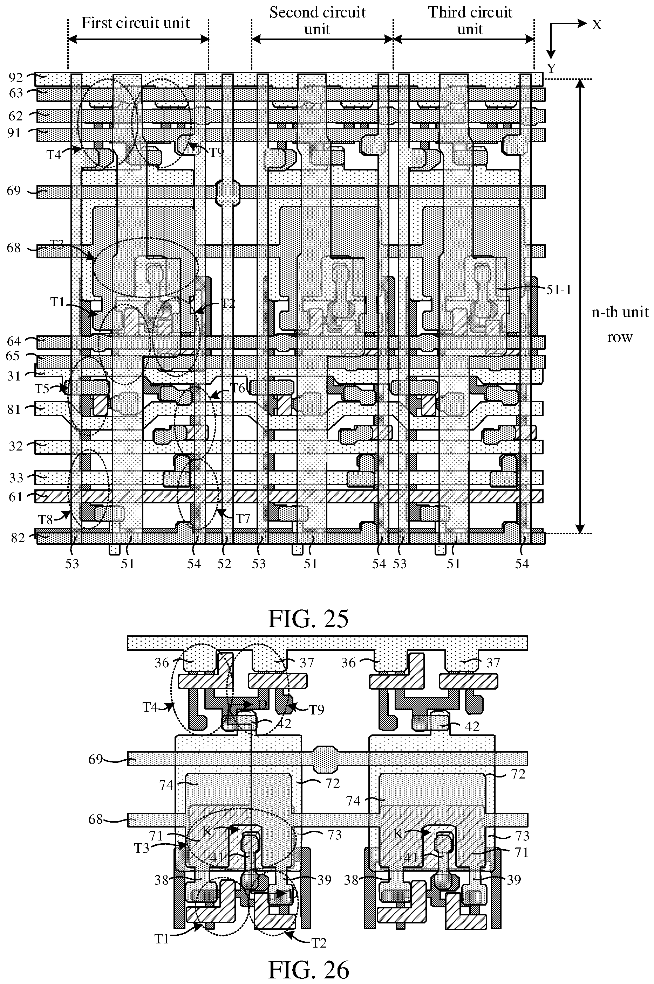

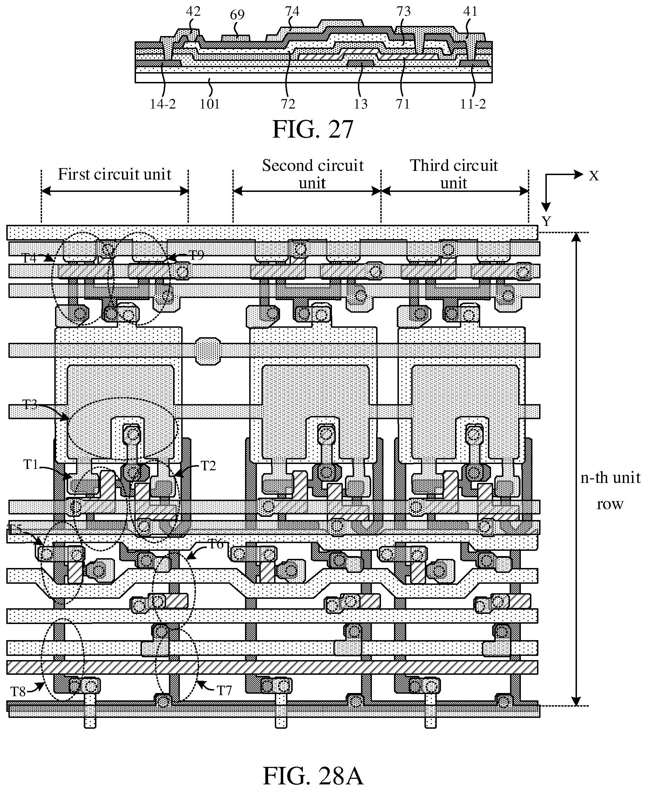

FIG. 25 is a schematic diagram of a planar structure of yet another display substrate according to an exemplary embodiment of the present disclosure, illustrating a structure of a pixel drive circuit in three circuit units (a first circuit unit, a second circuit unit, and a third circuit unit) in the display substrate, FIG. 26 is a schematic diagram of a structure of a first storage capacitor and a second storage capacitor in FIG. 25, and FIG. 27 is a sectional view taken along a D-D direction in FIG. 26. As shown in FIGs. 25, 26, and 27, a main body structure of the pixel drive circuit in the exemplary embodiment is substantially the same as that in the embodiment shown in FIG. 15, the first storage capacitor and the second storage capacitor are of a stacked structure and the second storage capacitor is provided at a side of the first storage capacitor away from the base substrate, except that in the present embodiment, positions of the first power supply connection line 68 and the second power supply connection line 69 are different, and the fifth shielding electrode 38 and the sixth shielding electrode 39 are connected with the first power supply connection line 68 (the fourth electrode plate 74).

In an exemplary implementation mode, the first storage capacitor may include at least a first electrode plate 71 and a third electrode plate 73, an orthographic projection of the third electrode plate 73 on the base substrate is at least partially overlapped with an orthographic projection of the first electrode plate 71 on the base substrate, the first electrode plate 71 and the third electrode plate 73 constitute the first storage capacitor. The second storage capacitor may include at least a second electrode plate 72 and a fourth electrode plate 74, an orthographic projection of the fourth electrode plate 74 on the base substrate is at least partially overlapped with an orthographic projection of the second electrode plate 72 on the base substrate, and the second electrode plate 72 and the fourth electrode plate 74 constitute the second storage capacitor.

In an exemplary implementation mode, positions, structures, and connection relationships of the first connection electrode 41, the second connection electrode 42, the third shielding electrode 36, the fourth shielding electrode 37, the first electrode plate 71, the second electrode plate 72, the third electrode plate 73, and the fourth electrode plate 74 in the present embodiment are substantially the same as those of the foregoing embodiment.

In an exemplary implementation mode, the at least one circuit unit may further include a fifth shielding electrode 38 connected with the first power supply connection line 68, an orthographic projection of the fifth shielding electrode 38 on the base substrate is at least partially overlapped with an orthographic projection of the semiconductor layer between two gate electrodes of the first transistor T1 on the base substrate. The at least one circuit unit may further include a sixth shielding electrode 39 connected with the first power supply connection line 68, an orthographic projection of the sixth shielding electrode 39 on the base substrate is at least partially overlapped with an orthographic projection of the semiconductor layer between two gate electrodes of the second transistor T2 on the base substrate. Positions and functions of the fifth shielding electrode 38 and the sixth shielding electrode 39 are substantially the same as those of the foregoing embodiment.

In an exemplary implementation mode, the fifth shielding electrode 38, the sixth shielding electrode 39, the first power supply connection line 68, and the fourth electrode plate 74 may be of an interconnected integral structure.

In an exemplary implementation mode, a mesh structure for transmitting a first power supply signal, a mesh structure for transmitting a second power supply signal, and a mesh structure for transmitting a first reference signal in the present embodiment are substantially the same as those of the foregoing embodiment.

In an exemplary implementation mode, a groove K is provided at a side of the fourth electrode plate 74 close to the fourth scan signal line 64, and the first connection electrode 41 is provided in the groove K, so that a first node of the pixel drive circuit is substantially surrounded by a constant potential of the first power supply line, the first node of the pixel drive circuit is more effectively shielded, interference of another signal to the first node of the pixel drive circuit is avoided to a maximum extent, and a display effect is improved.

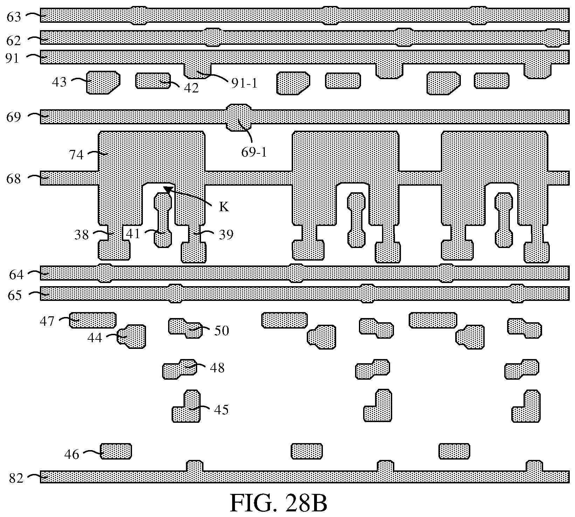

In an exemplary implementation mode, taking three circuit units (a first circuit unit, a second circuit unit, and a third circuit unit) in an n-th unit row as an example, a preparation process of the display substrate according to the present embodiment may include following operations.
(31) A pattern of a first insulation layer, a pattern of a semiconductor layer, a pattern of a second insulation layer, a pattern of a first conductive layer, a pattern of a third insulation layer, a pattern of a second conductive layer, and a pattern of a fourth insulation layer are formed sequentially. The semiconductor layer may include at least a second active connection line 20 and a first active layer 11 of the first transistor T1 to a ninth active layer 19 of the ninth transistor T9. The pattern of the first conductive layer includes at least a first gate electrode 21, a second gate electrode 22, a fourth gate electrode 24, a fifth gate electrode 25, a sixth gate electrode 26, a ninth gate electrode 29, a first scan signal line 61, and a first electrode plate 71. The pattern of the second conductive layer includes at least a first light emitting signal line 31, a second light emitting signal line 32, a repair line 33, a third shielding electrode 36, a fourth shielding electrode 37, a second electrode plate 72, a third electrode plate 73, a first initial signal line 81, and a second reference signal line 92. A plurality of vias on the fourth insulation layer include at least a first via V1 to a tenth via V10, a twelfth via V12, and a fourteenth via V14 to a twenty-third via V23. Positions, structures, and connection relationships of the above patterns are substantially the same as those of the foregoing embodiment, which will not be repeated herein.
(32) A pattern of a third conductive layer is formed. In an exemplary implementation mode, forming the third conductive layer may include: a third conductive thin film is deposited on the base substrate on which the aforementioned patterns are formed, the third conductive thin film is patterned through a patterning process to form the third conductive layer disposed on the fourth insulation layer, as shown in FIG. 28A and FIG. 28B, and FIG. 28B is a schematic diagram of the third conductive layer in FIG. 28A.

In an exemplary implementation mode, patterns of the third conductive layer of a plurality of circuit units in the display substrate may each include a fifth shielding electrode 38, a sixth shielding electrode 39, a first connection electrode 41, a second connection electrode 42, a third connection electrode 43, a fourth connection electrode 44, a fifth connection electrode 45, a sixth connection electrode 46, a seventh connection electrode 47, an eighth connection electrode 48, a tenth connection electrode 50, a second scan signal line 62, a third scan signal line 63, a fourth scan signal line 64, a fifth scan signal line 65, a first power supply connection line 68, a second power supply connection line 69, a fourth electrode plate 74, a second initial signal line 82, and a first reference signal line 91.

In an exemplary implementation mode, positions, structures, and connection relationships of the first connection electrode 41 to the eighth connection electrode 48, the tenth connection electrode 50, the second scan signal line 62, the third scan signal line 63, the fourth scan signal line 64, the fifth scan signal line 65, the first power supply connection line 68, the second power supply connection line 69, the second initial signal line 82, and the first reference signal line 91 are substantially the same as those of the foregoing embodiment, except that the second power supply connection line 69 is provided at a side of the first reference signal line 91 in the second direction Y, and the first power supply connection line 68 is provided at a side of the second power supply connection line 69 in the second direction Y, that is, the second power supply connection line 69 is located between the first power supply connection line 68 and the first reference signal line 91.

In an exemplary implementation mode, the fourth electrode plate 74 of the second storage capacitor may be in a shape of a rectangle, corners of the rectangle may be provided with chamfers, and the fourth electrode plate 74 may be located between the second power supply connection line 69 and the fourth scan signal line 64. An orthographic projection of the fourth electrode plate 74 on the base substrate is at least partially overlapped with an orthographic projection of the second electrode plate 72 on the base substrate. The fourth electrode plate 74 may serve as an upper electrode plate of the second storage capacitor, and the fourth electrode plate 74 and the second electrode plate 72 form the second storage capacitor of the pixel drive circuit.

In an exemplary implementation mode, an orthographic projection of the fourth electrode plate 74 on the base substrate is at least partially overlapped with an orthographic projection of the first power supply connection line 68 on the base substrate, and the first power supply connection line 68 is connected with the fourth electrode plate 74 of each circuit unit, so that the first power supply connection line 68 may ensure that a plurality of fourth electrode plates in one unit row have a same potential, which is conducive to improving uniformity of a panel, avoiding poor display of the display substrate, and ensuring a display effect of the display substrate. Since the first power supply connection line 68 is connected with a first power supply line formed subsequently, the first power supply connection line 68 may write a first power supply signal into the upper electrode plate of the second storage capacitor, and fourth electrode plates 74 of the plurality of circuit units have a potential of the first power supply line.

In an exemplary implementation mode, the first power supply connection line 68 and the fourth electrode plate 74 may be of an interconnected integral structure.

In an exemplary implementation mode, a groove K is provided at a side of the fourth electrode plate 74 close to the fourth scan signal line 64, and the groove K is configured to accommodate the first connection electrode 41. Since the fourth electrode plate 74 has the potential of the first power supply line, and the first connection electrode 41 serves as the first node of the pixel drive circuit, thus a structure in which the first connection electrode 41 is disposed in the groove K makes the first node of the pixel drive circuit essentially surrounded by a constant potential of the first power supply line, the first node of the pixel drive circuit is more effectively shielded, interference of another signal to the first node of the pixel drive circuit is avoided to a maximum extent, and the display effect is improved.

In an exemplary implementation mode, the fifth shielding electrode 38 may be in a shape of a strip with a main body portion extending along the second direction Y, and may be located at a side of the fourth electrode plate 74 close to the fourth scan signal line 64. A first end of the fifth shielding electrode 38 is connected with the fourth electrode plate 74, and a second end of the fifth shielding electrode 38 extends toward a direction of the fourth scan signal line 64. An orthographic projection of the fifth shielding electrode 38 on the base substrate is at least partially overlapped with an orthographic projection of the first active layer between two gate electrodes of the first transistor T1 in the present circuit unit on the base substrate. The fifth shielding electrode 38 is configured to shield an influence of a data voltage jump on the first transistor T1, prevent the data voltage jump from affecting a normal operation of the pixel drive circuit, and improve the display effect.

In an exemplary implementation mode, the sixth shielding electrode 39 may be in a shape of a strip with a main body portion extending along the second direction Y, may be located at a side of the fourth electrode plate 74 close to the fourth scan signal line 64, a first end of the sixth shielding electrode 39 is connected with the fourth electrode plate 74, a second end of the sixth shielding electrode 39 extends toward a direction of the fourth scan signal line 64, an orthographic projection of the sixth shielding electrode 39 on the base substrate is at least partially overlapped with an orthographic projection of the second active layer between two gate electrodes of the second transistor T2 in the present circuit unit on the base substrate, the sixth shielding electrode 39 is configured to shield an influence of a data voltage jump on the second transistor T2, prevent the data voltage jump from affecting the normal operation of the pixel drive circuit, and improve the display effect.

In an exemplary implementation mode, the fourth electrode plate 74, the fifth shielding electrode 38, the sixth shielding electrode 39, and the first power supply connection line 68 may be of an interconnected integral structure.

In an exemplary implementation mode, the first electrode plate 71 has a potential of the first node N1, the second electrode plate 72 and the third electrode plate 73 have a potential of the fifth node N5, and the fourth electrode plate 74 has a potential of the first power supply line. In this way, the first electrode plate 71 having the potential of the first node N1 and the third electrode plate 73 having the potential of the fifth node N5 form the first storage capacitor of the pixel drive circuit, and the second electrode plate 72 having the potential of the fifth node N5 and the fourth electrode plate 74 having the potential of the first power supply line form the second storage capacitor of the pixel drive circuit.

In an exemplary implementation mode, the first electrode plate 71 (a lower electrode plate of the first storage capacitor) is provided in the first conductive layer, the second electrode plate 72 (a lower electrode plate of the second storage capacitor) and the third electrode plate 73 (an upper electrode plate of the first storage capacitor) are provided in the second conductive layer, and the fourth electrode plate 74 (an upper electrode plate of the second storage capacitor) is provided in the third conductive layer, forming the first storage capacitor and the second storage capacitor which are stacked, and the second storage capacitor is provided at a side of the first storage capacitor away from the base substrate. In an embodiment of the present disclosure, the upper electrode plate of the first storage capacitor and the lower electrode plate of the second storage capacitor are disposed in the second conductive layer and have a common structure, the lower electrode plate of the first storage capacitor remains unchanged, and the upper electrode plate of the second storage capacitor in the third conductive layer is increased, so that the first power supply connection line 68 and the fourth electrode plate 74 of an integral structure achieve a through design of the upper electrode plate of the second storage capacitor in the first direction X, and a layout is more optimized, on one hand, an occupied area of the first storage capacitor and the second storage capacitor may be reduced, which is conducive to improving a resolution of the display substrate, on the other hand, on a premise of guaranteeing the resolution of the display substrate, space optimized by the layout of the storage capacitors may be used for laying out other signal lines such as laying out the second power supply line and the like. Since fourth electrode plates 74 in one unit row are connected with each other by means of the first power supply connection line 68, and an orthographic projection of the first power supply connection line 68 on the base substrate is overlapped with an orthographic projection of a data signal line formed subsequently on the base substrate, which is equivalent to performing a narrowing design at an overlapping position of the first power supply line and the data signal line, reducing an overlapping area of the first power supply line and the data signal line, reducing a parasitic capacitance between the first power supply line and the data signal line, signal crosstalk may be avoided effectively. In the present disclosure, by providing the fifth shielding electrode 38 and the sixth shielding electrode 39 in the third conductive layer, and utilizing the first power supply connection line 68 to provide a constant voltage for the fifth shielding electrode 38 and the sixth shielding electrode 39, a structure is more reasonable, which is conducive to improving the resolution of the display substrate.

In an exemplary implementation mode, orthographic projections of the second electrode plate 72 and the third electrode plate 73 on the base substrate are at least partially overlapped with orthographic projections of the first power supply connection line 68 and the second power supply connection line 69 on the base substrate, respectively. Since the second electrode plate 72 and the third electrode plate 73 have the potential of the fifth node N5, and the first power supply connection line 68 and the second power supply connection line 69 have a constant potential, and thus the potential of the fifth node N5 may be stabilized by setting the first power supply connection line 68 and the second power supply connection line 69 to be at least partially overlapped with the second electrode plate 72 and the third electrode plate 73 of an integral structure.

In an exemplary implementation mode, orthographic projections of the second electrode plate 72 and the third electrode plate 73 on the base substrate are not overlapped with an orthographic projection of the first reference signal line 91 on the base substrate, and the orthographic projections of the second electrode plate 72 and the third electrode plate 73 on the base substrate are not overlapped with an orthographic projection of the reference signal connection line 54 on the base substrate. Since the second electrode plate 72 and the third electrode plate 73 have the potential of the fifth node N5, by setting the first reference signal line 91 and the reference signal connection line 54 not to be overlapped with the second electrode plate 72 and the third electrode plate 73 of an integral structure, a parasitic capacitance of the fifth node N5 may be reduced, signal crosstalk may be effectively avoided, and the potential of the fifth node N5 may be guaranteed to be stable.

In an exemplary implementation mode, in at least one circuit unit, a capacitance value of the first storage capacitor may be smaller than a capacitance value of the second storage capacitor.

In an exemplary implementation mode, an orthographic projection of the first electrode plate 71 on the base substrate and an orthographic projection of the third electrode plate 73 on the base substrate have a first overlapping region, and an orthographic projection of the second electrode plate 72 on the base substrate and an orthographic projection of the fourth electrode plate 74 on the base substrate have a second overlapping region. In the at least one circuit unit, the first overlapping region may be smaller than the second overlapping region.

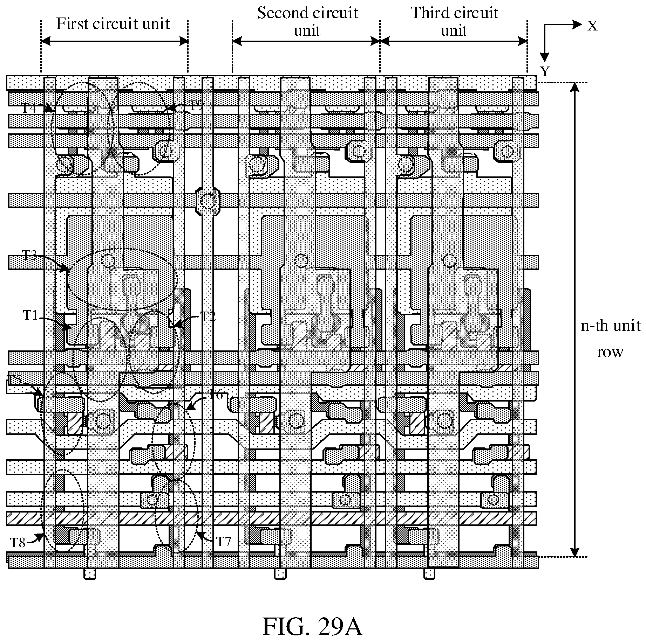

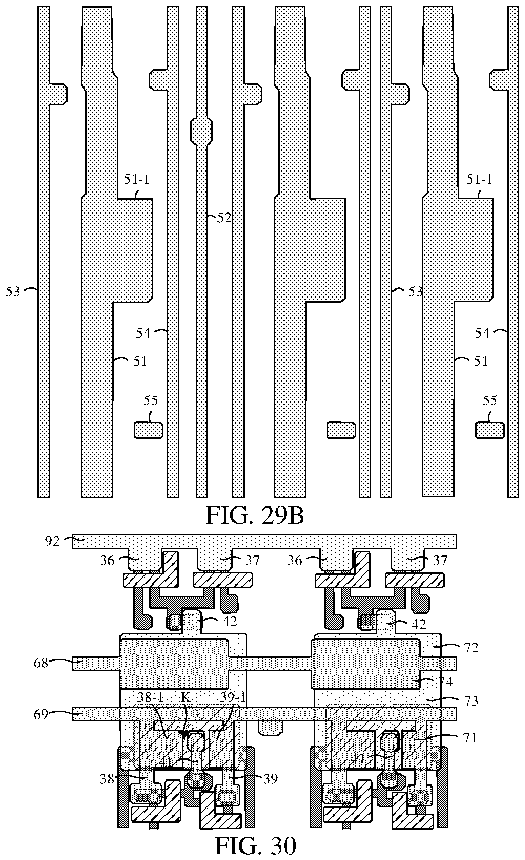

(33) A fifth insulation layer and a pattern of a fourth conductive layer are sequentially formed. A plurality of vias on the fifth insulation layer include at least a thirty-first via V31 to a thirty-sixth via V36. The pattern of the fourth conductive layer includes at least: a first power supply line 51, a second power supply line 52, a data signal line 53, a reference signal connection line 54, and an anode connection electrode 55. Positions, structures, and connection relationships of the above patterns are substantially the same as those of the foregoing embodiment, as shown in FIGs. 29A and 29B, FIG. 29B is a schematic diagram of the fourth conductive layer in FIG. 29A.

In an exemplary implementation mode, the pattern of the fourth conductive layer may each include a first power supply line 51, a second power supply line 52, a data signal line 53, a reference signal connection line 54, and an anode connection electrode 55. Positions, structures, and connection relationships of the first power supply line 51 (including a power supply shielding block 51-1), the second power supply line 52, the data signal line 53, the reference signal connection line 54, and the anode connection electrode 55 are substantially the same as those of the foregoing embodiment.

As may be seen from the structure and the preparation process of the display substrate of the present embodiment described above, in the embodiment of the present disclosure, the first conductive layer, the second conductive layer, and the third conductive layer are used for forming the first storage capacitor and the second storage capacitor that are stacked, the lower electrode plate of the first storage capacitor is disposed in the first conductive layer, the upper electrode plate of the first storage capacitor and the lower electrode plate of the second storage capacitor are disposed in the second conductive layer and have a common structure, and the upper electrode plate of the second storage capacitor is disposed in the third conductive layer. Therefore, the second storage capacitor is disposed at a side of the first storage capacitor away from the base substrate, and a layout is more optimized. On one hand, an occupied area of the first storage capacitor and the second storage capacitor may be reduced, which is conducive to improving a resolution of the display substrate. On the other hand, on a premise of guaranteeing the resolution of the display substrate, space optimized by the layout of the storage capacitors may be used for laying out other signal lines.

In the embodiment of the present disclosure, the groove K is provided on the fourth electrode plate 74, and the first connection electrode 41 is provided in the groove K, so that the first node of the pixel drive circuit is substantially surrounded by a constant potential of the first power supply line, the first node of the pixel drive circuit is more effectively shielded, interference of another signal to the first node of the pixel drive circuit is avoided to a maximum extent, and the display effect is improved.

In the embodiment of the present disclosure, a constant voltage is provided for the fifth shielding electrode and the sixth shielding electrode by using the first power supply line, so that a structure is more reasonable, which is conducive to improving the resolution of the display substrate. The preparation process in the present disclosure may be compatible well with an existing preparation process, is simple in process implementation, is easy to implement, and has a high production efficiency, a low production cost, and a high yield.

In an exemplary implementation mode, the base substrate may be a flexible base substrate, or a rigid base substrate. The rigid base substrate may be made of, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In an exemplary implementation mode, the flexible base substrate may include a first flexible material layer, a first inorganic material layer, a semiconductor layer, a second flexible material layer, and a second inorganic material layer which are stacked, wherein materials of the first flexible material layer and the second flexible material layer may be Polyimide (PI), Polyethylene Terephthalate (PET), or a surface-treated polymer soft film, or the like, materials of the first inorganic material layer and the second inorganic material layer may be Silicon Nitride (SiNx) or Silicon Oxide (SiOx), or the like, for improving a water and oxygen resistance capability of the base substrate, and a material of the semiconductor layer may be amorphous silicon (a-si).

In an exemplary implementation mode, the first conductive layer, the second conductive layer, the third conductive layer, and the fourth conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo. The first insulation layer, the second insulation layer, the third insulation layer, the fourth insulation layer, and the fifth insulation layer may be made of any one or more of Silicon Oxide (SiOx), Silicon Nitride (SiNx), and Silicon Oxynitride (SiON), and may be a single layer, a multi-layer, or a composite layer. The first insulation layer is referred to as a buffer layer, the second insulation layer and the third insulation layer are referred to as Gate Insulation (GI) layers, the fourth insulation layer is referred to as an Interlayer Dielectric (ILD) layer, and the fifth insulation layer is referred to as a Passivation (PVX) layer. The first planarization layer may be made of an organic material such as resin. An active layer may be made of a material such as amorphous Indium Gallium Zinc Oxide (a-IGZO), Zinc Oxynitride (ZnON), Indium Zinc Tin Oxide (IZTO), amorphous Silicon (a-Si), poly-crystalline Silicon (p-Si), hexathiophene, or polythiophene. That is, the present disclosure is applicable to a transistor that is manufactured based on an oxide technology, a silicon technology, or an organic matter technology.

FIG. 30 is a schematic diagram of a planar structure of yet another display substrate according to an exemplary embodiment of the present disclosure. A main body structure of the display substrate in the present embodiment is substantially the same as that of the display substrate shown in FIG. 15, except that a fifth shielding block 38-1 and a sixth shielding block 39-1 are also provided in the present embodiment.

In an exemplary implementation mode, the fifth shielding electrode 38 is connected with the second power supply connection line 69, and an orthographic projection of the fifth shielding electrode 38 on the base substrate is at least partially overlapped with an orthographic projection of the semiconductor layer between two gate electrodes of the first transistor T1 on the base substrate. The fifth shielding block 38-1 may be in a shape of a block (such as a rectangle), a first end of the fifth shielding block 38-1 is connected with the fifth shielding electrode 38, and a second end of the fifth shielding block 38-1 extends toward a direction of the first connection electrode 41 and is close to the first connection electrode 41. In an exemplary implementation mode, the fifth shielding block 38-1 is configured to provide a shielding function for the first connection electrode 41.

In an exemplary implementation mode, the fifth shielding electrode 38, the fifth shielding block 38-1, and the second power supply connection line 69 may be of an interconnected integral structure.

In an exemplary implementation mode, the sixth shielding electrode 39 is connected with the second power supply connection line 69, and an orthographic projection of the sixth shielding electrode 39 on the base substrate is at least partially overlapped with an orthographic projection of the semiconductor layer between two gate electrodes of the second transistor T2 on the base substrate. The sixth shielding block 39-1 may be in a shape of a block (such as a rectangle), a first end of the sixth shielding block 39-1 is connected with the sixth shielding electrode 39, and a second end of the sixth shielding block 39-1 extends toward a direction of the first connection electrode 41 and is close to the first connection electrode 41. In an exemplary implementation mode, the sixth shielding block 39-1 is configured to provide a shielding function for the first connection electrode 41.

In an exemplary implementation mode, the sixth shielding electrode 39, the sixth shielding block 39-1, and the second power supply connection line 69 may be of an interconnected integral structure.

In an exemplary implementation mode, the second power supply connection line 69, the fifth shielding block 38-1, and the sixth shielding block 39-1 may form a groove K, and the first connection electrode 41 is provided in the groove K, so that the first node of the pixel drive circuit is substantially surrounded by a constant potential of the first power supply line, the first node of the pixel drive circuit is more effectively shielded, interference of another signal to the first node of the pixel drive circuit is avoided to a maximum extent, and the display effect is improved.

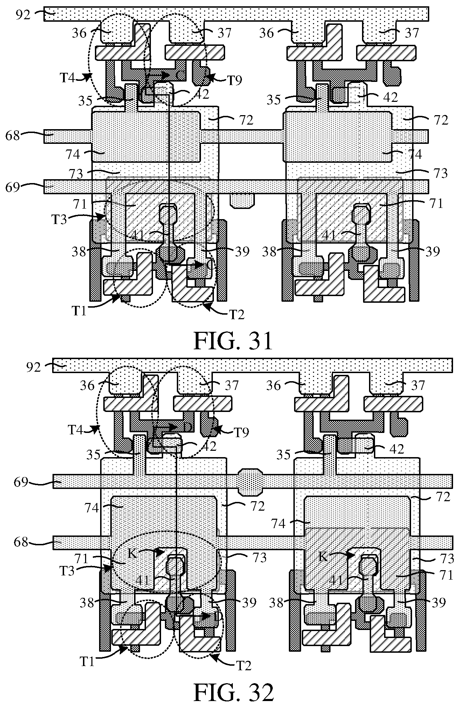

FIG. 31 is a schematic diagram of a planar structure of yet another display substrate according to an exemplary embodiment of the present disclosure. A main body structure of the display substrate in the present embodiment is substantially the same as that of the display substrate shown in FIG. 15, except that a second shielding electrode 35 is also provided in the present embodiment.

In an exemplary implementation mode, the second shielding electrode 35 may be in a shape of a strip extending along the second direction Y, may be provided at a side of the fourth electrode plate 74 close to the second reference signal line 92, and the second shielding electrode 35 may be provided in each circuit unit. In an exemplary implementation mode, a first end of the second shielding electrode 35 is connected with the fourth electrode plate 74, a second end of the second shielding electrode 35 extends toward the second reference signal line 92 and is located between the first region of the fourth active layer and the second region of the fourth active layer, the second shielding electrode 35 is configured to provide shielding between a first electrode of the fourth transistor T4 and a second electrode of the fourth transistor T4, reduce an influence of a data voltage jump on a potential of the fifth node N5 of the pixel drive circuit, and improve the display effect.

FIG. 32 is a schematic diagram of a planar structure of yet another display substrate according to an exemplary embodiment of the present disclosure. A main body structure of the display substrate in the present embodiment is substantially the same as that of the display substrate shown in FIG. 25, except that a second shielding electrode 35 is also provided in the present embodiment.

In an exemplary implementation mode, the second shielding electrode 35 may be in a shape of a strip extending along the second direction Y, may be provided at a side of the fourth electrode plate 74 close to the second reference signal line 92, and the second shielding electrode 35 may be provided in each circuit unit. In an exemplary implementation mode, a first end of the second shielding electrode 35 is connected with the second power supply connection line 69, a second end of the second shielding electrode 35 extends toward the second reference signal line 92 and is located between the first region of the fourth active layer and the second region of the fourth active layer, the second shielding electrode 35 is configured to provide shielding between a first electrode of the fourth transistor T4 and a second electrode of the fourth transistor T4, reduce an influence of a data voltage jump on the potential of the fifth node N5 of the pixel drive circuit, and improve the display effect.

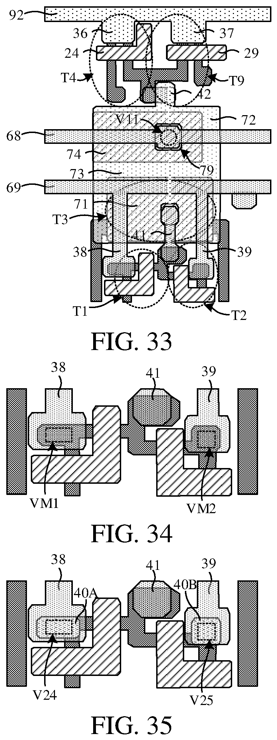

FIG. 33 is a schematic diagram of a planar structure of yet another display substrate according to an exemplary embodiment of the present disclosure. A main body structure of the display substrate in the present embodiment is substantially the same as that of the display substrate shown in FIG. 15, except that the fourth electrode plate 74 of the second storage capacitor in the present embodiment is provided in the first conductive layer, and the first power supply connection line 68 is connected with the fourth electrode plate 74 through a via.

In an exemplary implementation mode, in forming the first conductive layer, the plurality of vias of each circuit unit may further include the fourth electrode plate 74 of the second storage capacitor. The fourth electrode plate 74 may be substantially in a shape of a rectangle, corners of the rectangle may be provided with chamfers, and the fourth electrode plate 74 may be located between the first electrode plate 71, and the fourth gate electrode 24 and the ninth gate electrode 29.

In an exemplary implementation mode, an orthographic projection of the second electrode plate 72 in the second conductive layer on the base substrate is at least partially overlapped with an orthographic projection of the fourth electrode plate 74 on the base substrate, and the second electrode plate 72 and the fourth electrode plate 74 include the second storage capacitor of the pixel drive circuit. The second electrode plate 72 is provided with a third opening 79, the third opening 79 may be located in a partial region of the second electrode plate 72, and the third opening 79 may be rectangular, circular, or the like, so that the second electrode plate 72 forms an annular structure. The third opening 79 exposes the third insulation layer covering the fourth electrode plate 74, and an orthographic projection of the fourth electrode plate 74 on the base substrate contains an orthographic projection of the third opening 79 on the base substrate.

In an exemplary implementation mode, in a process of forming the pattern of the fourth insulation layer , the plurality of vias of each circuit unit may further include an eleventh via V11, an orthographic projection of the eleventh via V11 on the base substrate is within a range of an orthographic projection of the third opening 79 of the second electrode plate 72 on the base substrate, the fourth insulation layer and the third insulation layer within the eleventh via V11 are etched off to expose a surface of the fourth electrode plate 74.

In an exemplary implementation mode, in forming the fourth conductive layer, the first power supply connection line 68 is connected with the fourth electrode plate 74 in each circuit unit through the eleventh via V11, thereby achieving that the first power supply connection line 68 connects the fourth electrode plate 74, and the first power supply connection line 68 may write a first power supply signal into the fourth electrode plate 74 of the second storage capacitor.

In an exemplary implementation mode, in the display substrate shown in FIG. 25, a structure in which the fourth electrode plate 74 of the second storage capacitor is provided in the first conductive layer may also be adopted, which will not be repeated here.

FIG. 34 is a schematic diagram of a planar structure of yet another display substrate according to an exemplary embodiment of the present disclosure. A main body structure of the display substrate in the present embodiment is substantially the same as that of the display substrate shown in FIGs. 15 and 25, except that a first blind hole VM1 and a second blind hole VM2 are also provided in the present embodiment.

In an exemplary implementation mode, in a process of forming the pattern of the fourth insulation layer, the plurality of vias of each circuit unit may further include the first blind hole VM1 and the second blind hole VM2.

In an exemplary implementation mode, an orthographic projection of the first blind hole VM1 on the base substrate is within a range of an orthographic projection of the semiconductor layer between two gate electrodes of the first transistor T1 on the base substrate, and the fourth insulation layer and the third insulation layer within the first blind hole VM1 are etched off to expose the second insulation layer covering the semiconductor layer. In a process of forming the pattern of the third conductive layer, the third conductive layer is deposited within the first blind hole VM1, that is, an end portion of the fifth shielding electrode 38 is disposed within the first blind hole VM1.

In an exemplary implementation mode, an orthographic projection of the second blind hole VM2 on the base substrate is within a range of an orthographic projection of the semiconductor layer between two gate electrodes of the second transistor T2 on the base substrate, and the fourth insulation layer and the third insulation layer within the second blind hole VM2 are etched off to expose the second insulation layer covering the semiconductor layer. In a process of forming the pattern of the third conductive layer, the third conductive layer is deposited within the second blind hole VM2, that is, an end portion of the sixth shielding electrode 39 is disposed within the second blind hole VM2.

In the embodiment of the present disclosure, by providing blind holes at a node between two gate electrodes of the first transistor T1 and a node between two gate electrodes of the second transistor T2, a distance between the third conductive layer and the semiconductor layer in the region is reduced, which may increase a parasitic capacitance at a node between two gate electrodes, and may improve a shielding effect.

In some possible implementation modes, the fourth insulation layer within the first blind hole VM1 and the second blind hole VM2 may be etched off to expose the third insulation layer covering the first conductive layer , which is not limited in the present disclosure.

FIG. 35 is a schematic diagram of a planar structure of yet another display substrate according to an exemplary embodiment of the present disclosure. A main body structure of the display substrate in the present embodiment is substantially the same as that of the display substrate shown in FIGs. 15 and 25, except that the second conductive layer is further provided with a first node electrode 40A and a second node electrode 40B, the fifth shielding electrode 38 is connected with the first node electrode 40A through a via, and the sixth shielding electrode 39 is connected with the second node electrode 40B through a via.

In an exemplary implementation mode, in a process of forming the second conductive layer, the second conductive layer of each circuit unit may further include the first node electrode 40A and the second node electrode 40B.

In an exemplary implementation mode, the first node electrode 40A and the second node electrode 40B may be in a shape of a block (e.g., a rectangle), an orthographic projection of the first node electrode 40A on the base substrate is at least partially overlapped with an orthographic projection of the semiconductor layer between two gate electrodes of the first transistor T1 on the base substrate, and an orthographic projection of the second node electrode 40B on the base substrate is at least partially overlapped with an orthographic projection of the semiconductor layer between two gate electrodes of the second transistor T2 on the base substrate.

In an exemplary implementation mode, in a process of forming the pattern of the fourth insulation layer, the plurality of vias of each circuit unit may further include a twenty-fourth via V24 and a twenty-fifth via V25.

In an exemplary implementation mode, an orthographic projection of the twenty-fourth via V24 on the base substrate is within a range of an orthographic projection of the first node electrode 40A on the base substrate, and the fourth insulation layer within the twenty-fourth via V24 is etched off to expose a surface of the first node electrode 40A. An orthographic projection of the twenty-fifth via V25 on the base substrate is within a range of an orthographic projection of the second node electrode 40B on the base substrate, and the fourth insulation layer within the twenty-fifth via V25 is etched off to expose a surface of the second node electrode 40B.

In a process of forming the pattern of the third conductive layer, the fifth shielding electrode 38 is connected with the first node electrode 40A through the twenty-fourth via V24, and the sixth shielding electrode 39 is connected with the second node electrode 40B through the twenty-fifth via V25.

In an embodiment of the present disclosure, the first node electrode 40A and the second node electrode 40B are respectively provided at a node between two gate electrodes of the first transistor T1 and at a node between two gate electrodes of the second transistor T2, the fifth shielding electrode 38 is connected with the first node electrode 40A through a via, and the sixth shielding electrode 39 is connected with the second node electrode 40B through a via, which is equivalent to reducing a distance between the third conductive layer and the semiconductor layer in the region, and may increase a parasitic capacitance at a node between two gate electrodes, and may improve a shielding effect.

In some possible implementation modes, the first node electrode 40A and the second node electrode 40B may be disposed in the first conductive layer, which is not limited in the present disclosure.

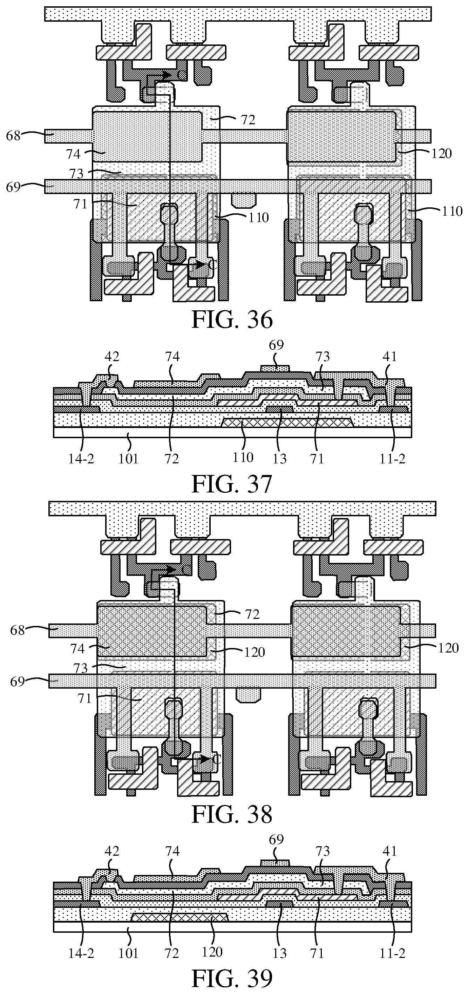

FIG. 36 is a schematic diagram of a planar structure of yet another display substrate according to an exemplary embodiment of the present disclosure, and FIG. 37 is a sectional view taken along a C-C direction in FIG. 36. A main body structure of the display substrate of the present embodiment is substantially the same as that of the display substrate shown in FIG. 15, except that the display substrate further includes a shield layer (LS), the shield layer may be provided on the base substrate, the first insulation thin film covers the shield layer, and the semiconductor layer is provided on the first insulation layer.

In an exemplary implementation mode, the shield layer of each circuit unit in the display substrate may include at least a first shield electrode 110, the first shield electrode 110 may be in a shape of a rectangle, corners of the rectangle may be provided with chamfers, and a position of the first shield electrode 110 may correspond to a position of the first electrode plate 71.

In an exemplary implementation mode, an orthographic projection of the first shield electrode 110 on the base substrate is at least partially overlapped with an orthographic projection of the third active layer on the base substrate, and the first shield electrode 110 is configured to shade the third transistor T3, reduce an intensity of light irradiated on the third transistor T3, reduce a leakage current of the third transistor T3, and thereby reduce an influence of light on characteristics of the third transistor T3.

In some possible exemplary implementation modes, the first shield electrode 110 may be connected with the third electrode plate 73 by providing a connection electrode, and a connection structure of the connection electrode may be provided according to a specific situation, which will not be repeated here. In this way, the first electrode plate 71 has the potential of the first node N1, the third electrode plate 73 and the first shield electrode 110 each have the potential of the fifth node N5, the first shield electrode 110 and the first electrode plate 71 form one sub-capacitor, the first electrode plate 71 and the third electrode plate 73 form another sub-capacitor, and the two sub-capacitors are connected in parallel, thus the first storage capacitor includes two sub-capacitors in parallel, on one hand, a capacitance value of a storage capacitor may be effectively increased, and on the other hand, an area of an electrode plate may be reduced under a condition that the capacitance value of the storage capacitor is guaranteed, so as to effectively reduce an occupied area.

FIG. 38 is a schematic diagram of a planar structure of yet another display substrate according to an exemplary embodiment of the present disclosure, and FIG. 39 is a sectional view taken along a C-C direction in FIG. 38. A main body structure of the display substrate of the present embodiment is substantially the same as that of the display substrate shown in FIG. 15, except that the display substrate further includes a shield layer (LS), the shield layer may be provided on the base substrate, the first insulation thin film covers the shield layer, and the semiconductor layer is provided on the first insulation layer.

In an exemplary implementation mode, the shield layer of each circuit unit in the display substrate may include at least a second shield electrode 120, the second shield electrode 120 may be in a shape of a rectangle, corners of the rectangle may be provided with chamfers, a position of the second shield electrode 120 may correspond to a position of the fourth electrode plate 74, and an orthographic projection of the second shield electrode 120 on the base substrate is at least partially overlapped with an orthographic projection of the fourth electrode plate 74 on the base substrate.

In some possible exemplary implementation modes, the second shield electrode 120 may be connected with the first power supply line 51, or the second shield electrode 120 may be connected with the first power supply connection line 68, by providing a connection structure. In this way, the second electrode plate 72 has the potential of the fifth node N5, the fourth electrode plate 74 and the second shield electrode 120 each have the potential of the first power supply line, the second shield electrode 120 and the second electrode plate 72 form one sub-capacitor, the second electrode plate 72 and the fourth electrode plate 74 form another sub-capacitor, and the two sub-capacitors are connected in parallel. Therefore, the second storage capacitor includes two sub-capacitors in parallel. On one hand, a capacitance value of a storage capacitor may be effectively increased, and on the other hand, an area of an electrode plate may be reduced under a condition that the capacitance value of the storage capacitor is guaranteed, so as to effectively reduce an occupied area.

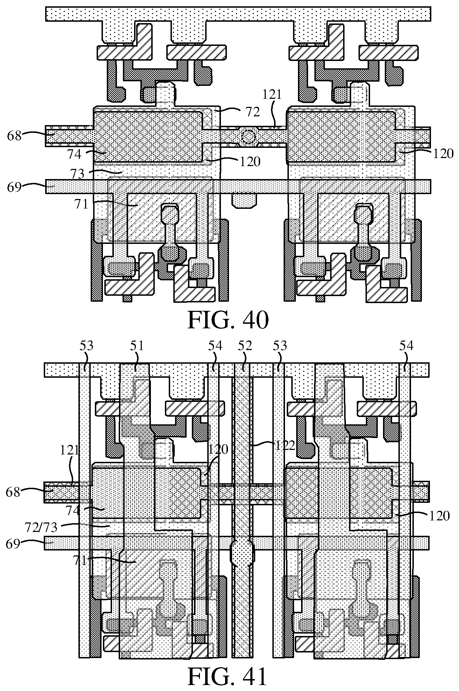

FIG. 40 is a schematic diagram of a connection structure according to an exemplary embodiment of the present disclosure, illustrating a structure for connecting the second shield electrode with the first power supply line. As shown in FIG. 40, the shield layer may further include a first shield connection line 121, the first shield connection line 121 may be in a shape of a line extending along the first direction X, may be disposed between second shield electrodes 120 of adjacent circuit units in one unit row, and may be connected with the second shield electrodes 120 of the adjacent circuit units, and the second shield electrodes 120 and the first shield connection line 121 in one unit row may be of an interconnected integral structure. In forming the pattern of the fourth insulation layer, a shield connection via is also provided. An orthographic projection of the shield connection via on the base substrate is within a range of an orthographic projection of the first shield connection line 121 on the base substrate. The first insulation layer, the second insulation layer, the third insulation layer, and the fourth insulation layer within the shield connection via are etched off to expose a surface of the first shielding connection line 121. In forming the pattern of the third conductive layer, the first power supply connection line 68 is connected with the first shield connection line 121 through the shield connection via. Since the first shield connection line 121 is connected with the second shield electrode 120, and the first power supply connection line 68 is connected with a first power supply line subsequently formed, the second shield electrode 120 has a potential of the first power supply line.

FIG. 41 is a schematic diagram of another connection structure according to an exemplary embodiment of the present disclosure. As shown in FIG. 41, a main body structure of the connection structure of the present embodiment is substantially the same as that shown in FIG. 40, except that the shield layer may further include a second shield connection line 122. The second shield connection line 122 may be in a shape of a line extending along the second direction Y, may be disposed between two adjacent unit columns, and may be connected with the first shield connection line 121, so that a plurality of second shield electrodes 120 in at least one unit column are connected with each other.

In an exemplary implementation mode, the second shield electrode 120, the first shield connection line 121, and the second shield connection line 122 may be of an interconnected integral structure.

In an exemplary implementation mode, an orthographic projection of the second shield connection line 122 on the base substrate is at least partially overlapped with an orthographic projection of the second power supply line 52 on the base substrate, so that a transmittance may not be affected, and a coupling capacitance formed by the second shield connection line 122 and another signal line may be reduced.

In an exemplary implementation mode, the second shield connection line 122 may be provided every two unit columns, so that the second shield connection line 122 has an overlapping relationship with only one constant voltage line, and a mutual influence between the second shield connection line 122 and another constant voltage line is reduced.

In some possible exemplary implementation modes, an orthographic projection of the second shield connection line 122 on the base substrate is not overlapped with an orthographic projection of the second power supply line 52 on the base substrate, the orthographic projection of the second shield connection line 122 on the base substrate is not overlapped with an orthographic projection of the data signal line 53 on the base substrate, and the orthographic projection of the second shield connection line 122 on the base substrate is not overlapped with an orthographic projection of the reference signal connection line 54 on the base substrate. For example, a distance between a unit column in which the first circuit unit is located and a unit column in which the second circuit unit is located may be increased, so that the second shield connection line 122 may be located between the second power supply line 52 and the data signal line 53, or so that the second shield connection line 122 may be located between the second power supply line 52 and the reference signal connection line 54.

In some possible exemplary implementation modes, the shield layer may not be provided with a first shield connection line, but only a second shield connection line, an orthographic projection of the second shield connection line 1222 on the base substrate is at least partially overlapped with an orthographic projection of the first power supply line on the base substrate, without affecting a transmittance, and the first power supply line is connected with the second shield connection line through a via.

In some possible exemplary implementation modes, structures of FIGs. 36 and 38 may be combined.

The structure shown and mentioned above in the present disclosure and the preparation process thereof are merely an exemplary description. In an exemplary implementation mode, corresponding structures may be altered and patterning processes may be added or reduced according to actual needs. For example, a structure and a shape of a capacitor electrode plate of the third conductive layer may be adjusted according to a actual situation. For another example, the reference signal connection line in the fourth conductive layer may be connected with the second reference signal line, so that the second reference signal line and the reference signal connection line form a mesh-like mesh structure for transmitting a second reference signal on the display substrate. For yet another example, the first reference signal line or the second reference signal line may be connected with one of electrode plates in the first storage capacitor, or the first reference signal line or the second reference signal line may be connected with one of electrode plates in the second storage capacitor. For yet another example, an initial connection line in the fourth conductive layer may be connected with a first initial signal line, so that the first initial signal line and the initial connection line form a mesh-like mesh structure for transmitting a first initial signal on the display substrate, which is not limited in the present disclosure.

In an exemplary implementation mode, the display substrate according to the present disclosure may be applied to a display apparatus with a pixel drive circuit, such as an OLED, a quantum dot display (QLED), a light emitting diode display (Micro LED or Mini LED), or a Quantum Dot Light Emitting Diode display (QDLED), which is not limited here in the present disclosure.

The present disclosure also provides a preparation method of a display substrate, for preparing the display substrate according to the foregoing embodiments. In an exemplary implementation mode, the display substrate includes a plurality of circuit units, at least one circuit unit includes a pixel drive circuit, the pixel drive circuit includes at least a first storage capacitor and a second storage capacitor, a second end of the first storage capacitor is connected with a second end of the second storage capacitor; the first storage capacitor includes at least two first capacitor electrode plates, orthographic projections of the two first capacitor electrode plates on the base substrate are at least partially overlapped, and the second storage capacitor includes at least two second capacitor electrode plates, orthographic projections of the two second capacitor electrode plates on the base substrate are at least partially overlapped. The preparation method of the display substrate may include following operations.

A first conductive layer, a second conductive layer, and a third conductive layer are sequentially formed on the base substrate, wherein at least one first capacitor electrode plate of the first storage capacitor is disposed in the first conductive layer, at least one first capacitor electrode plate of the first storage capacitor is disposed in the second conductive layer, at least one second capacitor electrode plate of the second storage capacitor is disposed in the second conductive layer, and at least one second capacitor electrode plate of the second storage capacitor is disposed in the third conductive layer.

The present disclosure also provides a display apparatus which includes the aforementioned display substrate. The display apparatus may be any product or component with a display function, such as a mobile phone, a tablet computer, a television, a display, a laptop computer, a digital photo frame, or a navigator, which is not limited in the embodiments of the present invention.

Although implementation modes disclosed in the present disclosure are described as above, the described contents are only implementation modes which are used for facilitating understanding of the present disclosure, but are not intended to limit the present invention. Any skilled person in the art to which the present disclosure pertains may make any modification and variation in a form and details of implementation without departing from the spirit and scope of the present disclosure. However, the patent protection scope of the present invention should be subject to the scope defined in the appended claims.

## Claims

1. A display substrate, comprising a plurality of circuit units, wherein at least one circuit unit comprises a pixel drive circuit, the pixel drive circuit comprises at least a first storage capacitor and a second storage capacitor, a second end of the first storage capacitor is connected with a second end of the second storage capacitor; the first storage capacitor comprises at least two first capacitor electrode plates, orthographic projections of the two first capacitor electrode plates on a plane of the display substrate are at least partially overlapped, and the second storage capacitor comprises at least two second capacitor electrode plates, orthographic projections of the two second capacitor electrode plates on the plane of the display substrate are at least partially overlapped; in a direction perpendicular to the display substrate, the display substrate comprises a semiconductor layer disposed on a base substrate, and a first conductive layer, a second conductive layer, and a third conductive layer sequentially disposed along a direction away from the base substrate, the at least two first capacitor electrode plates in the first storage capacitor are respectively disposed in the first conductive layer and the second conductive layer, and the at least two second capacitor electrode plates in the second storage capacitor are respectively disposed in the second conductive layer and the third conductive layer.

2. The display substrate according to claim 1, wherein the at least two first capacitor electrode plates comprise a first electrode plate, a third electrode plate, and a fifth electrode plate, wherein the first electrode plate is disposed in the first conductive layer, the third electrode plate is disposed in the second conductive layer, and the fifth electrode plate is disposed in the third conductive layer; an orthographic projection of the first electrode plate on the base substrate is at least partially overlapped with an orthographic projection of the third electrode plate on the base substrate, and the orthographic projection of the third electrode plate on the base substrate is at least partially overlapped with an orthographic projection of the fifth electrode plate on the base substrate; the first storage capacitor comprises a first sub-capacitor and a second sub-capacitor, the first sub-capacitor comprises the first electrode plate and the third electrode plate, and the second sub-capacitor comprises the third electrode plate and the fifth electrode plate.

3. The display substrate according to claim 1, wherein the at least two second capacitor electrode plates comprise a second electrode plate, a fourth electrode plate, and a sixth electrode plate, wherein the second electrode plate is disposed in the first conductive layer, the fourth electrode plate is disposed in the second conductive layer, and the sixth electrode plate is disposed in the third conductive layer; an orthographic projection of the second electrode plate on the base substrate is at least partially overlapped with an orthographic projection of the fourth electrode plate on the base substrate, and the orthographic projection of the fourth electrode plate on the base substrate is at least partially overlapped with an orthographic projection of the sixth electrode plate on the base substrate; the second storage capacitor comprises a third sub-capacitor and a fourth sub-capacitor, the third sub-capacitor comprises the second electrode plate and the fourth electrode plate, the fourth sub-capacitor comprises the fourth electrode plate and the sixth electrode plate.

4. The display substrate according to claim 1, wherein the at least two first capacitor electrode plates comprise a first electrode plate, a third electrode plate, and a fifth electrode plate, the at least two second capacitor electrode plates comprise a second electrode plate, a fourth electrode plate, and a sixth electrode plate, the first electrode plate and the second electrode plate are disposed in the first conductive layer, the third electrode plate and the fourth electrode plate are disposed in the second conductive layer, and the fifth electrode plate and the sixth electrode plate are disposed in the third conductive layer; the fifth electrode plate is connected with the first electrode plate, and the sixth electrode plate is connected with the second electrode plate and the third electrode plate, respectively.

5. The display substrate according to claim 1, wherein the at least two first capacitor electrode plates comprise a first electrode plate and a third electrode plate, the first electrode plate is disposed in the first conductive layer, the third electrode plate is disposed in the second conductive layer, an orthographic projection of the first electrode plate on the base substrate is at least partially overlapped with an orthographic projection of the third electrode plate on the base substrate, and the first storage capacitor comprises the first electrode plate and the second electrode plate.

6. The display substrate according to claim 5, wherein the at least two second capacitor electrode plates comprise a second electrode plate and a fourth electrode plate, the second electrode plate is disposed in the second conductive layer, the fourth electrode plate is disposed in the third conductive layer, an orthographic projection of the second electrode plate on the base substrate is at least partially overlapped with an orthographic projection of the fourth electrode plate on the base substrate, and the second storage capacitor comprises the second electrode plate and the fourth electrode plate.

7. The display substrate according to claim 6, wherein the third electrode plate of the first storage capacitor and the second electrode plate of the second storage capacitor are of an interconnected integral structure.

8. The display substrate according to any one of claims 1 to 7, wherein the display substrate further comprises at least one first power supply connection line extending along a first direction, at least one second power supply connection line extending along the first direction, at least one reference signal connection line extending along the first direction, at least one first power supply line extending along a second direction, at least one second power supply line extending along the second direction, and at least one reference signal line extending along the second direction, the first direction intersecting with the second direction; the first power supply line and the first power supply connection line are disposed in different conductive layers, and the first power supply line and the first power supply connection line are connected through a via to form a mesh structure for transmitting a first power supply signal; the second power supply line and the second power supply connection line are disposed in different conductive layers, and the second power supply line and the second power supply connection line are connected through a via to form a mesh structure for transmitting a second power supply signal; the reference signal line and the reference signal connection line are disposed in different conductive layers, and the reference signal connection line and the reference signal line are connected through a via to form a mesh structure for transmitting a reference signal; potentials of the first power supply line and the second power supply line are different.

9. The display substrate according to claim 8, wherein the pixel drive circuit comprises a first initialization transistor, a compensation transistor, a data writing transistor, a first reference transistor, a first node, and a fifth node, wherein the first node is respectively connected with a second electrode of the first initialization transistor, a first electrode of the compensation transistor, and a first end of the first storage capacitor, and the fifth node is respectively connected with a second electrode of the data writing transistor, a second electrode of the first reference transistor, a second end of the first storage capacitor, and a second end of the second storage capacitor; an orthographic projection of the second power supply connection line on the base substrate is at least partially overlapped with an orthographic projection of the fifth node on the base substrate.

10. The display substrate according to claim 8, wherein the display substrate further comprises at least one data signal line extending along the second direction; a reference signal connection line in one circuit unit is adjacent to a data signal line in another circuit unit adjacent in the first direction; in at least one circuit unit, an orthographic projection of the reference signal connection line on the base substrate is not overlapped with an orthographic projection of the fifth node on the base substrate.

11. The display substrate according to claim 8, wherein the reference signal line is connected with one first capacitor electrode plate in the first storage capacitor, or the reference signal line is connected with one second capacitor electrode plate in the second storage capacitor.

12. The display substrate according to any one of claims 1 to 7, wherein the display substrate further comprises at least one initial signal line extending along a first direction and at least one initial connection line extending along a second direction, the first direction intersecting with the second direction; the initial signal line and the initial connection line are disposed in different conductive layers, and the initial connection line and the initial signal line are connected through a via to form a mesh structure for transmitting an initial signal.

13. The display substrate according to any one of claims 1 to 7, wherein the pixel drive circuit further comprises a first initialization transistor, a compensation transistor, a data writing transistor, and a first reference transistor; a first electrode of the first initialization transistor is connected with a first initial signal line, a second electrode of the first initialization transistor is connected with a first electrode of the compensation transistor and a first end of the first storage capacitor, respectively, a first electrode of the data writing transistor is connected with a data signal line, a second electrode of the data writing transistor is connected with a second electrode of the first reference transistor, a second end of the first storage capacitor and a second end of the second storage capacitor, a first electrode of the first reference transistor is connected with a first reference signal line, and a first end of the second storage capacitor is connected with a first power supply line.

14. The display substrate according to claim 13, wherein the at least one circuit unit further comprises a first shielding electrode, an orthographic projection of the first shielding electrode on the base substrate is at least partially overlapped with an orthographic projection of a semiconductor layer between two gate electrodes of the first initialization transistor on the base substrate, and the orthographic projection of the first shielding electrode on the base substrate is at least partially overlapped with an orthographic projection of a semiconductor layer between two gate electrodes of the compensation transistor on the base substrate.

15. The display substrate according to claim 13, wherein the at least one circuit unit further comprises a second shielding electrode disposed between the first electrode of the data writing transistor and the second electrode of the data writing transistor.

16. The display substrate according to claim 13, wherein the at least one circuit unit further comprises a third shielding electrode and a fourth shielding electrode, wherein an orthographic projection of the third shielding electrode on the base substrate is at least partially overlapped with an orthographic projection of a semiconductor layer between two gate electrodes of the data writing transistor on the base substrate, and an orthographic projection of the fourth shielding electrode on the base substrate is at least partially overlapped with an orthographic projection of a semiconductor layer between two gate electrodes of the first reference transistor on the base substrate.

17. The display substrate according to claim 13, wherein the at least one circuit unit further comprises a fifth shielding electrode and a sixth shielding electrode, wherein an orthographic projection of the fifth shielding electrode on the base substrate is at least partially overlapped with an orthographic projection of a semiconductor layer between two gate electrodes of the first initialization transistor on the base substrate, and an orthographic projection of the sixth shielding electrode on the base substrate is at least partially overlapped with an orthographic projection of a semiconductor layer between two gate electrodes of the compensation transistor on the base substrate.

18. The display substrate according to claim 17, wherein the fifth shielding electrode and the sixth shielding electrode are connected with a first power supply line, or the fifth shielding electrode and the sixth shielding electrode are connected with a second power supply line.

19. The display substrate according to claim 13, wherein the at least one circuit unit further comprises a first connection electrode and a power supply shielding block, wherein the first connection electrode is connected with the second electrode of the first initialization transistor, a second electrode of the compensation transistor, and the first end of the first storage capacitor, respectively, the power supply shielding block is connected with the first power supply line, and an orthographic projection of the power supply shielding block on the base substrate is at least partially overlapped with an orthographic projection of the first connection electrode on the base substrate.

20. The display substrate according to claim 13, wherein the at least one circuit unit further comprises a second connection electrode, the second connection electrode is connected with the second electrode of the data writing transistor, the second electrode of the first reference transistor, the second end of the first storage capacitor, and the second end of the second storage capacitor, respectively, wherein an orthographic projection of the first power supply line on the base substrate is at least partially overlapped with an orthographic projection of the second connection electrode on the base substrate.

21. A display apparatus, comprising a display substrate according to any one of claims 1 to 20.

22. A preparation method of a display substrate, wherein the display substrate comprises a plurality of circuit units, at least one circuit unit comprises a pixel drive circuit, the pixel drive circuit comprises at least a first storage capacitor and a second storage capacitor, a second end of the first storage capacitor is connected with a second end of the second storage capacitor; the first storage capacitor comprises at least two first capacitor electrode plates, orthographic projections of the two first capacitor electrode plates on a plane of the display substrate are at least partially overlapped, and the second storage capacitor comprises at least two second capacitor electrode plates, orthographic projections of the two second capacitor electrode plates on the plane of the display substrate are at least partially overlapped; the preparation method comprises:
forming a first conductive layer, a second conductive layer, and a third conductive layer sequentially on a base substrate, wherein at least one first capacitor electrode plate in the first storage capacitor is disposed in the first conductive layer, at least one first capacitor electrode plate of the first storage capacitor is disposed in the second conductive layer, at least one second capacitor electrode plate in the second storage capacitor is disposed in the second conductive layer, and at least one second capacitor electrode plate in the second storage capacitor is disposed in the third conductive layer.
